(19) Europäisches Patentamt
European Patent Office
Office européen des brevets

(11) EP 2 267 540 B1

# (12) EUROPEAN PATENT SPECIFICATION

(45) Date of publication and mention of the grant of the patent:
**18.03.2015 Bulletin 2015/12**

(21) Application number: **09725207.6**

(22) Date of filing: **19.03.2009**

(51) Int Cl.:
***G03F 7/32*** (2006.01)
***G03F 7/00*** (2006.01)
***G03F 7/11*** (2006.01)
***B41C 1/10*** (2006.01)
***G03F 7/004*** (2006.01)

(86) International application number:
**PCT/JP2009/055400**

(87) International publication number:
**WO 2009/119430 (01.10.2009 Gazette 2009/40)**

## (54) PROCESS FOR PRODUCING LITHOGRAPHIC PRINTING PLATE

PROZESS ZUR HERSTELLUNG EINER LITHOGRAFISCHEN DRUCKPLATTE

PROCÉDÉ DE FABRICATION D'UNE PLAQUE D'IMPRESSION LITHOGRAPHIQUE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **25.03.2008 JP 2008076940**

(43) Date of publication of application:
**29.12.2010 Bulletin 2010/52**

(73) Proprietor: **FUJIFILM Corporation**
**Tokyo 106-8620 (JP)**

(72) Inventor: **ENDO, Akihiro**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 1 334 823**
**EP-A2- 2 166 410**
**JP-A- 2002 091 014**
**JP-A- 2003 255 527**
**JP-A- 2004 347 983**
**JP-A- 2005 049 466**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 267 540 B1

## Description

The present invention relates to a process for making a lithographic printing plate and, in particular, to a process for making a lithographic printing plate that can be processed by a single bath and has high processing capacity.

In general, a lithographic printing plate is formed from a lipophilic image area for accepting ink and a hydrophilic non-image area for accepting dampening water in a printing process. Lithographic printing is a printing process in which the property of water and printing ink repelling each other is utilized so as to cause a difference in ink attachment on the surface of a lithographic printing plate with a lipophilic image area of the lithographic printing plate as an ink-accepting area and a hydrophilic non-image area as a dampening water-accepting area (non-ink-accepting area), and after inking only the image area ink is transferred to a printing substrate such as paper.

In order to make this lithographic printing plate, a lithographic printing plate precursor (PS plate) formed by providing a lipophilic photosensitive resin layer (photosensitive layer, image-forming layer) on a hydrophilic support is widely used in the art. A lithographic printing plate is usually obtained by a process in which, after the lithographic printing plate precursor is exposed through an original image such as a lith film, an area that becomes an image area of the image-forming layer is made to remain, and unwanted image-forming layer other than this is removed by dissolving using an alkaline developer or an organic solvent to thus form a non-image area in which the surface of the hydrophilic support is exposed.

In this way, in the conventionally known plate-making process of a lithographic printing plate precursor, after exposure a step of removing unnecessary image-forming layer by dissolving, for example, with a developer is required, but from the viewpoint of the environment and safety carrying out processing with a developer that is closer to neutral or reducing the amount of liquid waste are issues. In particular, since in recent years the disposal of effluent discharged accompanying wet treatment has become a great concern throughout the industrial world from the viewpoint of consideration for the global environment, the demand for a solution to the above-mentioned issues has been increasing more and more.

On the other hand, digitization techniques involving electronically processing, storing, and outputting image information by computer have spread widely in recent years, and various new image output methods used with such digitization techniques have been put into practical use. Accompanying this, a computer-to-plate (CTP) technique in which a lithographic printing plate is made directly without a lith film by carrying digitalized image information in highly convergent radiant rays such as laser light and scanning and exposing a lithographic printing plate precursor with this light has been attracting attention. It is therefore an important technical task to obtain a lithographic printing plate precursor that is suitable for the above-mentioned techniques.

As described above, there has been an increasingly strong desire for decreasing the alkalinity of a developer and simplifying the processing step both from the viewpoint of consideration of the global environment and from the viewpoint of being able to accommodate space saving and low running cost. However, as described above, the development processing step generally comprises three stages, that is, developing using an aqueous solution of an alkali having a pH of at least 10, then washing away alkali agent using a water washing bath, and subsequently treating using a gumming liquid containing a hydrophilic resin as a main component; because of this an automatic processor itself occupies a large space, and there are still problems in terms of the environment and running cost such as disposal of development effluent, water washing effluent, and gumming effluent.

On the other hand, Patent Publication 1 for example proposes a development method in which processing is carried out using an aqueous solution having a pH of 8.5 to 11.5, but since water washing and gumming liquid processing steps are required, the environmental and running cost problems cannot be solved.

Furthermore, an example of Patent Publication 2 describes single bath processing using a processing solution comprising a water-soluble resin having a pH of 11.9 to 12.1. However, a lithographic printing plate with an alkali having a pH of 12 attached to the plate surface has a problem in terms of operator safety, and if after the lithographic printing plate is made there is a long time before printing, an image area gradually dissolves, thus degrading plate life or ink laydown.

Patent Document 1: JP-A-11-65126 (JP-A denotes a Japanese unexamined patent application publication)
Patent Document 2: EP Laid-open No. 1868036

EP 1334823 discloses a process for making a lithographic printing plate comprising processing the exposed plate precursor using a solution comprising alkali metal carbonate salt and alkali metal bicarbonate salt.

It is therefore an object of the present invention to provide a process for making a lithographic printing plate that can overcome the above-mentioned defects of the conventional techniques, and specifically to provide a process for making a lithographic printing plate that exhibits safety, and excellent developability and processing capacity in single solution processing using a weakly alkaline processing solution.

As a result of an intensive investigation, the present inventors have successfully accomplished the above-mentioned object by the means below. The present invention and preferred embodiments thereof are defined in the appended claims.

In accordance with the present invention, a lithographic printing plate can be made by processing, using a single solution, a photopolymerization type photosensitive lithographic printing plate precursor that is suitable for (near) infrared laser light lithography and that has good uniformity in terms of screen tint evenness for middle tones when high definition AM screen printing or FM screen printing, in particular FM screen, having a screen ruling of at least 200 is used. In particular, since single bath development using a weakly alkaline processing solution is possible, simplification of the processing steps can provide merits such as consideration of the global environment and being able to accommodate space saving and low running cost.

Brief Description of Drawings

FIG. 1: A schematic constitutional diagram showing one example of mechanical roughening equipment used for producing a hydrophilic support used in a lithographic printing plate precursor employed in the present invention.

FIG. 2: A schematic diagram showing the structure of one example of a processor employed in the present invention.

Explanation of Reference Numerals

| | |
|---|---|
| 1: | Aluminum plate |
| 2, 4: | Roller-shaped brush |
| 3: | Abrasive slurry liquid |
| 5, 6, 7, 8: | Support roller |
| 11: | Rotating brush roller |
| 12: | Backing roller |
| 13: | Transport roller |
| 14: | Transport guide plate |
| 15: | Spray pipe |
| 16: | Pipeline |
| 17: | Filter |
| 18: | Plate supply table |
| 19: | Plate discharge table |
| 20: | Processing solution tank |
| 21: | Circulation pump |
| 22: | Dryer |
| 30: | Lithographic printing plate precursor |

The process for making a lithographic printing plate related to the present invention and preferred embodiments thereof are explained below. 1. Lithographic printing plate precursor

A step of preparing a lithographic printing plate precursor used in the present invention is explained below.

The lithographic printing plate precursor used in the present invention has an image-forming layer having negative-working photosensitivity, and an exposed region forms a hydrophobic image when processed, thus forming an ink receiving area for printing.

The image-forming layer is also called a 'photosensitive layer' or a 'photosensitivity layer' below.

It is essential for the lithographic printing plate precursor to have a hydrophilic support and an image-forming layer provided thereabove by coating; an intermediate layer may be provided therebetween, and a protective layer may be provided outside the image-forming layer. A backcoat layer may be provided on the side opposite to the image-forming layer relative to the support.

The constitution of the negative-working photosensitive lithographic printing plate precursor used in the process for making a lithographic printing plate is explained below.

<Hydrophilic support>

A hydrophilic support (hereinafter, also called simply a 'support') used in the present invention is a support having at least one hydrophilic surface. The material of the support is not particularly limited, but the support preferably

has a dimensionally stable plate form and has a hydrophilic surface. Examples thereof include paper, paper laminated with a plastic (e.g. polyethylene, polypropylene, polystyrene, etc.), a metal plate (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinylacetal, etc.), and paper or plastic film laminated or vapor-deposited with the above metal. Preferred examples of the support include a polyester film and an aluminum plate. Among them, an aluminum plate, which has good dimensional stability and is relatively inexpensive, is preferable. When these supports are not sufficiently hydrophilic, they are used by subjecting the surface to a hydrophilization treatment. The hydrophilization treatment involves coating with a hydrophilic layer or hydrophilizing a support surface.

The aluminum plate includes a pure aluminum plate, an alloy plate containing aluminum as a main component and also containing a small amount of another element, and a thin aluminum film or aluminum alloy film laminated with a plastic. Examples of the other element contained in the aluminum alloy include silicon, iron, manganese, copper, magnesium, chromium, zinc, bismuth, nickel, and titanium. The content of the other element in the alloy is preferably no greater than 10 wt %. The thickness of the aluminum plate is preferably 0.1 to 0.6 mm, more preferably 0.15 to 0.4 mm, and yet more preferably 0.2 to 0.3 mm.

The aluminum plate is preferably subjected to a surface treatment such as a surface roughening treatment, an anodization treatment, or a hydrophilization treatment.

Materials that can be used as the support, the surface roughening treatment, the anodization treatment, and the hydrophilization treatment are known and described in, for example, paragraphs 0335 to 0344 of JP-A-2007-47742.

Furthermore, when a polyester film, etc. is used as a support, it is preferable to provide an antistatic layer on a hydrophilic layer side, the opposite side, or both sides of the support. When an antistatic layer is provided between the support and a hydrophilic layer, it also contributes to an improvement in adhesion to the hydrophilic layer. As the antistatic layer, a polymer layer, described in JP-A-2002-79772, in which metal oxide microparticles or a matting agent are dispersed, etc. may be used.

The center line average roughness of the support is preferably 0.10 to 1.2 μm from the viewpoint of good adhesion to a photosensitive layer or an intermediate layer, good plate life, and good stain prevention properties. Furthermore, from the viewpoint of good image formation properties by prevention of halation during imagewise exposure, ease of plate inspection after development, etc., the color density of the support is preferably 0.15 to 0.65 as a reflection density value thereof.

<intermediate layer>

The lithographic printing plate precursor used in the present invention may have an intermediate layer provided between the image-forming layer and the support. Since the intermediate layer has the function of strengthening adhesion between the support and the photosensitive layer in an exposed area and the function of facilitating peeling of the photosensitive layer from the support in an unexposed area, ease of discrimination by development is improved. Moreover, when imagewise exposure is carried out by means of an infrared laser, since the intermediate layer functions as a heat-insulating layer, heat generated by the imagewise exposure does not diffuse into the support and is efficiently utilized, thus giving the advantage that high sensitivity is achieved.

Examples of materials used as the intermediate layer include a silane coupling agent having an addition-polymerizable ethylenic double bond reactive group described in JP-A-10-282679 and a phosphorus compound having an ethylenic double bond reactive group described in JP-A-2-304441.

As a polymer compound (polymer compound for intermediate layer) used in the intermediate layer, a known resin having a hydrophilic group may also be used. Specific examples of such a resin include gum Arabic, casein, gelatin, a starch derivative, carboxymethylcellulose and a sodium salt thereof, cellulose acetate, sodium alginate, a vinyl acetate maleic acid copolymer, a styrene/maleic acid copolymer, a polyacrylic acid and a salt thereof, a polymethacrylic acid and a salt thereof, hydroxyethyl methacrylate homopolymer and copolymer, hydroxyethyl acrylate homopolymer and copolymer, hydroxypropyl methacrylate homopolymer and copolymer, hydroxypropyl acrylate homopolymer and copolymer, hydroxybutyl methacrylate homopolymer and copolymer, hydroxybutyl acrylate homopolymer and copolymer, a polyethylene glycol, a hydroxypropylene polymer, a polyvinyl alcohol, a hydrolyzed polyvinyl acetate having a degree of hydrolysis of at least 60 mole % and preferably at least 80 mole %, polyvinyl formal, polyvinyl butyral, polyvinylpyrrolidone, acrylamide homopolymer and copolymer, methacrylamide homopolymer and polymer, *N*-methylolacrylamide homopolymer and copolymer, polyvinylpyrrolidone, alcohol-soluble nylon, and a polyether of 2,2-bis(4-hydroxyphenyl)propane and epichlorohydrin.

The polymer compound for the intermediate layer preferably has the ability to adsorb onto a support surface. With respect to the presence or absence of the ability to adsorb onto a support surface, it may be determined by, for example, the method below.

A coating solution in which a test compound is dissolved in a solvent in which it is readily soluble is prepared,

and a support is coated with the coating solution at a dry coat weight of 30 mg/m$^2$ and dried. Subsequently, the support coated with the test compound is washed well using a solvent in which the test compound is readily soluble, and the amount of test compound remaining without being removed by washing is measured, thus calculating the amount adsorbed on the support. Measurement of the amount remaining may be carried out by direct quantitative analysis of the amount of compound remaining or by quantitative analysis of the amount of test compound dissolved in the washing liquid. Quantitative analysis of the compound may be carried out by, for example, using X-ray fluorescence measurement, reflectance spectrum absorbance measurement, liquid chromatography measurement, etc. A compound having the ability to adsorb onto a support is a compound for which at least 1 mg/m$^2$ remains after the above-mentioned washing treatment.

In order to impart the ability to adsorb onto a support surface to a polymer compound for an intermediate layer, it may be achieved by introducing an adsorbable group. A group that is adsorbable onto a support surface is a functional group that can induce a chemical bond (e.g. an ionic bond, a hydrogen bond, a coordination bond, a bond due to intermolecular forces) to a material (e.g. a metal, a metal oxide) or functional group (e.g. a hydroxy group) present on the support surface. The adsorbable group is preferably an acid group or a cationic group.

The acid group preferably has an acid dissociation constant (pKa) of no greater than 7. Examples of the acid group include a phenolic hydroxy group, a carboxy group, $-SO_3H$, $-OSO_3H$, $-PO_3H_2$, $-OPO_3H_2$, $-CONHSO_2-$, $-SO_2NHSO_2-$, and $COCH_2CO-$. A phosphoric acid group ($-OPO_3H_2$, $-PO_3H_2$) is particularly preferable. These acid groups may be metal salts.

The cationic group is preferably an onium group. Examples of the onium group include an ammonium group, a phosphonium group, an arsonium group, a stibonium group, an oxonium group, a sulfonium group, a selenonium group, a stannonium group, and an iodonium group. An ammonium group, a phosphonium group, and a sulfonium group are preferable, an ammonium group and a phosphonium group are more preferable, and an ammonium group is most preferable.

In order to introduce an adsorbable group into a polymer compound for an intermediate layer, a monomer unit having an adsorbable group may be introduced. Preferred examples of the monomer having an adsorbable group include a compound represented by Formula (E-1) or Formula (E-2) below, and a monomer represented by (E-1) is more preferable.

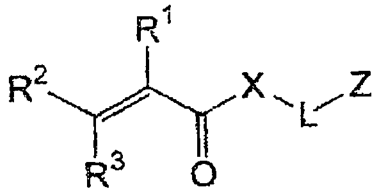 (E-1) 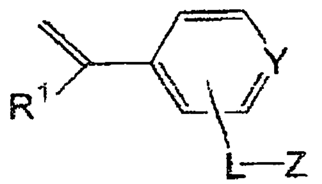 (E-2)

In Formula (E-1) and Formula (E-2), R$^1$, R$^2$, and R$^3$ are independently a hydrogen atom, a halogen atom, or an alkyl group having 1 to 6 carbon atoms. It is preferable for R$^1$, R$^2$, and R$^3$ to be independently a hydrogen atom or an alkyl group having 1 to 6 carbon atoms, it is more preferable for them to be a hydrogen atom or an alkyl group having 1 to 3 carbon atoms, and it is most preferable for them to be a hydrogen atom or a methyl group. R$^2$ and R$^3$ are particularly preferably hydrogen atoms.

X is an oxygen atom (-O-) or imino (-NH-). X is preferably an oxygen atom.

L is a divalent linking group. L is preferably a divalent aliphatic group (an alkylene group, an alkenylene group, an alkynylene group), a divalent aromatic group (an arylene group), a divalent heterocyclic group, or a group formed by combining the above with an oxygen atom (-O-), a sulfur atom (-S-), imino (-NH-), substituted imino (-NR-, R is an aliphatic group, an aromatic group, or a heterocyclic group), or carbonyl (-CO-).

In Formula (E-1) and Formula (E-2), the aliphatic group may have a cyclic structure or a branched structure. The number of carbon atoms of the aliphatic group is preferably 1 to 20, more preferably 1 to 15, and yet more preferably 1 to 10. The aliphatic group is preferably a saturated aliphatic group rather than an unsaturated aliphatic group. The aliphatic group may have a substituent. Examples of the substituent include a halogen atom, a hydroxy group, an aromatic group, and a heterocyclic group.

The number of carbon atoms of the aromatic group is preferably 6 to 20, more preferably 6 to 15, and yet more preferably 6 to 10. The aromatic group may have a substituent. Examples of the substituent include a halogen atom, a hydroxy group, an aliphatic group, an aromatic group, and a heterocyclic group.

The heterocyclic group preferably has a 5-membered or 6-membered ring as a heterocycle. The heterocycle may be condensed with another heterocycle, an aliphatic ring, or an aromatic ring. The heterocyclic group may have a substituent. Examples of the substituent include a halogen atom, a hydroxy group, an oxo group (=O), a thioxo group (=S), an imino group (=NH), a substituted imino group (=N-R, R is an aliphatic group, an aromatic group, or a heterocyclic

group), an aliphatic group, an aromatic group, and a heterocyclic group.

L is preferably a divalent linking group containing a plurality of polyoxyalkylene structures. The polyoxyalkylene structure is more preferably a polyoxyethylene structure. In other words, L preferably contains $-(OCH_2CH_2)_n-$(n is an integer of 2 or greater).

Z is a functional group that adsorbs on a hydrophilic support surface. The adsorbable functional group is as described above.

Y is a carbon atom or a nitrogen atom. When Y is a nitrogen atom and L is bonded to Y to form a quaternary pyridinium group, since the group itself exhibits adsorbablility, Z is not essential.

Specific examples of monomers represented by Formula (E-1) or Formula (E-2) are listed below.

Hereinafter, Me denotes a methyl group and Et denotes an ethyl group.

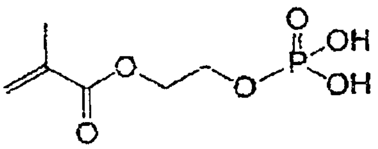
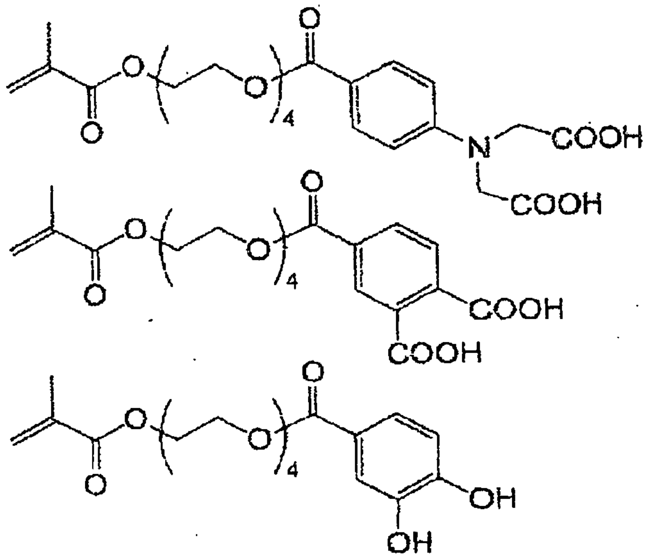
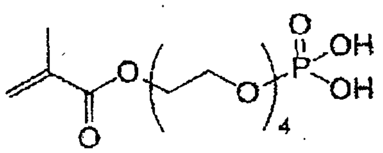
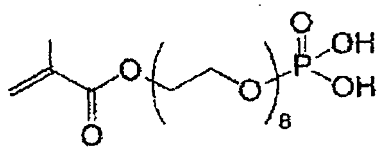
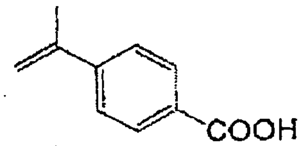
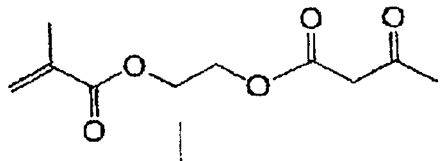
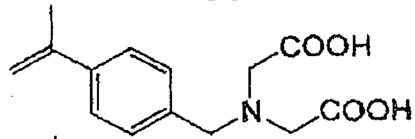
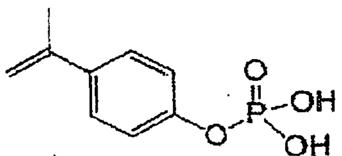
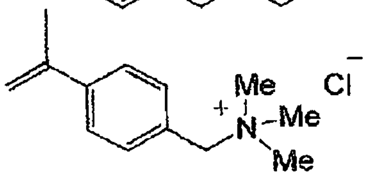
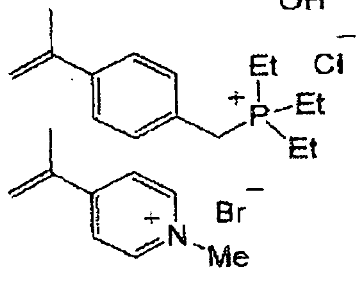
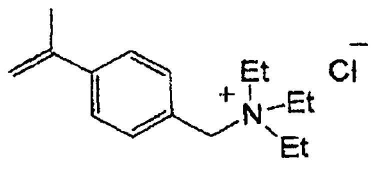

The polymer compound for the intermediate layer preferably further comprises a hydrophilic group. Preferred examples of the hydrophilic group include a hydroxy group, a carboxy group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonic acid group, and a phosphoric acid group.

In the present invention, when a binder polymer having a cationic group in its side chain is used in a photosensitive layer, an anionic group such as a carboxy group, a carboxylate group, a sulfonic acid group, or a phosphoric acid group is preferable as the hydrophilic group of the polymer compound for the intermediate layer that interacts with the above.

The polymer compound for the intermediate layer used in the present invention preferably further comprises a crosslinkable group. The crosslinkable group can improve adhesion to an image area. In order to impart crosslinkablility

to the polymer compound for the intermediate layer, a crosslinkable functional group such as an ethylenically unsaturated bond may be introduced into a side chain of a polymer, or a salt structure may be formed from a compound having an ethylenically unsaturated bond and a substituent having the opposite charge to a polar substituent of the polymer compound.

Examples of monomers having an ethylenically unsaturated bond in the molecule include ester or amide monomers of acrylic acid or methacrylic acid in which the ester or amide residue (R in -COOR or -CONHR) has an ethylenically unsaturated bond.

Examples of the residue having an ethylenically unsaturated bond (R above) include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$, and $-(CH_2CH_2O)_2-X$ (in the formulae, $R^1$ to $R^3$ independently denote a hydrogen atom, a halogen atom, an alkyl group having 1 to 20 carbon atoms, an aryl group, an alkoxy group, or an aryloxy group, and $R^1$ and $R^2$ or $R^3$ may be bonded to each other to form a ring. n denotes an integer of 1 to 10. X denotes a dicyclopentadienyl residue).

Specific examples of the ester residue (R in -COOR above) include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2NHCOO-CH_2CH=CH_2$, and $-CH_2CH_2O-X$ (in the formula, X denotes a dicyclopentadienyl residue).

Specific examples of the amide residue (R in -CONHR above) include $-CH_2CH=CH_2$, $-CH_2CH_2O-Y$ (in the formula, Y denotes a cyclohexenyl residue), and $-CH_2CH_2OCO-CH=CH_2$.

The crosslinkable group content in the polymer compound for the intermediate layer (the radically polymerizable unsaturated double bond content by iodimetry) is preferably 0.1 to 10.0 mmol per g of polymer compound, more preferably 1.0 to 7.0 mmol, and most preferably 2.0 to 5.5 mmol. In this range, a balance can be achieved between good sensitivity and stain prevention properties, and good storage stability can be obtained.

The polymer compound for the intermediate layer is preferably a polymer having a monomer unit having an adsorbable group and a monomer unit having a hydrophilic group, and is particularly preferably a polymer having a monomer unit having an adsorbable group, a monomer unit having a hydrophilic group, and a monomer unit having a crosslinkable group.

Specific preferred examples of the polymer compound for the intermediate layer are listed below, but the present invention should not be construed as being limited thereto. In the list below, Et denotes an ethyl group, and Me denotes a methyl group. The figures on the bottom right of the parentheses showing the monomer units of the polymer compounds denote molar ratio.

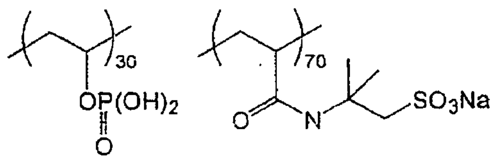

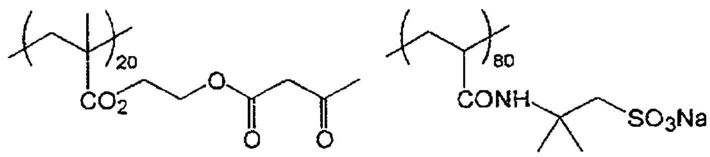

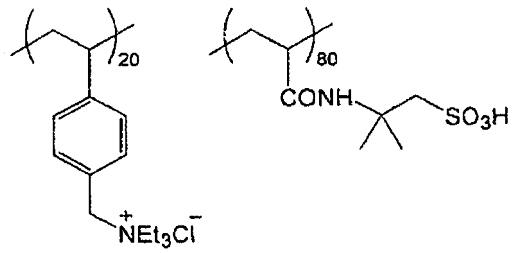

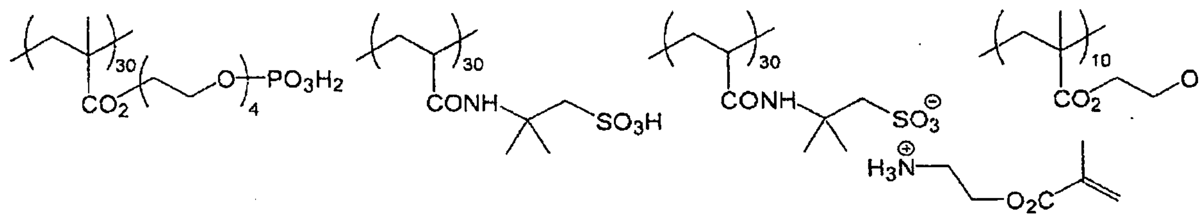

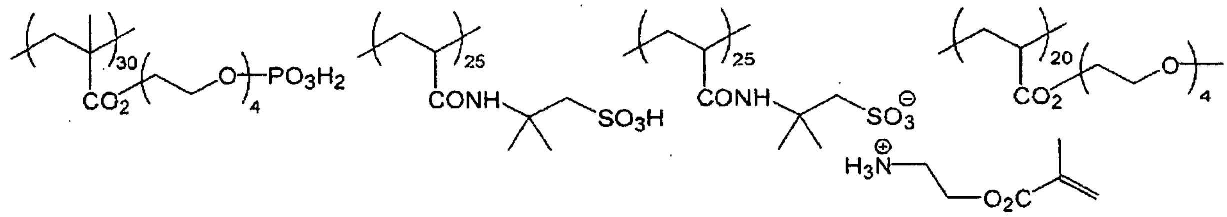

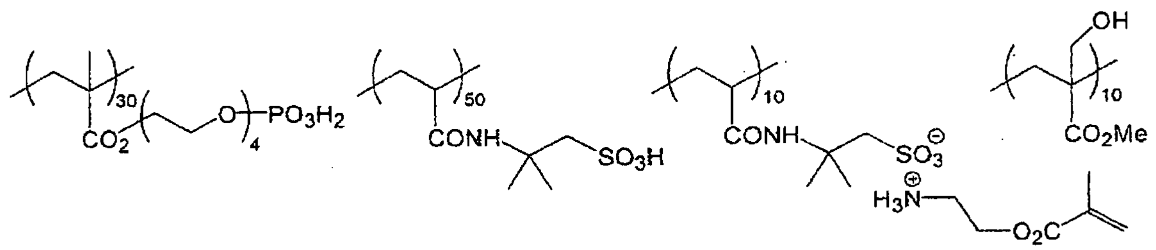

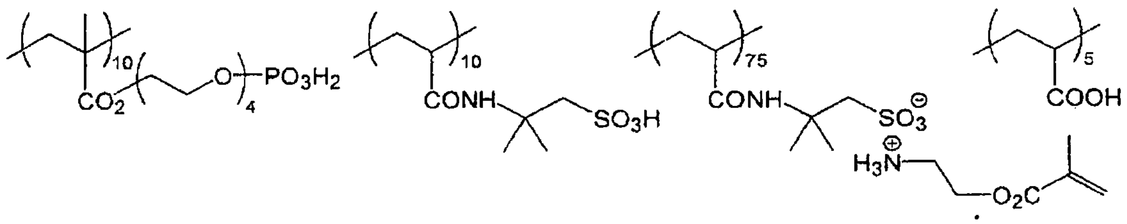

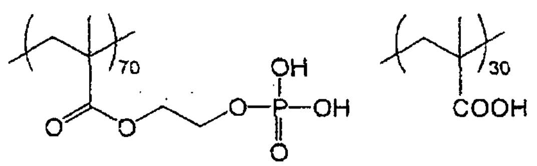

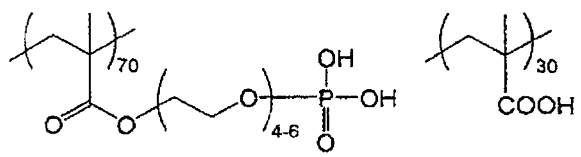

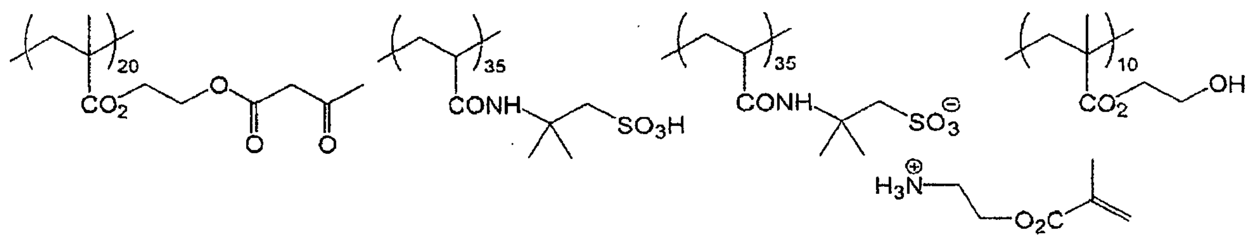

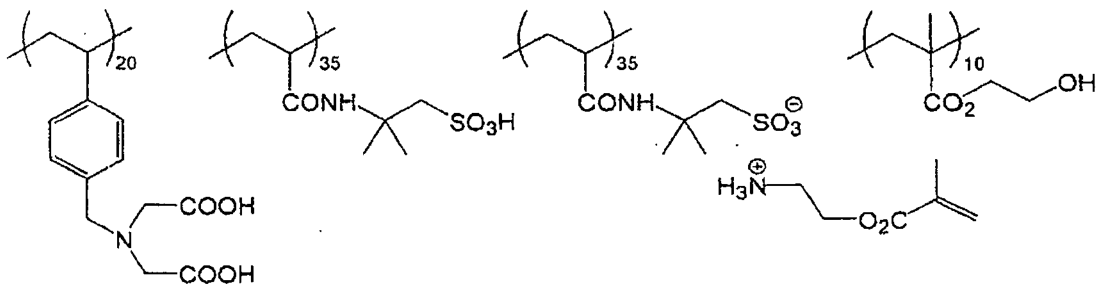

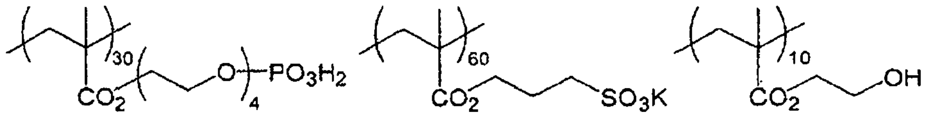

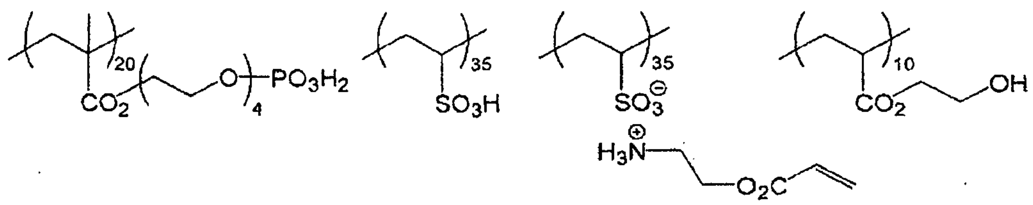

Furthermore, a copolymer comprising a monomer unit containing an ethylenically unsaturated bond, etc. described in JP-A-2005-125749 may also be used preferably.

The polymer compound for the intermediate layer preferably has a weight-average molecular weight of 5,000 or more, and more preferably 10,000 to 300,000, and a number-average molecular weight of 1,000 or more, and more preferably 2,000 to 250,000. The polydispersity (weight-average molecular weight/number-average molecular weight) is preferably 1.1 to 10.

The polymer compound for the intermediate layer may be any of a random polymer, a block polymer, a graft polymer, etc., and is preferably a random polymer.

The polymer compound for the intermediate layer may be used singly or as a mixture of 2 or more types thereof.

The amount of intermediate layer coated (solids content) is preferably 0.1 to 100 mg/$m^2$, and more preferably 1 to 30 mg/$m^2$.

<Image-forming layer (photosensitivity layer, photosensitive layer)>

The lithographic printing plate precursor used in the present invention comprises an image-forming layer above a hydrophilic support as an essential layer, and this image-forming layer comprises as essential components (i) an infrared-absorbing agent, (ii) a polymerization initiator, (iii) an ethylenically unsaturated compound, and (iv) a binder polymer which is a carboxylic acid-containing aqueous alkali-soluble or -swelling organic polymer.

Detailed explanation is given below in this order.

(Infrared-absorbing agent)

The infrared-absorbing agent used in the present invention is a component that is used for increasing sensitivity toward a near-infrared to infrared laser. The infrared-absorbing agent has the function of converting absorbed infrared into heat and is also called a photothermal conversion agent. However, a mechanism of initiating polymerization by energy transfer of the energy absorbed by the infrared-absorbing agent to a polymerization initiator is not excluded. The infrared-absorbing agent used in the present invention is preferably a dye or pigment having a maximum absorption at a wavelength of 760 to 1,200 nm.

As dyes that absorb (near) infra red, commercial dyes and known dyes described in the literature such as, for example, 'Senryo Binran' (Dye Handbook) (Ed. The Society of Synthetic Organic Chemistry, Japan, 1970) may be used. Specific examples thereof include azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Preferred examples of the dyes include cyanine dyes described in JP-A-58-125246, JP-A-59-84356, JP-A-60-78787, etc., methine dyes described in JP-A-58-173696, JP-A-58-181690, JP-A-58-194595, etc., naphthoquinone dyes described in JP-A-58-112793, JP-A-58-224793, JP-A-59-48187, JP-A-59-73996, JP-A-60-52940, JP-A-60-63744, etc., squarylium dyes described in JP-A-58-112792, etc., and cyanine dyes described in British Patent 434,875.

Furthermore, near infrared-absorbing sensitizers described in US Pat. No. 5,156,938 are suitably used, and substituted arylbenzo(thio)pyrylium salts described in US Pat. No. 3,881,924, trimethinethiapyrylium salts described in JP-A-57-142645 (US Pat. No. 4,327,169), pyrylium compounds described in JP-A-58-181051, JP-A-58-220143, JP-A-59-41363, JP-A-59-84248, JP-A-59-84249, JP-A-59-146063, and JP-A-59-146061, cyanine dyes described in JP-A-59-216146, pentamethinethiopyrylium salts described in US Pat. No. 4,283,475, and pyrylium compounds described in JP-B-5-13514 and JP-B-5-19702 (JP-B denotes a Japanese examined patent application publication) are also preferably used. Furthermore, other preferred examples of the dyes include near infrared-absorbing dyes denoted by Formulae (I) and (II) described in US Pat. No. 4,756,993.

Furthermore, as other preferred examples of the infrared-absorbing agent, specific indolenine cyanine dyes described in JP-A-2002-278057 as shown below can be cited.

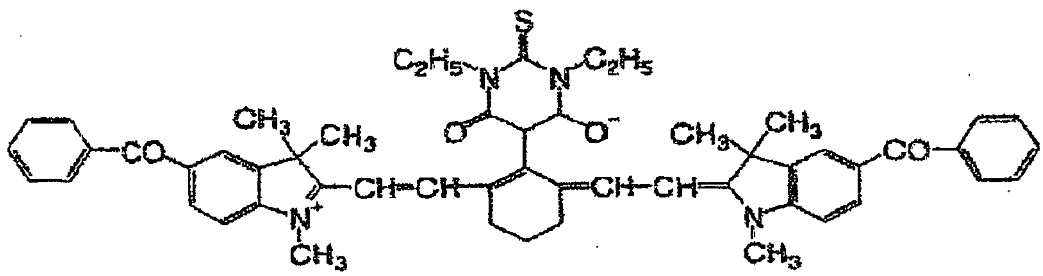

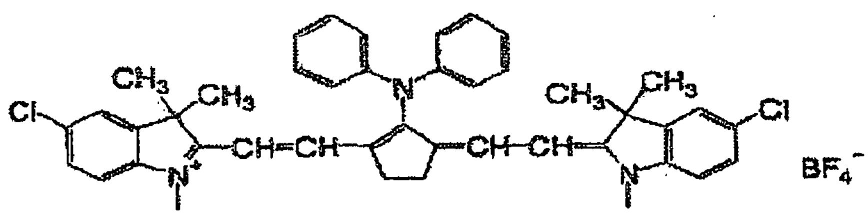

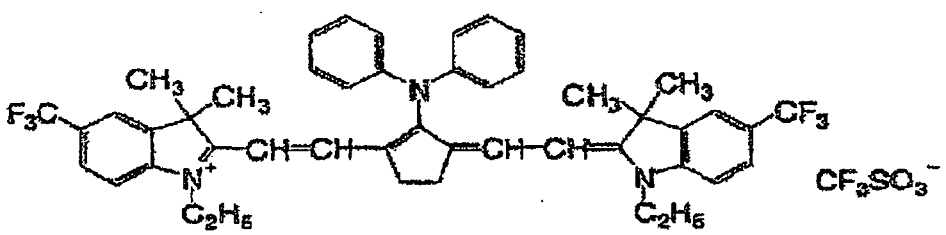

Among these dyes, cyanine dyes, squarylium dyes, pyrylium salts, nickel thiolate complexes, and indolenine cyanine dyes are preferable. Furthermore, cyanine dyes and indolenine cyanine dyes are more preferable, and a cyanine dye represented by Formula (A-I) below can be cited as one particularly preferred example.

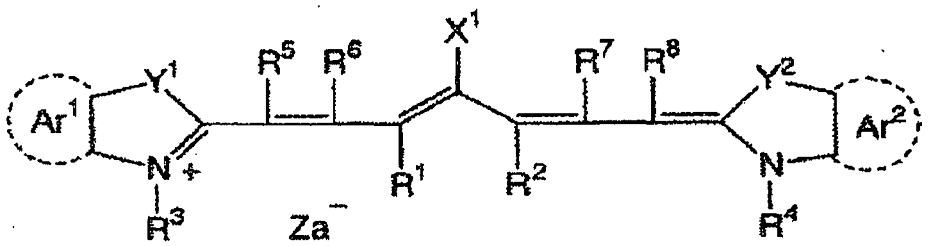

(A-I)

In Formula (A-I), $X^1$ denotes a hydrogen atom, a halogen atom, $-NPh_2$, $X^2$-$L^1$, or a group represented by structural formula (A-Ia) below. $X^2$ denotes an oxygen atom, N-$R^3$ ($R^3$ denotes a hydrogen atom or a monovalent organic group), or a sulfur atom, $L^1$ denotes a hydrocarbon group having 1 to 12 carbon atoms, a heteroatom-containing aromatic

ring, or a heteroatom-containing hydrocarbon group having 1 to 12 carbon atoms. The heteroatom referred to here means N, S, O, a halogen atom, or Se. $X_a^-$ is defined in the same manner as for $Z_a^-$, which is described later. $R^a$ denotes a hydrogen atom, an aryl group, an amino group, or a halogen atom. In the present invention, Ph denotes a phenyl group.

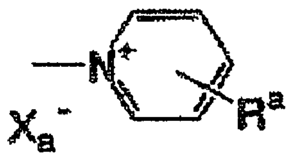

(A-Ia)

$R^1$ and $R^2$ independently denote a hydrocarbon group having 1 to 12 carbon atoms. From the viewpoint of storage stability of a photosensitive layer coating solution, $R^1$ and $R^2$ are preferably hydrocarbon groups having two or more carbon atoms and, furthermore, it is particularly preferable for $R^1$ and $R^2$ to be bonded to each other to form a 5-membered ring or a 6-membered ring.

$Ar^1$ and $Ar^2$ may be identical to or different from each other and denote an aromatic hydrocarbon group. Preferred examples of the aromatic hydrocarbon group include a benzene ring group and a naphthalene ring group. Preferred examples of a substituent include a hydrocarbon group having no greater than 12 carbon atoms, a halogen atom, and an alkoxy group having no greater than 12 carbon atoms. $Y^1$ and $Y^2$ may be identical to or different from each other and denote a sulfur atom or a dialkylmethylene group having no greater than 12 carbon atoms. $R^3$ and $R^4$ may be identical to or different from each other and denote a hydrocarbon group having no greater than 20 carbon atoms. Preferred examples of a substituent include an alkoxy group having no greater than 12 carbon atoms, a carboxy group, and a sulfo group. $R^5$, $R^6$, $R^7$, and $R^8$ may be identical to or different from each other and denote a hydrogen atom or a hydrocarbon group having no greater than 12 carbon atoms. From the viewpoint of starting material availability, a hydrogen atom is preferable. Furthermore, $Z_a^-$ denotes a counteranion. However, when a cyanine dye represented by Formula (A-I) has an anionic substituent within its structure and it is unnecessary to neutralize charge, $Z_a^-$ is not required. From the viewpoint of storage stability of the photosensitive layer coating solution, $Z_a^-$ is preferably a halide ion, a perchlorate ion, a tetrafluoroborate ion, a hexafluorophosphate ion, or a sulfonic acid ion, and is particularly preferably a perchlorate ion, a hexafluorophosphate ion, or an arylsulfonic acid ion.

In the present invention, specific examples of cyanine dyes represented by Formula (A-I) that can be used desirably include those described in paragraphs 0017 to 0019 of JP-A-2001-133969.

Moreover, other particularly preferred examples thereof include specific indolenine cyanine dyes described in JP-A-2002-278057 above.

As pigments that can be used in the function of photothermal conversion in the present invention, commercial pigments and pigments described in 'Karaa Indekkusu' (C.I.) Binran (Handbook), 'Saishin Ganryo Binran' (Latest Pigments Handbook) (Ed. Nippon Ganryo Gijutsu Kyokai, 1977), 'Saishin Ganryo Ouyo Gijutsu' (Latest Pigment Application Techniques) (CMC Publishing, 1986), and Insatsu Inki Gijutsu' (Printing Ink Techniques) (CMC Publishing, 1984) are included.

Examples of the type of pigment include black pigments, yellow pigments, orange pigments, brown pigments, red pigments, violet pigments, blue pigments, green pigments, fluorescent pigments, metal powder pigments and, in addition, polymer-bound dyes. Specifically, insoluble azo pigments, azo lake pigments, condensed azo pigments, chelate azo pigments, phthalocyanine-based pigments, anthraquinone-based pigments, perylene and perinone-based pigments, thioindigo-based pigments, quinacridone-based pigments, dioxazine-based pigments, isoindolinone-based pigments, roso pigments, nitro pigments, natural materials, fluorescent pigments, inorganic pigments, carbon black, etc. may be used. Among these pigments, carbon black is preferable.

These pigments may be used with or without a surface treatment being carried out. As a method for surface treatment, a method in which the surface is coated with a resin or wax, a method in which a surfactant is deposited, a method in which a reactive material (e.g. a silane coupling agent, an epoxy compound, a polyisocyanate, etc.) is bonded to the pigment surface, etc. can be considered. The above-mentioned surface treatment methods are described in 'Kinzoku Sekken no Seishitsu to Ouyo' (Properties and Applications of Metal Soaps) (Saiwai Shobo), 'Insatsu Inki Gijutsu' (Printing Ink Techniques) (CMC Publishing, 1984), and 'Saishin Ganryo Ouyo Gijutsu' (Latest Pigment Application Techniques) (CMC Publishing, 1986).

The particle size of the pigment is preferably in the range of 0.01 μm to 10 μm, more preferably in the range of 0.05 μm to 1 μm, and yet more preferably in the range of 0.1 μm to 1 μm. In this range, good stability and uniformity of a pigment dispersion in a photosensitive layer are obtained.

As a method for dispersing the pigment, a known dispersion technique used for ink production, toner production, etc. may be used. Examples of dispersers include an ultrasonic disperser, a sand mill, an attritor, a pearl mill, a super mill, a ball mill, an impeller, a disperser, a KD mill, a colloidal mill, a Dynatron, a three roll mill, and a pressure kneader. Details are described in 'Saishin Ganryo Ouyo Gijutsu' (Latest Pigment Application Techniques) (CMC Publishing, 1986).

An infrared-absorbing agent may be added by being microencapsulated.

With regard to the amount of infrared-absorbing agent added, it is added so that the absorbance of the photosensitive layer by a reflectance measurement method at a maximum absorption wavelength in the wavelength range of 760 nm to 1,200 nm is preferably in the range of 0.1 to 1.5, more preferably in the range of 0.2 to 1.2, and yet more preferably 0.3 to 1.0. When in this range, a polymerization reaction progresses uniformly in the depth direction of the photosensitive layer, and good film strength for an image area and adhesion to a support are obtained.

The absorbance of the photosensitive layer may be adjusted by the amount of infrared-absorbing agent added to the photosensitive layer and the thickness of the photosensitive layer. The absorbance may be measured by a standard method. Examples of the measurement method include a method in which a photosensitive layer having an appropriately determined thickness so that the dry coat weight is in a range necessary as a lithographic printing plate is formed by coating a reflective support such as aluminum and the reflection density is measured by an optical densitometer, and a method in which measurement is carried out using a spectrophotometer by a reflectance method using an integrating sphere.

(Polymerization initiator)

In the present invention, the polymerization initiator used in the photosensitive layer is a photo- or thermo-polymerization initiator that generates radicals by light or heat energy, and is a compound that initiates or promotes polymerization of an ethylenically unsaturated compound. The polymerization initiator may be selected appropriately from known radical polymerization initiators, compounds having a bond that has small bond dissociation energy, etc.

Examples of the polymerization initiator include an organic halogen compound, a carbonyl compound, an organic peroxide, an azo compound, an azido compound, a metallocene compound, a hexaarylbiimidazole compound, an organoboron compound, a disulfone compound, an oxime ester compound, and an onium salt compound.

Specific examples of the organic halogen compound include compounds described in Wakabayashi et al., "Bull. Chem. Soc. Japan", 42, 2924 (1969), US Pat. No. 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, and M. P. Hutt, "Journal of Heterocyclic Chemistry", 1 (No. 3) (1970). Among them, oxazole and s-triazine compounds substituted with a trihalomethyl group are preferable.

More preferably, it is an s-triazine derivative or oxadiazole derivative in which at least one mono-, di-, or tri-halogen-substituted methyl group is bonded to an s-triazine ring or an oxadiazole ring. Specific examples thereof include 2,4,6-tris(monochloromethyl)-*s*-triazine, 2,4,6-tris(dichloromethyl)-*s*-triazine, 2,4,6-tris(trichloromethyl)-*s*-triazine, 2-methyl-4,6-bis(trichloromethyl)-*s*-triazine, 2-*n*-propyl-4,6-bis(trichloromethyl)-*s*-triazine, 2-(α,α,β-trichloroethyl)-4,6-bis(trichloromethyl)-*s*-triazine, 2-(3,4-epoxyphenyl)-4,6-bis(trichloromethyl)-*s*-triazine, 2-[1-(*p*-methoxyphenyl)-2,4-butadienyl]-4,6-bis(trichloromethyl)-*s*-triazine, 2-styryl-4,6-bis(trichloromethyl)-*s*-triazine, 2-(*p*-methoxystyryl)-4,6-bis(trichloromethyl)-*s*-triazine, 2-(*p*-*i*-propyloxystyryl)-4,6-bis(trichloromethyl)-*s*-triazine, 2-(*p*-tolyl)-4,6-bis(trichloromethyl)-s-triazine, 2-(4-methoxynaphthyl)-4,6-bis(trichloromethyl)-*s*-triazine, 2-phenylthio-4,6-bis(trichloromethyl)-*s*-triazine, 2-benzylthio-4,6-bis(trichloromethyl)-*s*-triazine, 2,4,6-tris(dibromomethyl)-*s*-triazine, 2,4,6-tris(tribromomethyl)-*s*-triazine, 2-methyl-4,6-bis(tribromomethyl)-*s*-triazine, 2-methoxy-4,6-bis(tribromomethyl)-*s*-triazine, and the compounds below.

(I)-1

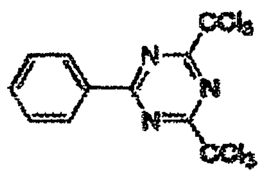

(I)-2

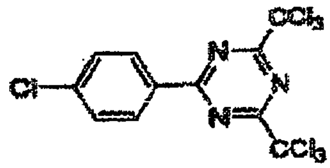

(I)-3

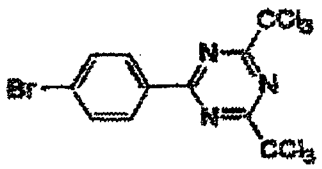

(I)-4

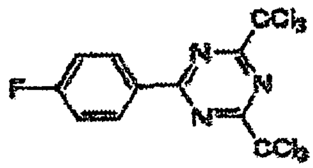

(I)-5

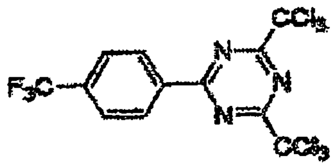

(I)-6

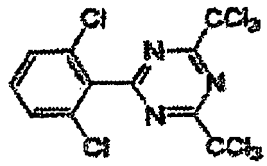

(I)-7

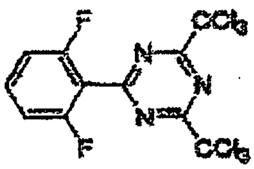

(I)-8

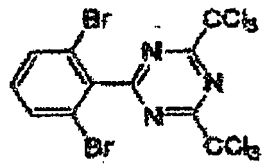

(I)-9

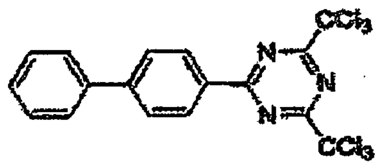

(I)-10

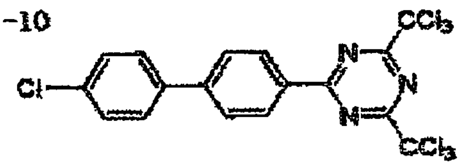

(I)-11

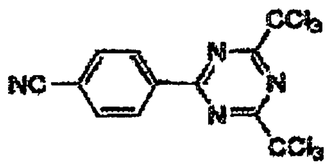

(I)-12

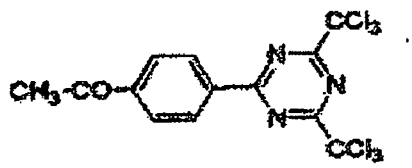

(I)-13

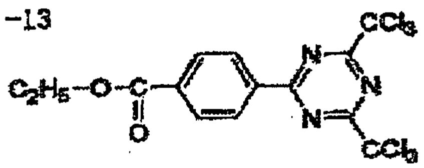

(I)-14

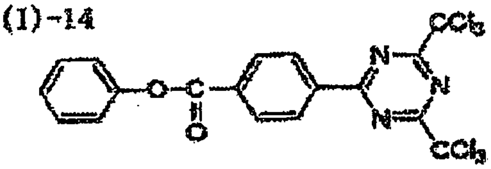

(I)-15

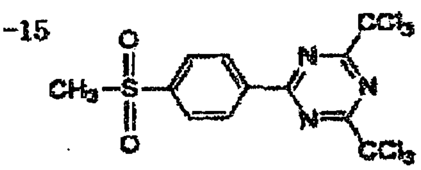

(I)-16

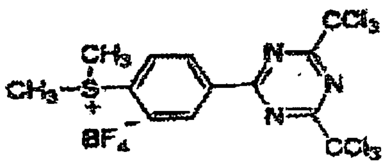

(I)-17

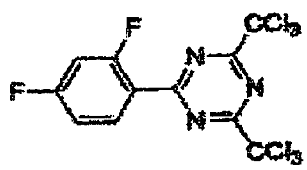

(I)-18

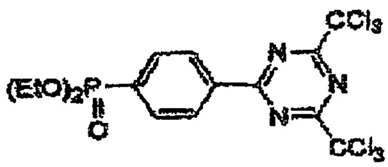

(I)-19

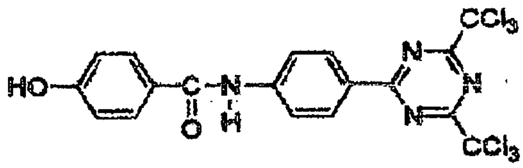

(I)-20

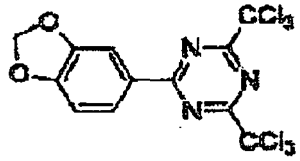

(I)-21

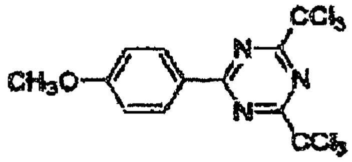

(I)-22

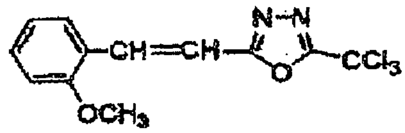

(I)-23

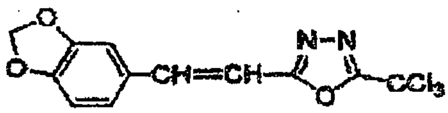

(I)-24

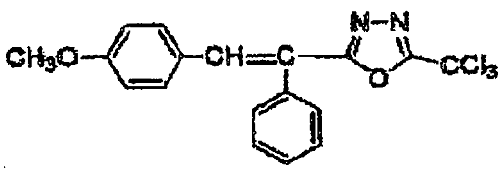

(I)-25

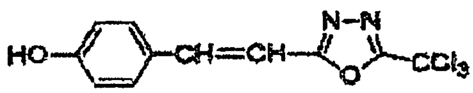

(I)-26

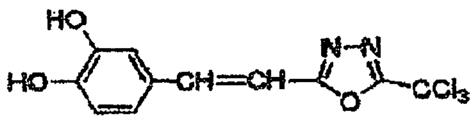

(I)-27

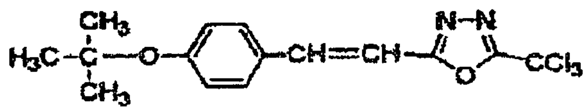

Examples of the above carbonyl compound include benzophenone, benzophenone derivatives such as Michler's Ketone, 2-methylbenzophenone, 3-methylbenzophenone, 4-methylbenzophenone, 2-chlorobenzophenone, 4-bromobenzophenone, and 2-carboxybenzophenone, acetophenone derivatives such as 2,2-dimethoxy-2-phenylacetophenone, 2,2-diethoxyacetophenone, 1-hydroxycyclohexyl phenyl ketone, $\alpha$-hydroxy-2-methylphenylpropanone, 1-hydroxy-1-methylethyl-(*p*-isopropylphenyl) ketone, 1-hydroxy-1-(*p*-dodecylphenyl) ketone, 2-methyl-(4'-(methylthio)phenyl)-2-morpholino-1-propanone, and 1,1,1-trichloromethyl-(*p*-butylphenyl) ketone, thioxanthone, thioxanthone derivatives such as 2-ethylthioxanthone, 2-isopropylthioxanthone, 2-chlorothioxanthone, 2,4-dimethylthioxanthone, 2,4-diethylthioxanthone, and 2,4-diisopropylthioxanthone, and benzoic acid ester derivatives such as ethyl *p*-dimethylaminobenzoate and ethyl *p*-diethylaminobenzoate.

As the above azo compound, for example, azo compounds described in JP-A-8-108621 may be used.

An azido compound is an aromatic azido compound in which an azido group is bonded to an aromatic ring directly or via a carbonyl group or a sulfonyl group. The azido group thereof undergoes decomposition by light to form a nitrene, and the nitrene undergoes various reactions to become insoluble.

Preferred examples of the aromatic azido compound include compounds that contain one or more groups such as azidophenyl, azidostyryl, azidobenzal, azidobenzoyl, and azidocinnamoyl, and specific examples thereof include 4,4'-diazidochalcone, 4-azido-4'-(4-azidobenzoylethoxy)chalcone, *N*,*N*-bis-*p*-azidobenzal-*p*-phenylenediamine, 1,2,6-tri(4'-azidobenzoxy)hexane, 2-azido-3-chloro-benzoquinone, 2,4-diazido-4'-ethoxyazobenzene, 2,6-di(4'-azidobenzal)-4-methylcyclohexanone, 4,4'-diazidobenzophenone, 2,5-diazido-3,6-dichlorobenzoquinone, 2,5-bis(4-azidostyryl)-1,3,4-oxadiazole, 2-(4-azidocinnamoyl)thiophene, 2,5-di(4'-azidobenzal)cyclohexanone, 4,4'-diazidophenylmethane, 1-(4-azidophenyl)-5-furyl-2-penta-2,4-dien-1-one, 1-(4-azidophenyl)-5-(4-methoxyphenyl)-penta-1,4-dien-3-one, 1-(4-azidophenyl)-3-(1-naphthyl)propen-1-one, 1-(4-azidophenyl)-3-(4-dimethylaminophenyl)-propan-1-one, 1-(4-azidophenyl)-5-phenyl-1,4-pentadien-3-one, 1-(4-azidophenyl)-3-(4-nitrophenyl)-2-propen-1-one, 1-(4-azidophenyl)-3-(2-furyl)-2-propen-1-one, 1,2,6-tri(4'-azidobenzoxy)hexane, 2,6-bis-(4-azidobenzylidyne-*p*-*t*-butyl)cyclohexanone, 4,4'-diazidobenzalacetone, 4,4'-diazidostilbene-2,2'-disulfonic acid, 4'-azidobenzalacetophenone-2-sulfonic acid, 4,4'-diazidostilbene-α-carboxylic acid, di-(4-azido-2'-hydroxybenzal)acetone-2-sulfonic acid, 4-azidobenzalacetophenone-2-sulfonic acid, 2-azido-1,4-dibenzenesulfonylaminonaphthalene, and 4,4'-diazidostilbene-2,2'-disulfonic acid anilide.

Other than these low-molecular-weight aromatic azido compounds, azido group-containing polymers describe in JP-B-44-9047, JP-B-44-31837, JP-B-45-9613, JP-B-45-24915, JP-B-45-25713, JP-A-50-5102, JP-A-50-84302, JP-A-50-84303, and JP-A-53-12984 are also suitable.

Examples of the above organic peroxide include trimethylcyclohexanone peroxide, acetylacetone peroxide, 1,1-bis(*tert*-butylperoxy)-3,3,5-trimethylcyclohexane, 1,1-bis(*tert*-butylperoxy)cyclohexane, 2,2-bis(*tert*-butylperoxy)butane, *tert*-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, *tert*-butylcumyl peroxide, dicumyl peroxide, 2,5-dimethyl-2,5-di(*tert*-butylperoxy)hexane, 2,5-oxanoyl peroxide, peroxysuccinic acid, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl) peroxydicarbonate, *tert*-butyl peroxyacetate, *tert*-butyl peroxypivalate, *tert*-butyl peroxyneodecanoate, *tert*-butyl peroxyoctanoate, *tert*-butyl peroxylaurate, 3,3',4,4'-tetra-(*t*-butylperoxycarbonyl)benzophenone, 3,3',4,4'-tetra-(*t*-hexylperoxycarbonyl)benzophenone, 3,3',4,4'-tetra-(*p*-isopropylcumylperoxycarbonyl)benzophenone, carbonyl di(*t*-butylperoxydihydrogendiphthalate), and carbonyl di(*t*-hexylperoxydihydrogendiphthalate).

Examples of the above metallocene compound include various titanocene compounds described in JP-A-59-152396, JP-A-61-151197, JP-A-63-41484, JP-A-2-249, JP-A-2-4705, and JP-A-5-83588, such as di-cyclopentadienyl-Ti-bis-phenyl, di-cyclopentadienyl-Ti-bis-2,6-difluorophen-1-yl, di-cyclopentadienyl-Ti-bis-2,4-di-fluorophen-1-yl, di-cyclopentadienyl-Ti-bis-2,4,6-trifluorophen-1-yl, di-cyclopentadienyl-Ti-bis-2,3,5,6-tetrafluorophen-1-yl, di-cyclopentadienyl-Ti-bis-2,3,4,5,6-pentafluorophen-1-yl, di-methylcyclopentadienyl-Ti-bis-2,6-difluorophen-1-yl, di-methylcyclopentadienyl-Ti-bis-2,4,6-trifluorophen-1-yl, di-methylcyclopentadienyl-Ti-bis-2,3,5,6-tetrafluorophen-1-yl, di-methylcyclopentadienyl-Ti-bis-2,3,4,5,6-pentafluorophen-1-yl, and bis(cyclopentadienyl)-bis(2,6-difluoro-3-(pyr-1-yl)phenyl)titanium, and iron-arene complexes described in JP-A-1-304453 and JP-A-1-152109.

Examples of the above hexaarylbiimidazole compound include various compounds described in JP-B-6-29285 and US Pat. Nos. 3,479,185, 4,311,783, and 4,622,286, and specific examples thereof include 2,2'-bis(*o*-chlorophenyl)-4,4',5,5'-tetraphenylbiimidazole, 2,2'-bis(*o*-bromophenyl)) 4,4',5,5'-tetraphenylbiimidazole, 2,2'-bis(*o*,*p*-dichiorophenyl)-4,4',5,5'-tetraphenylbiimidazole, 2,2'-bis(*o*-chlorophenyl)-4,4',5,5'-tetra(*m*-methoxy phenyl)biididazole, 2,2'-bis(*o*,*o*'-dichlorophenyl)-4,4',5,5'-tetraphenylbiimidazole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o*-trifluorophenyl)-4,4',5,5'-tetraphenylbiimidazole.

Examples of the above organoboron compound include organoborates described in JP-A-62-143044, JP-A-62-150242, JP-A-9-188685, JP-A-9-188686, JP-A-9-188710, JP-A-2000-131837, JP-A-2002-107916, Japanese registered patent No. 2764769, JP-A-2002-116539, and Martin Kunz, Rad Tech '98. Proceeding April, 19-22, 1998, Chicago, organoboron sulfonium complexes and organoboron oxosulfonium complexes described in JP-A-6-157623, JP-A-6-175564, and JP-A-6-175561, organoboron iodonium complexes described in JP-A-6-175554 and JP-A-6-175553, organoboron phosphonium complexes described in JP-A-9-188710, and organoboron transition metal coordination complexes described in JP-A-6-348011, JP-A-7-128785, JP-A-7-140589, JP-A-7-306527, and JP-A-7-292014.

Examples of the above disulfone compound include compounds described in JP-A-61-166544 and JP-A-2003-328465.

Examples of the above oxime ester compound include compounds described in J. C. S. Perkin II. 1653-1660 (1979), J. C. S. Perkin II, 156-162 (1979), Journal of Photopolymer Science and Technology, 202-232 (1995), JP-A-2000-66385, and JP-A-2000-80068. Specific examples thereof include compounds represented by the structural formulae below.

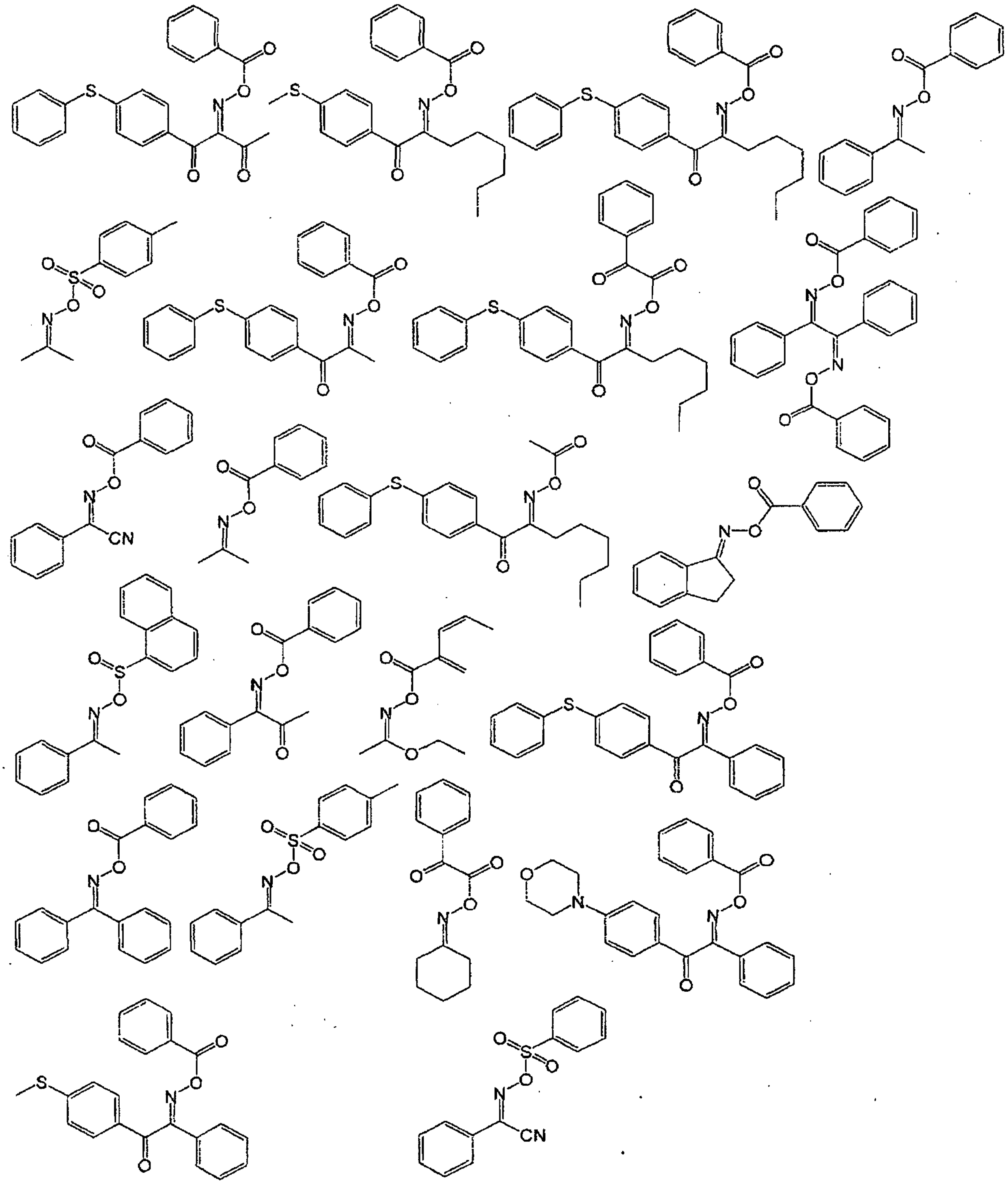

Examples of the above onium salt compound include diazonium salts described in S. I. Schlesinger, Photogr. Sci. Eng., 18, 387 (1974) and T. S. Bal et al., Polymer, 21, 423 (1980), ammonium salts described in US Pat. No. 4,069,055, and JP-A-4-365049, phosphonium salts described in US Pat. Nos. 4,069,055 and 4,069,056, sulfonium salts described in EP Patent No. 104,143 and US Pat. Nos. 339,049, 410,201, 580, and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), and arsonium salts described in C. S. Wen et al., The Proc. Conf. Rad. Curing ASIA, p.478, Tokyo, Oct. (1988).

In the present invention, these onium salt compounds function not as acid generating agents but as ionic radical polymerization initiators.

Preferably used onium salt compounds are onium salts represented by Formulae (RI-I) to (RI-III) below.

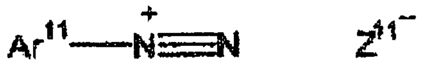
(RI-I)

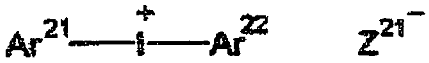
(RI-II)

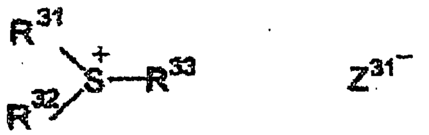
(RI-III)

In formula (RI-I), $Ar^{11}$ denotes an aryl group that has no greater than 20 carbon atoms and that may have 1 to 6 substituents. Preferable examples of the substituent include an alkyl group having no greater than 12 carbon atoms, an alkenyl group having no greater than 12 carbon atoms, an alkynyl group having no greater than 12 carbon atoms, an aryl group having no greater than 12 carbon atoms, an alkoxy group having no greater than 12 carbon atoms, an aryloxy group having no greater than 12 carbon atoms, a halogen atom, an alkylamino group having no greater than 12 carbon atoms, a dialkylamino group having no greater than 12 carbon atoms, an alkylamide group or arylamide group having no greater than 12 carbon atoms, a carbonyl group, a carboxy group, a cyano group, a sulfonyl group, a thioalkyl group having no greater than 12 carbon atoms, and a thioaryl group having no greater than 12 carbon atoms. $Z^{11-}$ denotes a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, and a sulfate ion. Among them, a perchlorate ion, a hexafluorophosphate ion, a tetrafluoroborate ion, a sulfonate ion, and a sulfinate ion are preferable from the viewpoint of stability.

In formula (RI-II), $Ar^{21}$ and $Ar^{22}$ independently denote an aryl group that has no greater than 20 carbon atoms and that may have 1 to 6 substituents. Preferable examples of the substituent include an alkyl group having no greater than 12 carbon atoms, an alkenyl group having no greater than 12 carbon atoms, an alkynyl group having no greater than 12 carbon atoms, an aryl group having no greater than 12 carbon atoms, an alkoxy group having no greater than 12 carbon atoms, an aryloxy group having no greater than 12 carbon atoms, a halogen atom, an alkylamino group having no greater than 12 carbon atoms, a dialkylamino group having no greater than 12 carbon atoms, an alkylamide group or arylamide group having no greater than 12 carbon atoms, a carbonyl group, a carboxy group, a cyano group, a sulfonyl group, a thioalkyl group having no greater than 12 carbon atoms, and a thioaryl group having no greater than 12 carbon atoms. $Z^{21-}$ denotes a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity.

In Formula (RI-III), $R^{31}$, $R^{32}$, and $R^{33}$ independently denote an aryl group, alkyl group, alkenyl group, or alkynyl group that has no greater than 20 carbon atoms and that may have 1 to 6 substituents. Among them, the aryl group is preferable from the viewpoint of reactivity and stability. Examples of the substituent include an alkyl group having no greater than 12 carbon atoms, an alkenyl group having no greater than 12 carbon atoms, an alkynyl group having no greater than 12 carbon atoms, an aryl group having no greater than 12 carbon atoms, an alkoxy group having no greater than 12 carbon atoms, an aryloxy group having no greater than 12 carbon atoms, a halogen atom, an alkylamino group having no greater than 12 carbon atoms, a dialkylamino group having no greater than 12 carbon atoms, an alkylamide group or arylamide group having no greater than 12 carbon atoms, a carbonyl group, a carboxy group, a cyano group, a sulfonyl group, a thioalkyl group having no greater than 12 carbon atoms, and a thioaryl group having no greater than 12 carbon atoms. $Z^{31-}$ denotes a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity. Carboxylate ions described in JP-A-2001-343742 are more preferable, and carboxylate ions described in JP-A-2002-148790 are yet more preferable.

Specific examples of onium salts represented by Formulae (RI-I) to (RI-III) are shown below, but the present

invention should not be construed as being limited thereto.

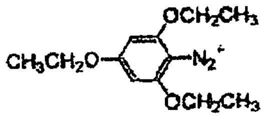
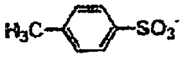
(N-1)

$PF_6^-$ (N-2)

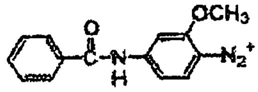
$CF_3SO_3^-$ (N-6)

$BF_4^-$ (N-7)

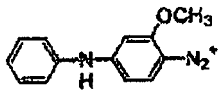
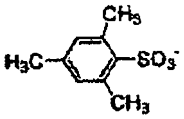
(N-3)

$ClO_4^-$ (N-4)

$PF_6^-$ (N-5)

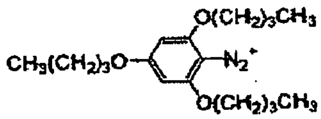
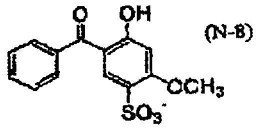
(N-8)

$ClO_4^-$ (N-9)

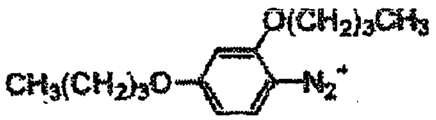
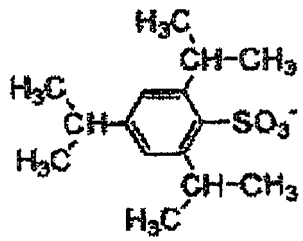
(N-10)

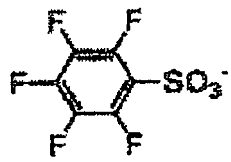
(N-11)

$PF_6^-$ (N-12)

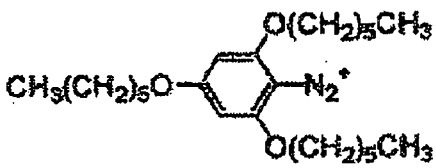
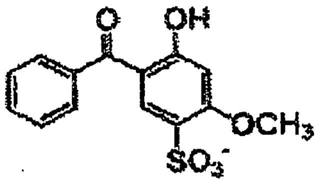
(N-13)

$ClO_4^-$ (N-14)

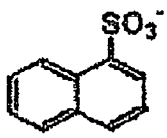
(N-15)

$PF_6^-$ (N-16)

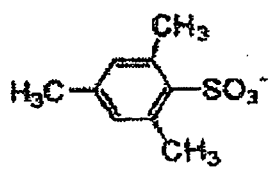
(N-17)

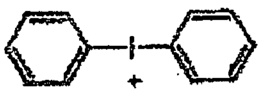

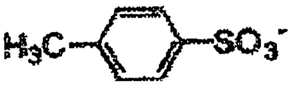 (I-1)

$PF_6^-$ (I-2)

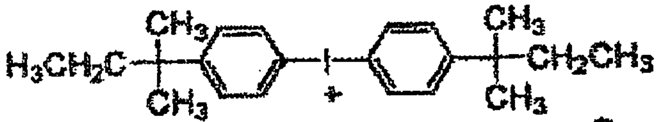

$PF_6^-$ (I-3)

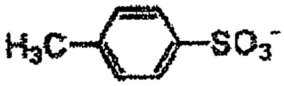 (I-4)

$ClO_4^-$ (I-5)

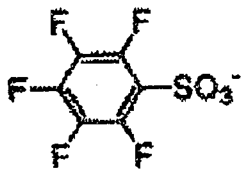 (I-6)

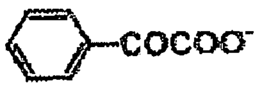 (I-7)

$CF_3SO_3^-$ (I-8)

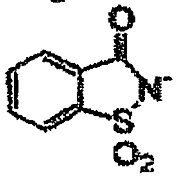 (I-9)

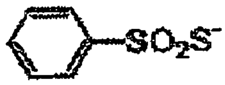 (I-10)

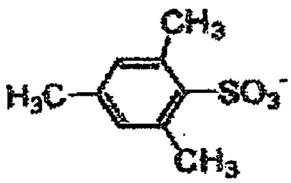 (I-11)

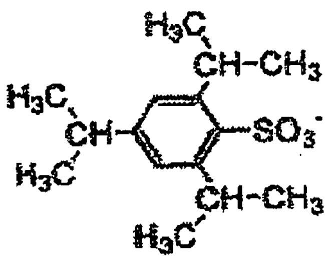 (I-12)

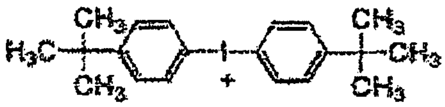 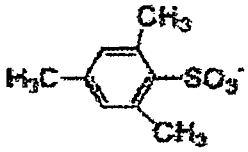 (I-13)

$ClO_4^-$ (I-14)

$PF_6^-$ (I-15)

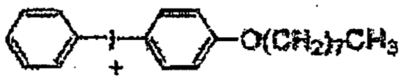 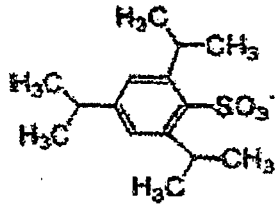 (I-16)

$CF_3COO^-$ (I-17)

$CF_3SO_3^-$ (I-18)

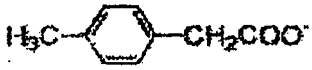 (I-19)

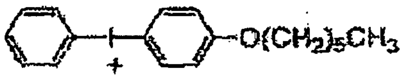 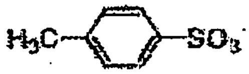 (I-20)

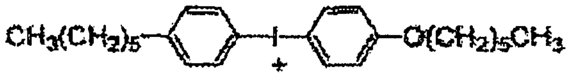 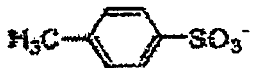 (I-21)

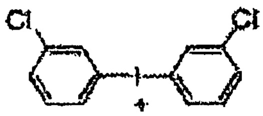 $BF_4^-$ (I-22)

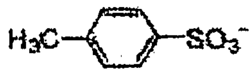 (I-23)

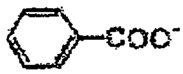 (I-24)

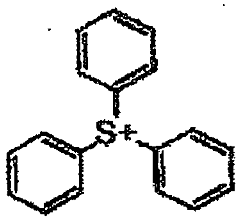

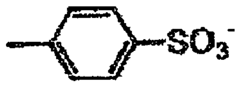 (S-1)

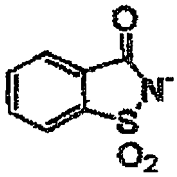 (S-7)

$PF_6^-$ (S-2)

$ClO_4^-$ (S-3)

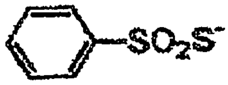 (S-8)

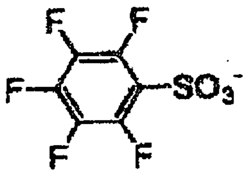 (S-4)

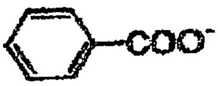 (S-9)

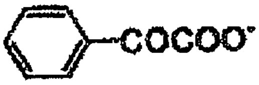 (S-5)

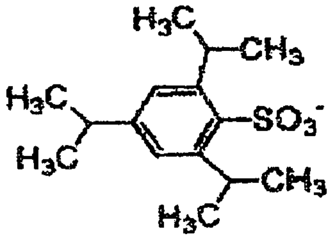 (S-10)

$CF_3SO_3^-$ (S-6)

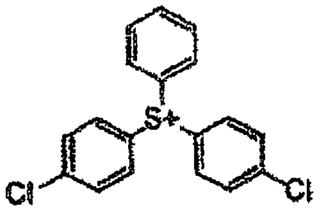

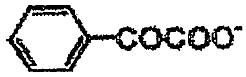

(S-11)

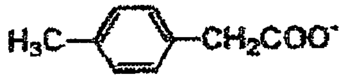

(S-12)

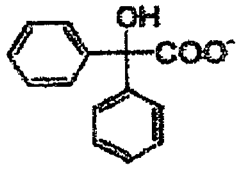

(S-13)

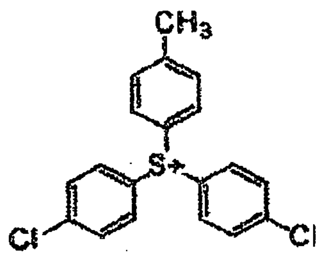

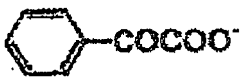

(S-14)

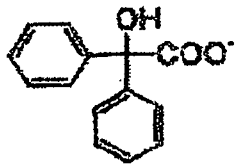

(S-15)

$BF_4^-$ (S-16)

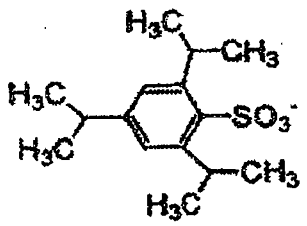

(S-17)

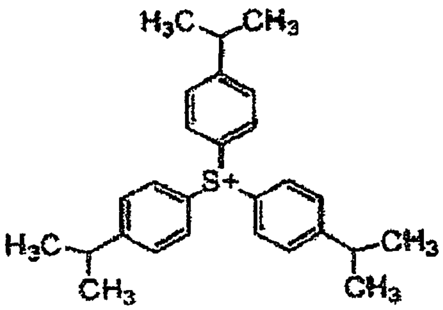

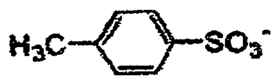

(S-18)

From the viewpoint of reactivity and safety in particular, the polymerization initiator is preferably an organic halogen compound, a metallocene compound, a hexaarylbiimidazole compound, an organoboron compound, an oxime ester compound, or an onium salt compound, and more preferably an organic halogen compound, a metallocene compound, a hexaarylbiimidazole compound, or an onium salt compound.

With regard to the polymerization initiator, it may be used singly or two or more types thereof may be used in combination. The content of the polymerization initiator relative to the total solids content of the photosensitive layer is preferably 0.1 to 50 wt %, more preferably 0.5 to 30 wt %, and yet more preferably 0.8 to 20 wt %.

(Co-sensitizer)

The photosensitive layer may comprise a co-sensitizer. The co-sensitizer referred to here is an additive that can further improve the sensitivity of the photosensitive layer when added to the photosensitive layer. Although the

mechanism of action thereof is not clear, it is thought that it is largely based on the following chemical process. That is, it is surmised that a co-sensitizer reacts with various intermediate active species (radical, peroxide, oxidizing agent, reducing agent, etc.) generated during a photoreaction initiated by light absorption by the above-mentioned polymerization initiator and a subsequent addition-polymerization reaction, thus generating new active radicals. Co-sensitizers can roughly be classified into (a) those that can generate active radicals as a result of reduction, (b) those that can generate active radicals as a result of oxidation, (c) those that react with low activity radicals and are converted into higher activity radicals or that function as a chain transfer agent, but there is often no general view on the classification of individual compounds.

(a) Compound generating active radical as a result of reduction

Compound having carbon-halogen bond: it is surmised that a carbon-halogen bond is reductively cleaved to generate an active radical. Specifically, for example, a trihalomethyl-*s*-triazine, a trihalomethyloxadiazole, etc. is suitably used.

Compound having nitrogen-nitrogen bond: it is surmised that a nitrogen-nitrogen bond is reductively cleaved to generate an active radical. Specifically, for example, a hexaarylbiimidazole, etc. is suitably used.

Compound having oxygen-oxygen bond: it is surmised that an oxygen-oxygen bond is reductively cleaved to generate an active radical. Specifically, for example, an organic peroxide, etc. is suitably used.

Onium compound: it is surmised that a carbon-hetero bond or oxygen-nitrogen bond is reductively cleaved to generate an active radical. Specifically, for example, a diaryliodonium salt, a triarylsulfonium salt, an *N*-alkoxypyridinium (azinium) salt, etc. is suitably used.

(b) Compound generating active radical as a result of oxidation

Alkylate complex: it is surmised that a carbon-hetero bond is oxidatively cleaved to generate an active radical. Specifically, for example, a triarylalkyl borate is suitably used.

Alkylamine compound: it is surmised that a C-X bond on a carbon adjacent to the nitrogen is cleaved as a result of oxidation, thus generating an active radical. As X, a hydrogen atom, a carboxy group, a trimethylsilyl group, a benzyl group, etc. are suitable. Specific examples include an ethanolamine, an *N*-phenylglycine, and an *N*-trimethylsilylmethylaniline.

Sulfur-containing/tin-containing compound: one formed by replacing the nitrogen atom of the above-mentioned amine with a sulfur atom or a tin atom can generate an active radical by the same action. Furthermore, it is known that a compound having an S-S bond is also sensitized as a result of cleavage of S-S.

$\alpha$-Substituted methylcarbonyl compound: cleavage of bond between carbonyl-$\alpha$ carbon as a result of oxidation can generate an active radical. Furthermore, one in which the carbonyl is replaced with an oxime ether exhibits the same action. Specific examples include a 2-alkyl-1-[4-(alkylthio) phenyl]-2-morpholinopropanone-1, an oxime ether formed by reacting the above with a hydroxyamine and then etherifying the N-OH, and an oxime ester formed by esterifying the N-OH.

Sulfinate: an active radical can be reductively generated. Specific examples include a sodium arylsulfinate.

(c) Compound converted into highly active radical by reacting with radical or functioning as chain transfer agent

As a compound that is converted into a highly active radial as a result of reaction with a radical or that functions as a chain transfer agent, a group of compounds having SH, PH, SiH, or GeH in the molecule may be used. These can donate hydrogen to a low activity radical species to generate a radical or are oxidized and then deprotonated to generate a radical. Specific examples thereof include 2-mercaptobenzimidazoles.

The chain transfer agent contributes to improving sensitivity and storage stability.

As the chain transfer agent, thiol compounds (e.g. 2-mercaptobenzimidazoles) may be preferably used. Among them, a thiol compound represented by Formula (T) below is particularly suitably used. In accordance with the use of this thiol compound as a chain transfer agent, problems with odor and degradation of sensitivity due to evaporation from the photosensitive layer or diffusion to another layer can be avoided, and a lithographic printing plate precursor having excellent storage stability and high sensitivity and a lithographic printing plate having high plate life can be obtained.

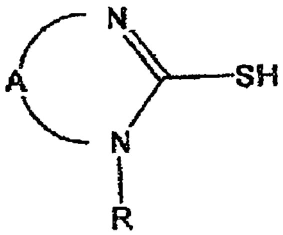

(T)

In Formula (T), R denotes an alkyl group or an aryl group, A denotes an atomic group forming together with the N=C-N moiety a carbon atom-containing 5- or 6-membered heterocycle, and A may further have a substituent.

More preferably, those represented by Formula (TA) or Formula (TB) below are used.

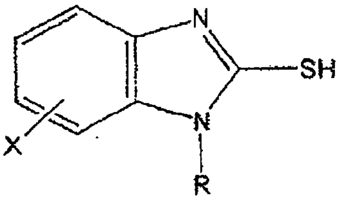

(TA)

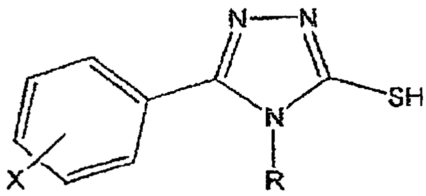

(TB)

In Formula (TA) and Formula (TB), R denotes an alkyl group or an aryl group, and X denotes a hydrogen atom, a halogen atom, an alkoxyl group, an alkyl group, or an aryl group.

Specific examples of compounds represented by Formula (T) are listed below, but the present invention should not be construed as being limited thereto.

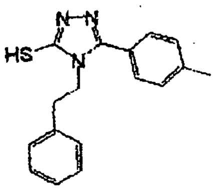 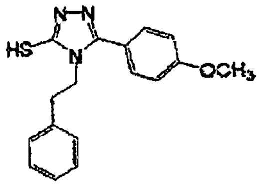 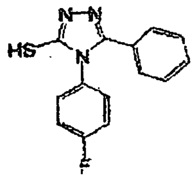 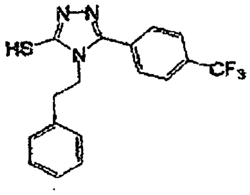

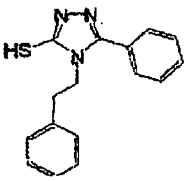 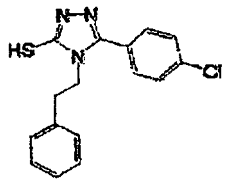 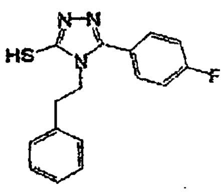 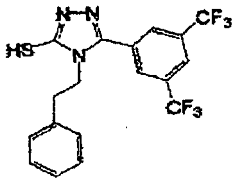

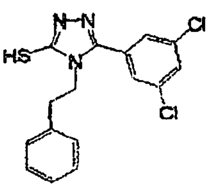 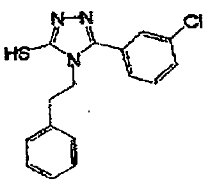 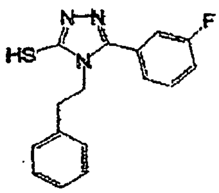 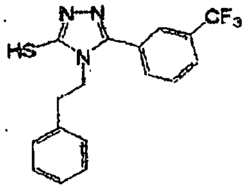

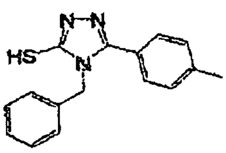 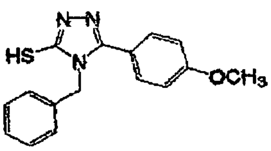 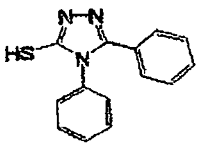 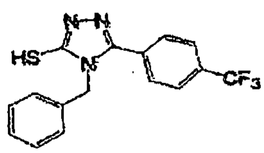

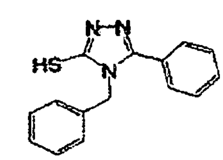
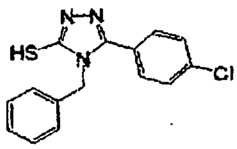
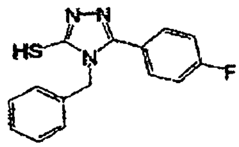
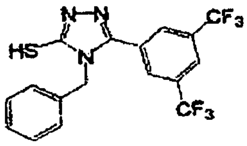

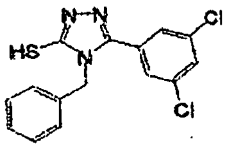
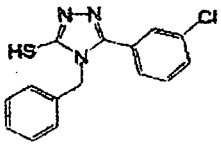
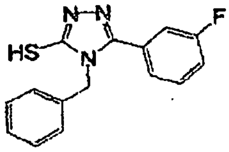
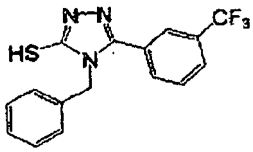

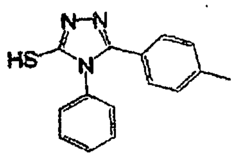
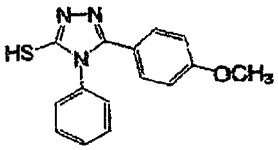
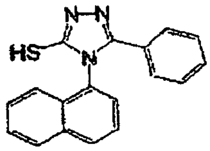
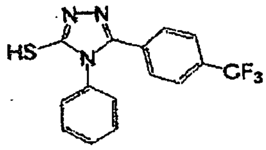

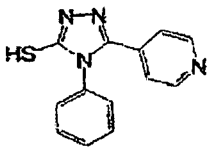
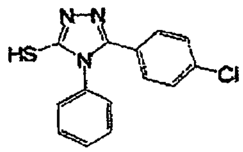
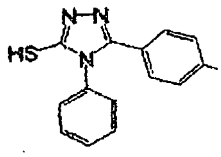
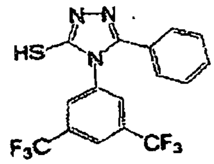

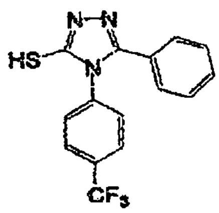
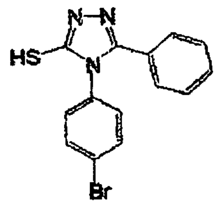
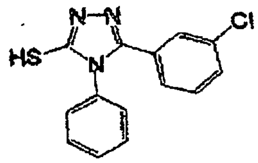
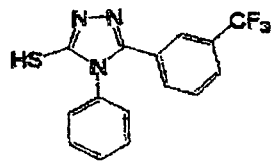

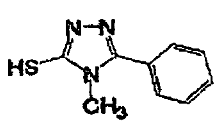
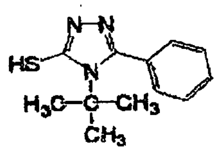
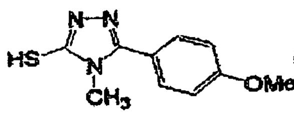
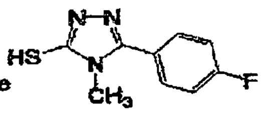

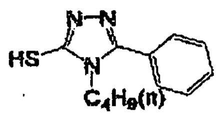
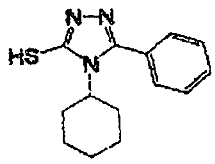
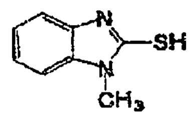
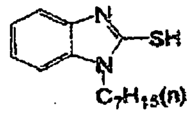

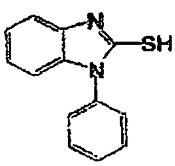
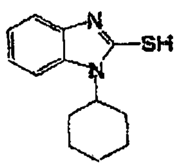
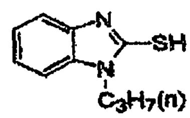
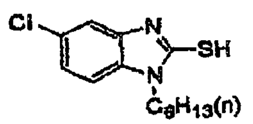

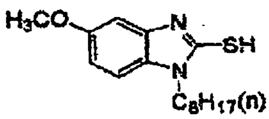
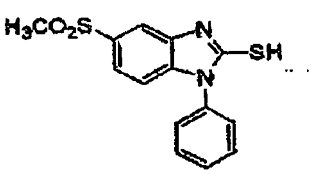
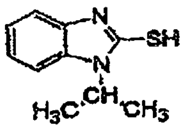
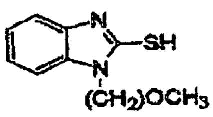

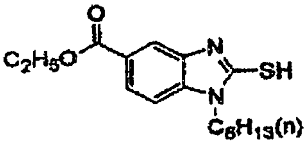
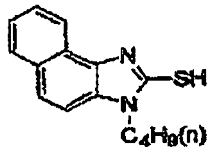
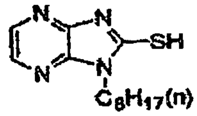
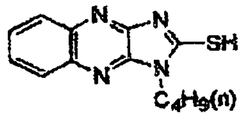

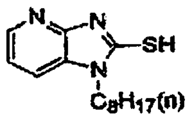
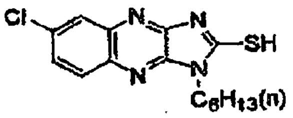
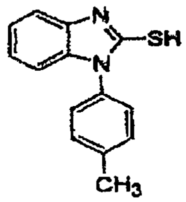
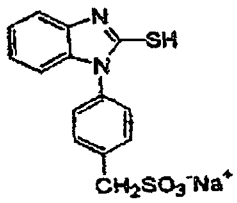

The amount of chain transfer agent used is preferably 0.01 to 20 wt % relative to the total solids content of the photosensitive layer, more preferably 0.1 to 15 wt %, and yet more preferably 1.0 to 10 wt %.

<Ethylenically unsaturated compound>

The ethylenically unsaturated compound that is contained in the image-forming layer in the present invention may be selected freely from compounds having at least one, preferably two or greater, and more preferably 2 to 6 ethylenically unsaturated double bonds. The ethylenically unsaturated compound undergoes addition-polymerization by the action of the polymerization initiator to thus form a polymer or a crosslinked structure, thereby forming a region in the image-forming layer that is not dissolved by processing.

The ethylenically unsaturated compound includes a monofunctional monomer having one ethylenically unsaturated double bond in the molecule and a polyfunctional monomer having two or more of the bonds in the molecule. In the image-forming layer of the present invention, a polyfunctional monomer is preferably used. The molecular weight of such a polyfunctional monomer is preferably 200 to 2,000.

Examples of the monofunctional and polyfunctional ethylenically unsaturated compounds include an ester of an unsaturated carboxylic acid (for example, acrylic acid, methacrylic acid, itaconic acid, crotonic acid, isocrotonic acid, or maleic acid) and an aliphatic polyhydric alcohol compound, and an amide of an unsaturated carboxylic acid and an aliphatic polyvalent amine compound.

Specific examples of monomers that are esters of an aliphatic polyhydric alcohol compound and an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[*p*-(3-methacryloxy-2-hydroxypropoxy)phenyl]dimethylmethane, and bis[*p*-(methacryloxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetradicrotonate.

As isocrotonic acid esters there can be cited ethylene glycol diisocrotonate, pentaerythritol diisocrotonate, and sorbitol tetraisocrotonate.

As maleic acid esters there can cited ethylene glycol dimaleate, triethylene glycol dimaleate, pentaerythritol dimaleate, and sorbitol tetramaleate.

Furthermore, a mixture of the above-mentioned ester monomers can be cited.

Furthermore, specific examples of monomers that are amides of an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide.

Moreover, there can also cited urethane acrylates described in JP-A-51-37193, and polyfunctional acrylates and methacrylates, for example, polyester acrylates and epoxy acrylates obtained by reacting an epoxy resin with (meth)acrylic acid, described in JP-A-48-64183, JP-B-49-43191, and JP-B-52-30490. Moreover, those described as photocurable monomers or oligomers in Nippon Secchaku Kyokaishi (Journal of Japan Adhesion Society), Vol. 20, No. 7, pp. 300-308 (1984) can also be used.

Specific examples thereof include NK OLIGO U-4HA, U-4H, U-6HA, U-6ELH, U-108A, U-1084A, U-200AX, U-122A, U-340A, U-324A, and UA-100 (the above from Shin-Nakamura Chemical Co., Ltd.), UA-306H, AI-600, UA-101T, UA-101I, UA-306T, and UA-306I (the above from Kyoeisha Chemical Co., Ltd.), Art Resin UN-9200A, UN-3320HA, UN-3320HB, UN-3320HC, SH-380G, SH-500, and SH-9832 (the above from Negami Chemical Industrial Co., Ltd.), and PLEX6661-O (Degussa, Germany).

The amount of such an ethylenically unsaturated compound used is preferably in the range of 5 to 90 wt % relative to the total components of the photosensitivity layer (meaning the solids content, the same applies below), and is more preferably in the range of 20 to 75 wt %.

(Binder polymer)

As the binder polymer used in the present invention, a carboxylic acid-containing aqueous alkali-soluble or -swelling organic polymer is used. Examples of such an organic polymer include addition polymers having a carboxylic acid group in a side chain such as those described in JP-A-59-44615, JP-B-54-34327, JP-B-58-12577, JP-B-54-25957, JP-A-54-92723, JP-A-59-53836, and JP-A-59-71048; that is, a methacrylic acid copolymer, an acrylic acid copolymer, an itaconic acid copolymer, a crotonic acid copolymer, a maleic acid copolymer, a partially esterified maleic acid copolymer, etc. are useful. As the binder polymer, a copolymer containing a monomer unit derived from a carboxylic acid (salt) group-containing (meth)acrylic acid ester is preferable.

Furthermore, an acidic cellulose derivative having a carboxylic acid group in a side chain, an addition product of a hydroxy group-containing addition polymer with a cyclic acid anhydride, etc. are also useful.

Moreover, polyurethane resins falling under the definition given in claim 1 described in JP-B-7-120040, JP-B-7-120041, JP-B-7-120042, JP-B-8-12424, JP-A-63-287944, JP-A-63-287947, JP-A-1-271741, and JP-A-11-352691 are also useful as aqueous alkali-soluble or - swelling binders.

As the binder polymer used in the present invention, an acrylic resin, a methacrylic resin, or a urethane resin falling under the definition given in claim 1 is preferably used.

Examples of materials suitable as the binder polymer used in the present invention include a copolymer having (a) a carboxylic acid (including a salt thereof)-containing monomer unit and (b) a monomer unit that imparts radical crosslinkability, which is described later.

The carboxylic acid-containing monomer unit (a) is not particularly limited, but the structure below is preferably used.

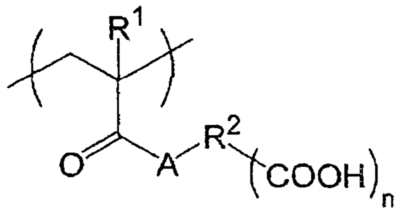

(I)

In Formula (I), $R^1$ denotes a hydrogen atom or a methyl group, $R^2$ denotes a linking group formed so as to contain two or more atoms selected from the group consisting of a carbon atom, a hydrogen atom, an oxygen atom, a nitrogen atom, and a sulfur atom, the number of atoms thereof being 2 to 82. A denotes an oxygen atom or $-NR^3-$, and $R^3$ denotes a hydrogen atom or a monovalent hydrocarbon group having 1 to 10 carbon atoms n denotes an integer of 1 to 5.

The linking group denoted by $R^2$ in Formula (I) is formed so as to contain two or more atoms selected from the group consisting of a carbon atom, a hydrogen atom, an oxygen atom, a nitrogen atom, and a sulfur atom, and the total number of atoms thereof is 2 to 82, preferably 2 to 50, and more preferably 2 to 30. The linking group denoted by $R^2$ may have a substituent. When the linking group has a substituent, the total number of atoms referred to here means the number of atoms including those of the substituent. More specifically, the number of atoms forming the main skeleton of the linking group denoted by $R^2$ is preferably 1 to 30, more preferably 3 to 25, yet more preferably 4 to 20, and most preferably 5 to 10. In addition, the 'main skeleton of the linking group' in the present invention means an atom or a group of atoms used only for linking A and the terminal COOH in Formula (I); in particular, when there are a plurality of linking pathways, it means an atom or a group of atoms constituting the pathway that uses the least number of atoms. Therefore, when there is a ring structure within the linking group, the number of atoms taken into calculation varies according to the linking site thereof (e.g. *o*-, *m*-, *p*-, etc.).

More specific examples of the linking group denoted by $R^2$ in Formula (I) include alkylene, substituted alkylene, arylene, substituted arylene, and an (n + 1)-valent group formed by removing a hydrogen atom on any carbon atom forming the above groups, and those having a structure in which a plurality of the above groups are linked via an amide bond or an ester bond are preferable. In particular, one in which the number of atoms forming the main skeleton of the linking group is 5 to 10 is preferable, and in terms of the structure, one having a chain-like structure and having an ester bond in the structure and one having a cyclic structure described above are preferable.

As the substituent that can be introduced into the linking group denoted by $R^2$, a monovalent non-metal atomic group excluding hydrogen can be cited, and examples thereof include a halogen atom (-F, -Br, -Cl, -I), a hydrocarbon group (an alkyl group, an aryl group, an alkenyl group, an alkynyl group), an alkoxy group, and an aryloxy group.

A in Formula (I) is preferably an oxygen atom or -NH- since synthesis is easy.

n in Formula (I) denotes an integer of 1 to 5, and is preferably 1 in terms of plate life.

Specific examples of the alkali solubility-imparting monomer unit (a) include compounds having structures shown in (a-1) to (a-12) below.

When the total number of monomer units is 100, the content of the carboxylic acid-containing monomer (a) is 5 to 50 units, preferably 5 to 25 units, and more preferably 5 to 15 units.

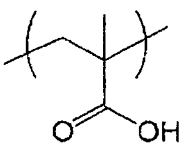

a - 1

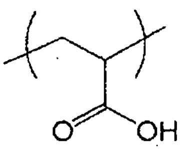

a - 2

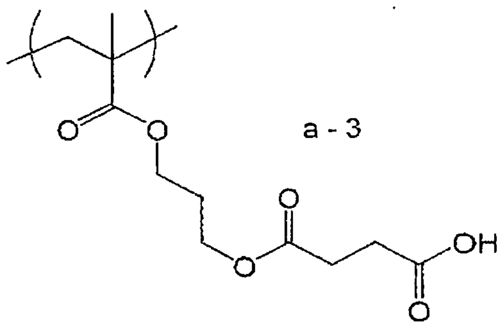

a - 3

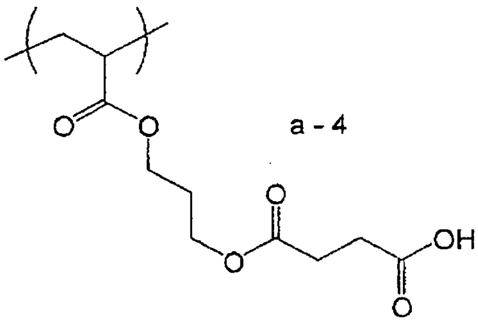

a - 4

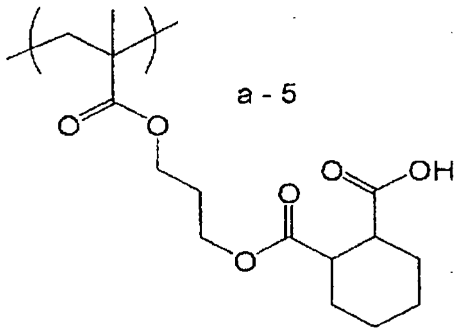

a - 5

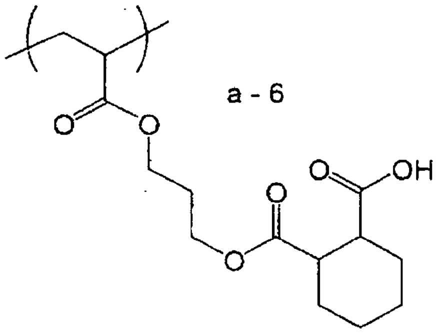
a - 6

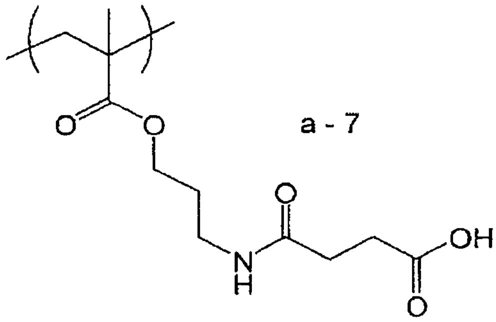
a - 7

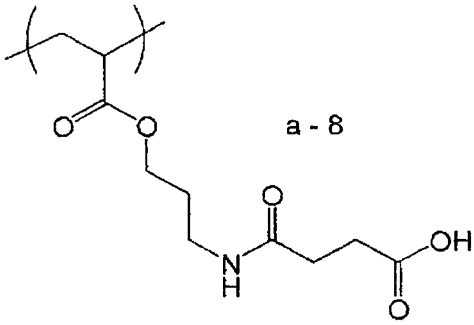
a - 8

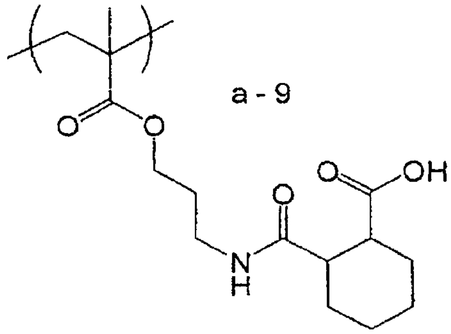
a - 9

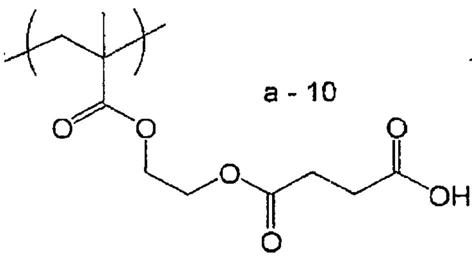
a - 10

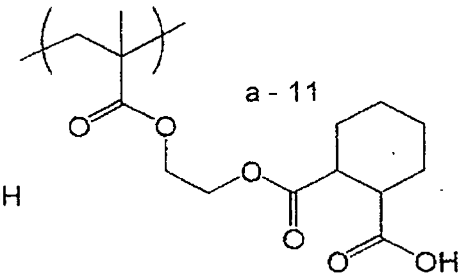
a - 11

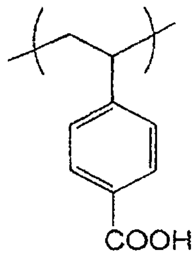
a - 12

Furthermore, specific examples of the radical crosslinkability-imparting monomer unit (b) include structures shown in (b-1) to (b-11) below.

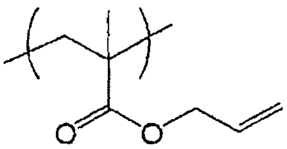
b - 1

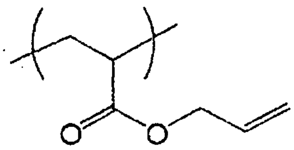
b - 2

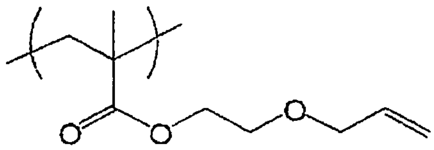
b - 3

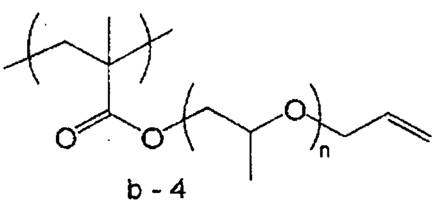
b - 4

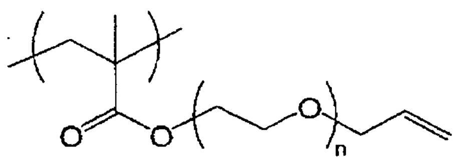
b - 5

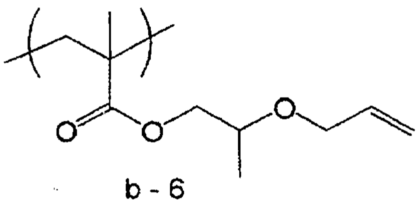

b - 6

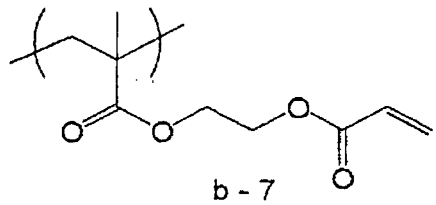

b - 7

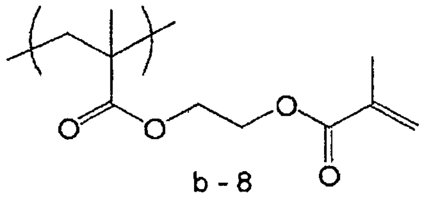

b - 8

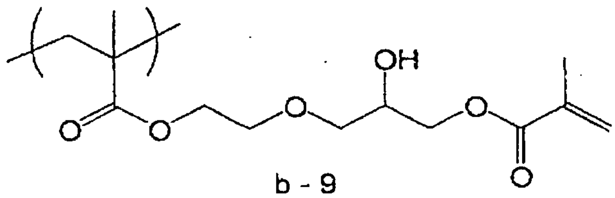

b - 9

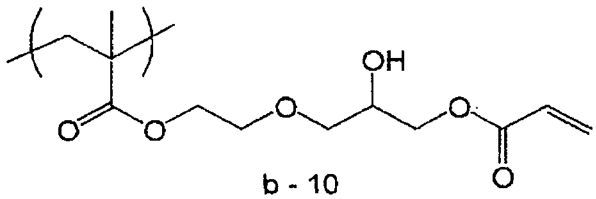

b - 10

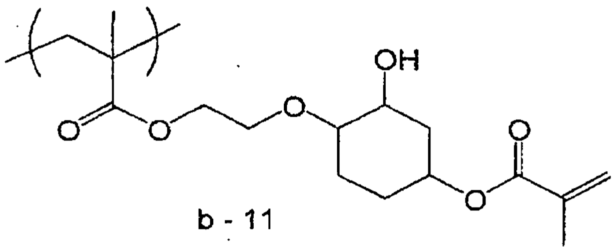

b - 11

When the total number of monomer units is 100, the content of the radical crosslinkablility-imparting monomer unit (b) is 5 to 90 units, preferably 20 to 85 units, and more preferably 40 to 80 units.

The binder polymer used in the present invention may have as a copolymer component a monomer unit derived from an ethylenically unsaturated compound that does not contain either the alkali solubility-imparting monomer unit (a) or the radical crosslinkablility-imparting monomer unit (b). As such a monomer unit, a monomer unit derived from a (meth)acrylic acid ester or a (meth)acrylamide is preferable. In particular, a monomer unit derived from a (meth)acrylamide described in paragraphs 0061 to 0084 of JP-A-2007-272134 is preferably used. The content of the monomer, when the total number of monomer units is 100, is 5 to 50 units, preferably 5 to 35 units, and more preferably 5 to 25 units.

The image-forming layer in the present invention may also employ as a binder polymer, other than an addition polymer having a combination of the above-mentioned monomer units, a urethane resin having a crosslinkable group in a side chain. The crosslinkable group referred to here is a group that can crosslink a binder polymer by a chemical reaction occurring in an image formation layer when a lithographic printing plate precursor is exposed. As long as it is a group having such a function, its chemical structure is not particularly limited, and examples of a functional group that can undergo addition polymerization include an ethylenically unsaturated group, and a cyclic ether group such as an epoxy group/oxetanyl group. Also, a functional group capable of forming a radical upon irradiation with light may be used and such a crosslinkable group includes, for example, a thiol group, a halogen atom, and an onium salt structure. Among them, an ethylenically unsaturated group is preferable, and examples thereof include functional groups described in paragraphs 0130 to 0139 of JP-A-2007-17948.

Since the polyurethane resin having a crosslinkable group in its side chain not only functions as a film-forming agent for the image-forming layer but also is required to dissolve in an alkaline processing solution, it is necessary for it to be soluble or swellable in aqueous alkali. Because of this, the side chain has, other than the crosslinkable group, as an aqueous alkali-soluble group a carboxy group (including a salt thereof). The polyurethane resin is preferable since developability of an unexposed area is not degraded even when the image-forming layer has a low acid value, development damage of an exposed area can be suppressed, and good stain prevention properties and high plate life can both be achieved.

The polyurethane resin having a crosslinkable group in a side chain is explained in detail below.

The polyurethane resin having a crosslinkable group in a side chain that is particularly preferably used in the present invention may be obtained by a polyaddition reaction of (i) a diisocyanate compound, (ii) a carboxy group-containing diol compound, (iii) a crosslinkable group-containing diisocyanate compound and, as necessary, (iv) a diol compound that does not have a carboxy group and (v) an amino group-containing compound.

Examples of compounds (i), (ii), and (iii) above include Formulae (4) to (10) and specific examples described in paragraphs 0142 to 0167 of JP-A-2007-17948.

Here, as a method for introducing a crosslinkable group into a side chain of a polyurethane resin, a method in

which a diisocyanate compound containing a crosslinkable group in a side chain is used as a starting material for production of a polyurethane resin is suitable. It is a diisocyanate compound obtained by an addition reaction of a triisocyanate compound and 1 equivalent of a monofunctional alcohol or monofunctional amine compound having a crosslinkable group, and examples of ones having a crosslinkable group in a side chain include compounds of paragraphs 0179 to 0183 of JP-A-2007-17948.

(iv) Diol compound having no carboxy group

As a method of introducing an unsaturated group into a side chain of a polyurethane resin, a method in which a diol compound having an unsaturated group in a side chain is used as a starting material for production of a polyurethane resin may be employed. Such a diol compound includes a commercial product such as trimethylolpropane monoallyl ether, and also includes a compound produced by a reaction of a halogenated diol compound, triol compound, or amino diol compound with a carboxylic acid, acid chloride, isocyanate, alcohol, amine, thiol, or halogenated alkyl compound having an unsaturated group. Specific examples of these compounds include Formula (A'), Formulae (a) to (e), Formulae (11) to (22), and specific compounds described in paragraphs 0180 to 0225 of JP-A-2007-17948.

(v) Amino-group containing compound

As the binder polymer that can be used in the image-forming layer, an amino group-containing compound may be further combined and reacted with a diisocyanate compound in the production of a polyurethane resin to thus form a urea structure, thereby incorporating it into the structure of the polyurethane resin. The amino group-containing compound includes Formula (31), Formula (32), and specific compounds described in paragraphs 0227 to 0230 of JP-A-2007-17948.

The binder polymer used in the present invention includes, other than the above-mentioned polyurethane resins obtained by introducing a crosslinkable group into a side chain when synthesizing the polyurethane, a polyurethane resin obtained by introducing a crosslinkable group into a carboxy group-containing polyurethane by a polymer reaction as described in JP-A-2003-270775.

In the present invention, a combination of a monomer having a melting point of at least 45°C and, among the above-mentioned urethane resins having a crosslinkable group, a urethane resin having a crosslinkable group and having a Tg of at least 45°C, and preferably at least 50°C, is particularly preferably used. A specific example of such a urethane resin is shown below, but the present invention should not be construed as being limited thereto. The figures on the bottom right of the parentheses showing the monomer units of the urethane resin denote molar ratio.

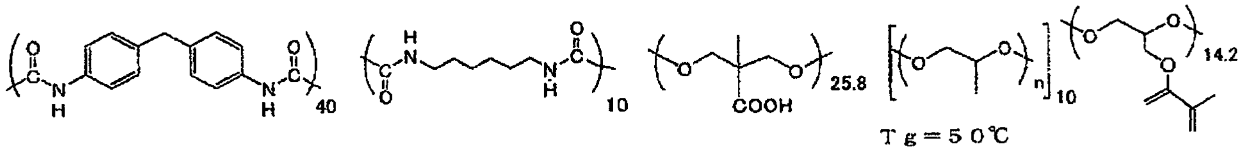

Tg = 50°C

In order to maintain the developability of a photosensitivity layer, it is preferable for the binder polymer used to have an appropriate molecular weight, and the weight-average molecular weight is more preferably 5,000 to 300,000. A particularly preferred range is 20,000 to 150,000.

These binder polymers can be contained in the image-forming layer in any amount, but when the amount exceeds 90 wt %, there are cases in which desirable results cannot be given in terms of image strength, etc., and it is preferably 10 to 90 wt % of the solids content, and more preferably 30 to 80 wt %.

(Microcapsules)

In the present invention, as a method by which the above-mentioned constituent components of the photosensitive layer and other constituent components described hereinafter are contained in the photosensitive layer, part of the constituent components may be encapsulated in microcapsules and added to the photosensitive layer as described in, for example, JP-A-2001-277740 and JP-A-2001-277742. In such a case, each constituent component may be present inside or outside the microcapsules in any ratio.

As a method of microencapsulating the constituent components of the photosensitive layer, known methods can be used.

Methods for the production of microcapsules include, for example, a method utilizing coacervation found in U.S. Pat. Nos. 2,800,457 and 2,800,458, a method using interfacial polymerization found in U.S. Pat. No. 3,287,154, JP-B-38-19574, and JP-B-42-446, a method using polymer deposition found in U.S. Pat. Nos. 3,418,250 and 3,660,304,

a method using an isocyanate polyol wall material found in U.S. Pat. No. 3,796,669, a method using an isocyanate wall material found in U.S. Pat. No. 3,914,511, a method using a urea-formaldehyde-based or urea-formaldehyde-resorcinol-based wali-forming material found in U.S. Pat. Nos. 4,001,140, 4,087,376, and 4,089,802, a method using a wall material, for example, a melamine-formaldehyde resin or hydroxycellulose found in U.S. Pat. No. 4,025,445, an in-situ method by monomer polymerization found in JP-B-36-9163 and JP-B-51-9079, a spray drying method found in GB Patent No. 930,422 and U.S. Pat. No. 3,111,407, and an electrolytic dispersion cooling method found in GB Patents Nos. 952,807 and 967,074, but the present invention should not be construed as being limited thereto.

A preferred microcapsule wall that can be used in the present invention has three-dimensional crosslinking and has the property of being swollen by solvent. From this point of view, preferred wall materials of the microcapsules include polyurea, polyurethane, polyester, polycarbonate, polyamide, and mixtures thereof, and polyurea and polyurethane are particularly preferred. Furthermore, a compound having a crosslinkable functional group such as an ethylenically unsaturated bond, capable of being introduced into above-mentioned water-insoluble polymer, may be introduced into the microcapsule wall.

The average particle size of the microcapsules is preferably 0.01 to 3.0 μm, more preferably 0.05 to 2.0 μm, and yet more preferably 0.10 to 1.0 μm. When in the above-mentioned range, good resolution and stability over time can be achieved.

<Other additive in image-forming layer>

Furthermore, in the photosensitivity layer used in the present invention, in order to prevent unwanted thermal polymerization of an ethylenically unsaturated compound during production or during storage of a composition (photosensitive composition) for forming the photosensitivity layer, it is desirable to add a small amount of a thermal polymerization inhibitor. Appropriate examples of the thermal polymerization inhibitor include hydroquinone, p-methoxyphenol, di-*t*-butyl-p-cresol, pyrogallol, *t*-butylcatechol, benzoquinone, 4,4'-thiobis(3-methyl-6-*t*-butylphenol), 2,2'-methylenebis(4-methyl-6-*t*-butylphenol), *N*-nitrosophenylhydroxylamine cerous salt, and *N*-nitrosophenylhydroxylamine aluminum salt. The amount of thermal polymerization inhibitor added is preferably about 0.01 wt % to about 5 wt % of the total components of the composition. Moreover, as necessary, in order to prevent polymerization inhibition by oxygen, a higher fatty acid derivative such as behenic acid or behenic acid amide, etc. may be added and localized on the surface of the photosensitivity layer during drying after coating. The amount of higher fatty acid derivative added is preferably about 0.5 wt % to about 10 wt % of the total components of the photosensitive composition.

Moreover, for the purpose of coloring of the photosensitivity layer, a colorant may be added. Examples of the colorant include pigments such as a phthalocyanine-based pigment (C.I. Pigment Blue 15:3, 15:4, 15:6, etc.), an azo-based pigment, carbon black, and titanium oxide, ethyl violet, crystal violet, an azo dye, an anthraquinone-based dye, and a cyanine-based dye. The amount of dye and pigment added is preferably about 0.5 wt % to about 5 wt % of the total components (solids content) of the photosensitive composition.

In addition, in order to improve the physical properties of a cured film, an additive such as an inorganic filler or a plasticizer such as dioctyl phthalate, dimethyl phthalate, or tricresyl phosphate may be added. These additives are preferably added at no greater than 10 wt % of the total components of the photosensitive composition.

Moreover, a composition for forming a photosensitivity layer may comprise a surfactant in order to improve coated surface quality. Preferred examples of the surfactant include a fluorine-based nonionic surfactant.

(Solvent of image-forming layer)

In the present invention, the composition for the image-forming layer is applied onto a support that has been subjected to various surface treatments as desired, and when a support is coated with the composition for the image-forming layer, the composition may be dissolved in various organic solvents and used. Examples of solvents that can be used here include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, *N*,*N*-dimethylformamide, dimethyl sulfoxide, γ-butyrolactone, methyl lactate, and ethyl lactate. These solvents may be used singly or as a mixture. The solids content in the coating solution is desirably 1 to 50 wt %.

In the photosensitive lithographic printing plate precursor used in the present invention, the coverage of the photosensitivity layer as a dry coat weight is desirably in the range of about 0.1 $g/m^2$ to about 10 $g/m^2$, preferably 0.3 to 5 $g/m^2$, and yet more preferably 0.5 to 3 $g/m^2$.

<Protective layer>

Usually, in order to prevent polymerization inhibition by oxygen, an oxygen barrier protective layer (overcoat layer) may also be provided above the photosensitivity layer.

Furthermore, in the present invention, the coat weight of the protective layer is preferably in the range of 0.5 to 3.0 g/$m^2$, and more preferably 0.5 to 2.5 g/$m^2$. It is preferable for it to be in this range since sensitivity does not deteriorate and the processing burden does not increase.

As a water-soluble vinyl polymer contained in the oxygen barrier protective layer, a polyvinyl alcohol, a partial ester, ether, or acetal thereof, or a copolymer of these containing substantially the amount of unsubstituted vinyl alcohol unit necessary to make them water-soluble, can be cited. Furthermore, a polyvinyl alcohol having a sulfonic acid group at a terminal or having a hydroxy group substituted with a sulfonic acid is also preferably used. Examples of the polyvinyl alcohol include those that are 71 to 100% hydrolyzed and have a degree of polymerization in the range of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (Kuraray Co., Ltd.). Examples of the above-mentioned copolymer include polyvinyl acetate chloroacetate or propionate, polyvinylformal, and polyvinyl acetal that are 88 to 100% hydrolyzed, and copolymers thereof. Examples of other useful polymers include polyvinylpyrrolidone, gelatin, and gum Arabic, and they may be used singly or in combination.

In the present invention, in order to obtain particularly good results, it is preferable to use a polyvinyl alcohol for which the degree of hydrolysis is at least 95%.

(Acid-modified polyvinyl alcohol)

Among the above, the protective layer in the present invention preferably comprises in particular an acid-modified polyvinyl alcohol. The acid-modified polyvinyl alcohol referred to here means a vinyl alcohol-based polymer containing a predetermined amount of acid groups. In particular, a vinyl alcohol-based polymer containing a predetermined amount of sulfonic acid groups or carboxy groups is preferably used; the former is called a sulfonic acid-modified polyvinyl alcohol, and the latter is called a carboxylic acid-modified polyvinyl alcohol.

As a method of synthesizing an acid-modified polyvinyl alcohol, it is preferably synthesized by a method in which a monomer having an acid group is polymerized together with vinyl acetate, and part or all of the vinyl acetate is then saponified to give vinyl alcohol, but it can be synthesized by bonding a compound having an acid group to a hydroxy group of a polyvinyl alcohol.

Examples of monomers having a sulfonic acid group include ethylenesulfonic acid, allylsulfonic acid, methallylsulfonic acid, 2-acrylamido-2-methylpropanesulfonic acid, and salts thereof. Examples of compounds having a sulfonic acid group include aldehyde derivatives having a sulfonic acid group such as benzaldehyde *p*-sulfonic acid and salts thereof, and introduction is possible by a conventionally known acetalization reaction.

Examples of monomers having a carboxy group include fumaric acid, maleic acid, itaconic acid, maleic anhydride, phthalic anhydride, trimellitic anhydride, acrylic acid, and salts thereof, acrylic acid esters such as methyl acrylate, and methacrylic acid esters such as methyl methacrylate. Examples of compounds having a carboxy group include monomers such as acrylic acid, and introduction is possible by a conventionally known Michael addition reaction.

The acid-modified polyvinyl alcohol may be synthesized on site or may be purchased as a commercial product.

In this way, an acid-modified specific polyvinyl alcohol can suppress degradation of development removability of the photosensitive layer. Among them, one with a degree of saponification of at least 91 mole % is preferable.

Specific examples of such an acid-modified polyvinyl alcohol having a high degree of saponification include carboxy-modified polyvinyl alcohols such as KL-118 (degree of saponification 97 mole %, average degree of polymerization 1,800), KM-618 (degree of saponification 94 mole %, average degree of polymerization 1,800), KM-118 (degree of saponification 97 mole %, average degree of polymerization 1,800), and KM-106 (degree of saponification 98.5 mole %, average degree of polymerization 600) manufactured by Kuraray Co., Ltd., Gohsenal T-330H (degree of saponification 99 mole %, average degree of polymerization 1700), Gohsenal T-330 (degree of saponification 96.5 mole %, average degree of polymerization 1,700), Gohsenal T-350 (degree of saponification 94 mole %, average degree of polymerization 1,700), Gohsenal T-230 (degree of saponification 96.5 mole %, average degree of polymerization 1,500), Gohsenal T-215 (degree of saponification 96.5 mole %, average degree of polymerization 1,300), and Gohsenal T-HS-1 (degree of saponification 99 mole %, average degree of polymerization 1,300) manufactured by the Nippon Synthetic Chemical Industry Co., Ltd., and AF-17 (degree of saponification 96.5 mole %, average degree of polymerization 1,700) and AT-17 (degree of saponification 93.5 mole %, average degree of polymerization 1,700) manufactured by Japan VAM & POVAL Co.

Examples of sulfonic acid-modified polyvinyl alcohols include SK-5102 (degree of saponification 98 mole %, average degree of polymerization 200) manufactured by Kuraray Co., Ltd., and Gohseran CKS-50 (degree of saponification 99 mole %, average degree of polymerization 300) and L-3266 (degree of saponification 88 mole %, average degree of polymerization 300) manufactured by the Nippon Synthetic Chemical Industry Co., Ltd.

Furthermore, from the viewpoint of suppressing degradation of development removability of the photosensitive layer more effectively, it is particularly preferable to use an acid-modified polyvinyl alcohol having an average degree of polymerization of vinyl alcohol units of 100 to 800. In accordance with the use of such an acid-modified polyvinyl alcohol having a low degree of polymerization and a high degree of saponification, it becomes possible to provide a protective layer that can suppress effectively degradation of the development removability of the photosensitive layer while maintaining excellent oxygen barrier properties.

As such an acid-modified polyvinyl alcohol having a low degree of polymerization and a high degree of saponification, an itaconic acid- or maleic acid-modified carboxy-modified polyvinyl alcohol or a sulfonic acid-modified polyvinyl alcohol having a degree of saponification of at least 91 mole % and an average degree of polymerization of vinyl alcohol units of 100 to 800 is preferable.

The degree of modification of the acid-modified polyvinyl alcohol used in the present invention means the molar ratio of acid group-containing units in an acid-modified polyvinyl alcohol copolymer. The degree of modification of the acid-modified polyvinyl alcohol is preferably 0.1 to 20 mole %, and more preferably 0.2 to 5 mole %.

As a solvent used when applying the protective layer in the photosensitive lithographic printing plate precursor used in the present invention, water is preferable, but the water may be mixed with a water-miscible solvent such as an alcohol such as methanol or ethanol or a ketone such as acetone or methyl ethyl ketone. The solids content in the coating solution is suitably 1 to 20 wt %. The above-mentioned protective layer may further comprise a known additive such as a surfactant for improving coating properties or a water-soluble plasticizer for improving physical properties of a film. As the water-soluble plasticizer, for example, there are propionamide, cyclohexanediol, glycerol, sorbitol, etc. Furthermore, a water-soluble (meth)acrylic-based polymer, etc. may be added. The coverage thereof is preferably in the range of 0.1 $g/m^2$ to 15 $g/m^2$ as a dry coat weight, and more preferably in the range of 1.0 $g/m^2$ to 5.0 $g/m^2$.

A protective layer that is located on the outermost part of the lithographic printing plate precursor may comprise organic resin particles containing silica (hereinafter, also called silica-containing organic resin particles as appropriate) and a hydrophilic polymer. By adding to the protective layer a hydrophilic polymer, preferably a hydrophilic polymer having a polyvinyl alcohol as a main component, and silica-containing organic resin particles, the stability of organic resin particles in the coating solution increases remarkably, and a lithographic printing plate precursor prepared using this coating solution can achieve excellent film strength. Furthermore, matte properties can be imparted to the protective layer. As a result, the protective layer can improve not only the sensitivity but also storage stability over time and safelight suitability, and the effect of suppressing degradation due to deformation or the occurrence of scratches is also promising. Furthermore, since excellent matte properties are imparted to the protective layer, when lithographic printing plate precursors of the present invention are stacked, it becomes possible to suppress blocking between the protective layer surface of the lithographic printing plate precursor and the support reverse face of an adjacent lithographic printing plate precursor and suppress scratches caused by rubbing between the protective layer surface and the support reverse face.

Furthermore, in the present invention, it is preferable from the viewpoint of improving various properties such as oxygen barrier properties, resistance to external pressure, and blocking resistance that, when the protective layer is a single layer, an inorganic lamellar compound (hereinafter, also called a mica compound in the present invention) is added to this layer, and when the protective layer has a layered structure it is added to any of the protective layers.

Each component used in the protective layer related to the present invention is explained below in sequence.

(Silica-containing organic resin particles)

In the present invention, the outermost layer of the protective layer comprises silica-containing organic resin particles. The organic resin particles suppress blocking between the protective layer surface of a lithographic printing plate precursor and the support reverse face of an adjacent lithographic printing plate precursor and scratches caused by rubbing between the protective layer surface and the support reverse face. With regard to such basic properties desired for particles functioning as a matting agent, a resin that does not substantially inhibit the transmission of light used for exposure, does not become softened or tacky due to atmospheric humidity or temperature, imparts an appropriate roughness to the surface of the protective layer on the outermost part by its addition, and reduces the surface area involved in blocking is preferable.

Furthermore, from the viewpoint of suppressing scratches caused by rubbing, matte particles that can relieve the stress generated when rubbed against a hard support (e.g. Al) face are preferable. Moreover, the particles preferably have a high affinity for a hydrophilic polymer as a binding resin of the protective layer, preferably a polyvinyl alcohol commonly used in the protective layer, are well mixed in the film, and are resistant to release from the film surface after forming the film. In the present invention, from such viewpoints, as the particles to be added, silica-containing organic resin particles are employed.

As the organic resin of the silica-containing organic resin particles that can be used in the present invention, a

resin having the above-mentioned physical properties may be used without restrictions, and examples thereof include a polyacrylic acid-based resin, a polyurethane-based resin, a polystyrene-based resin, a polyester-based resin, an epoxy-based resin, a phenolic resin, a melamine resin, and a silicone resin.

Among them, from the viewpoint of affinity with polyvinyl alcohol, which is a preferred hydrophilic polymer, it is preferable to use a polyacrylic acid-based resin, a polyurethane-based resin, a melamine resin, etc.

Furthermore, with regard to a material forming the silica component of the silica-containing organic resin particles, there can be cited a compound having an alkoxysilyl group such as a condensate of an alkoxysiloxane-based compound, in particular, a siloxane-based material used in a sol-gel method, and specifically silica particles such as a silica sol, colloidal silica, or silica nanoparticles are preferable.

The shape of the silica particles is not particularly limited; a spherical shape or a scale shape is preferable, and the average primary particle size of the silica particles is preferably 1 to 500 nm, more preferably 2 to 300 nm, and yet more preferably 5 to 100 nm. It is preferable for the particle size of the silica particles to be in the above-mentioned range since they are localized in the vicinity of the surface of the organic resin particles.

The silica-containing organic resin particles preferably contain silica on the surface or in the vicinity of the surface, and by covering the surface of the organic resin particles with a silica layer the silica-containing organic resin particles can be obtained.

Furthermore, with regard to the constitution of the silica-containing organic resin particles, either one in which silica particles are attached to the surface of the organic resin particles as a solid component or one in which a siloxane-based compound layer is formed on the surface of the organic resin particles by a condensation reaction of an alkoxysiloxane-based compound may be employed.

The silica content is preferably at least 0.1 parts by weight relative to 100 parts by weight of the organic resin particles, more preferably 0.1 to 10 parts by weight, yet more preferably 0.2 to 5 parts by weight, and particularly preferably 0.3 to 3 parts by weight.

Furthermore, as described above, with regard to the silica-containing organic resin particles, it is preferable that silica is present on the surface of the organic resin particles. It is not necessary for silica to be present over the whole of the surface of the organic resin particles, and silica may be present in at least part thereof.

It is preferable to make silica present in at least part of the surface of the organic resin particles since the affinity of the surface of the organic resin particles for a hydrophilic polymer (preferably polyvinyl alcohol) is improved, and even when subject to an external stress, loss of particles is suppressed, and excellent scratch resistance and blocking resistance can be maintained. Because of this, in the present invention, a state in which silica is present in at least part of the surface of the organic resin particles is preferable.

The state in which the surface is covered with silica may be confirmed by examining the morphology by means of scanning electron microscopy (TEM), etc., and the silica coverage may be confirmed by calculating the amount of silica present therein by detecting Si atoms by elemental analysis such as X-ray fluorescence analysis.

Furthermore, in the present invention, it is also possible to confirm that silica (for example, colloidal silica) is present in the vicinity of the surface of the silica-containing organic resin particles by examining the silica-containing organic resin particles as they are using scanning electron microscopy (SEM) or by examining them in the form of a slice using transmission electron microscopy-energy dispersive X-ray analysis (TEM-EDX).

The coverage factor of the surface of the organic resin particles by silica is preferably 0.3 to 1, more preferably 0.4 to 1, and yet more preferably 0.5 to 1.

The coverage factor is given by (1 - open ratio), and the open ratio may be measured by a method described in, for example, paragraphs 0080 to 0083 of JP-A-2004-307837.

A process for producing the silica-containing organic resin particles is not particularly limited, and may be a method in which a monomer component as a starting material for the organic resin particles is made to be present together with silica particles or a silica precursor compound, and silica is introduced at the same time as formation of the organic resin particles, or a method in which, after organic resin particles are formed, silica particles are made to physically adsorb on the surface, and following this immobilization is carried out.

As one example of the production process, first, silica and a starting material resin (more specifically, a monomer that can undergo suspension-polymerization, a prepolymer that can undergo suspension-crosslinking, or a starting material resin such as a resin liquid, forming the above-mentioned organic resin) are added to water containing a suspension stabilizer appropriately selected from a water-soluble polymer such as polyvinyl alcohol, methylcellulose, or polyacrylic acid or an inorganic suspending agent such as calcium phosphate or calcium carbonate, and stirred and mixed to thus prepare a suspension in which the silica and the hydrophobic starting material resin are dispersed. In this process, by adjusting the type of suspension stabilizer, the concentration thereof, stirring rotational speed, etc. an emulsion (suspension) having a target particle diameter can be formed. Subsequently, this suspension is heated to thus initiate a reaction, and the resin starting material is subjected to suspension-polymerization or suspension-crosslinking, thus forming resin particles. During this process, the silica that is co-present is immobilized on the resin particles that are curing by a polymerization or crosslinking reaction, and in particular into the vicinity of the surface of the resin particles

due to the physical properties thereof. Subsequently, this is subjected to solid-liquid separation, suspension stabilizer attached to the particles is removed by washing, and drying is carried out. This enables organic resin particles having a desired particle diameter and having silica immobilized thereon to be obtained.

In this way, a resin having a desired size can be obtained by controlling the suspension-polymerization or suspension-crosslinking conditions, but silica-containing organic resin particles having a desired size can also be obtained by a mesh filtration method after silica-containing organic resin particles are formed without carrying out such strict control.

With regard to the amount of starting material added to a mixture when producing silica-containing organic resin particles by the above-mentioned method, when the total amount of starting material resin and silica is 100 parts by weight, 0.1 to 20 parts by weight of a suspension stabilizer is added to 200 to 800 parts by weight of water as a dispersion medium and sufficiently dissolved or dispersed, to this liquid is added 100 parts by weight of the mixture of starting material resin and silica, stirring is carried out while adjusting the stirring speed so that dispersed particles have a predetermined particle size, after carrying out the particle size adjustment the liquid temperature is increased to 30°C to 90°C, and a reaction may be carried out for 1 to 8 hours.

With regard to the process for producing silica-containing organic resin particles, the above-mentioned method is one example thereof; it is described in detail in, for example, JP-A-2002-327036, JP-A-2002-173410, and JP-A-2004-307837, and all of the silica-containing organic resin particles obtained by the methods described therein may suitably be used in the present invention.

Furthermore, the silica-containing organic resin particles that can be used in the present invention are available as commercial products, and specific examples thereof include, as silica/melamine composite particles, Optbeads 2000M, Optbeads 3500M, Optbeads 6500M, Optbeads 10500M, Optbeads 3500S, and Optbeads 6500S manufactured by Nissan Chemical Industries Ltd. As silica/acrylic composite particles, Art Pearl G-200 transparent, Art Pearl G-400 transparent, Art Pearl G-800 transparent, Art Pearl GR-400 transparent, Art Pearl GR-600 transparent, Art Pearl GR-800 transparent, and Art Pearl J-7P manufactured by Negami Chemical Industrial Co., Ltd. can be cited. As silica/urethane composite particles, Art Pearl C-400 transparent, C-800 transparent, P-800T, U-600T, U-800T, CF-600T, and CF800T manufactured by Negami Chemical Industrial Co., Ltd.; and Dynamic Beads CN5070D and Danplacoat THU manufactured by Dainichiseika Color & Chemicals Mfg. Co., Ltd. can be cited.

In the present invention, the shape of the silica-containing organic resin particles is preferably a truly spherical shape, but may be a flat plate shape or a so-called spindle shape that is elliptical in projection.

The average particle size is preferably 1 to 30 $\mu m\phi$, more preferably 1.5 to 20 $\mu m\phi$, yet more preferably 2 to 15 $\mu m\phi$, and particularly preferably 3 to 10 $\mu m\phi$. In this range, sufficient spacer function and matte performance can be exhibited, it is easy to immobilize onto the surface of the protective layer, and an excellent holding function against external contact stress is given. The average particle size of the silica-containing organic resin particles is preferably larger than the thickness of the protective layer coated.

The amount of silica-containing organic resin particles added to the protective layer is preferably 5 to 1,000 $mg/m^2$, more preferably 7 to 500 $mg/m^2$, and yet more preferably 10 to 200 $mg/m^2$.

Furthermore, with regard to a preferred amount thereof added relative to the total protective layer, it is preferably 0.5 to 95 wt % relative to the total solids content of the protective layer, more preferably 1 to 50 wt %, and particularly preferably 2 to 20 wt %.

(Other organic resin particles)

The protective layer may contain, in addition to the above-mentioned silica-containing organic resin particles, other organic resin particles (not containing silica) as long as the effects of the present invention are not impaired.

Preferred examples of organic resin particles that can be used in combination include particles formed from a synthetic resin such as a poly(meth)acrylic acid ester, polystyrene or a derivative thereof, a polyamide, a polyimide, a polyolefin such as low-density polyethylene, high-density polyethylene, or polypropylene, polyurethane, polyurea, or polyester, and particles formed from a natural polymer such as chitin, chitosan, cellulose, crosslinked starch, or crosslinked cellulose.

Among them, synthetic resin particles have advantages in terms of ease of control of particle size, ease of control of desired surface properties by surface modification, etc.

In such a process for producing organic resin particles, in the case of a relatively hard resin such as PMMA, microparticulating by a grinding method is possible, but a method of synthesizing particles by an emulsification/ suspension-polymerization method is mainly used at present from the viewpoint of ease of control of particle size and precision.

Such processes for producing a microparticulate powder are described in detail in 'Ultrafine Particles and Materials' Ed. by Materials Science Society of Japan, Shokabo Publishing Co., Ltd, 1993, 'Manufacturing & Application of Microspheres & Powders' Edited by Haruma Kawaguchi, CMC Publishing Co., Ltd. 2005, etc.

Organic resin particles that can be used in combination with silica-containing organic resin particles in the protective layer are available as commercial products, and examples thereof include crosslinked acrylic resins MX-300,

MX-500, MX-1000, MX-1500H, MR-2HG, MR-7HG, MR-10HG, MR-3GSN, MR-5GSN, MR-7G, MR-10G, MR-5C, and MR-7GC and styryl resins SX-350H and SX-500H manufactured by Soken Chemical & Engineering Co., Ltd; acrylic resins MBX-5, MBX-8, MBX-12MBX-15, MBX-20, MB20X-5, MB30X-5, MB30X-8, MB30X-20, SBX-6, SBX-8, SBX-12, and SBX-17 manufactured by Sekisui Plastics Co., Ltd.; and polyolefin resins Chemipearl W100, W200, W300, W308, W310, W400, W401, W405, W410, W500, WF640, W700, W800, W900, W950, and WP100 manufactured by Mitsui Chemical Co., Ltd.

With regard to other organic resin particles contained in the protective layer as an optional component, it is preferable that the true specific gravity is in the range of 0.90 to 1.30 and the average particle size is 2.0 to 15 $\mu$m, and it is more preferable that the true specific gravity is in the range of 0.90 to 1.20 and the average particle size is 3.0 to 12 $\mu$m.

The content of these particles in the solids content of the protective layer is preferably 1.0 to 30 wt %, and more preferably 2.0 to 20 wt %. Furthermore, it is preferably in the range of 5.0 to 50 wt % relative to the silica-containing organic resin particles.

In accordance with the combined use of organic resin particles as an optional component, the surface matte effect, blocking prevention effect, and scratch resistance effect are improved, but when the amount added exceeds the above-mentioned preferred range there is a possibility of the occurrence of problems such as degradation in sensitivity and the organic particles coming off from the surface of the protective layer.

The protective layer in the lithographic printing plate precursor may comprise an inorganic lamellar compound. When a mica compound is used in combination, the mica compound may be contained in any one layer of layers forming the protective layer.

For example, when there is only a protective layer of a single layer structure, since this is the outermost layer, the protective layer comprises a mica compound in addition to a hydrophilic polymer and silica-containing organic resin particles; when the protective layer has a layered structure, the outermost layer comprises a hydrophilic polymer and silica-containing organic resin particles, and a mica compound may be contained in the protective layer of the outermost layer or may be contained in another protective layer in the vicinity of the photosensitivity layer (image-forming layer) together with a binder resin, preferably a hydrophilic polymer.

Examples of the mica compound used in the present invention include groups of micas such as natural micas or synthetic micas represented by, for example, the formula $A(B,C)_{2-5}D_4 0_{10}(OH,F,O)_2$ in which A is selected from the group consisting of K, Na, and Ca, B and C are selected from the group consisting of Fe (II), Fe (III), Mn, Al, Mg, and V, and D is Si or Al.

Examples of mica compounds that can be used in the present invention include natural micas such as muscovite, paragonite, phlogopite, biotite, and lepidolite. Examples of synthetic micas include non-swelling micas such as fluorine-phologopite $KMg_3(AlSi_3O_{10})F_2$ or potassium tetrasilicic mica $KMg_{2.5}(Si_4O_{10})F_2$, and swelling micas such as Na tetrasililic mica $NaMg_{2.5}(Si_4O_{10})F_2$, Na or Li taeniolite $(Na,Li)Mg_2Li(Si_4O_{10})F_2$, or montmorillonite-based Na or Li hectorite $(Na,Li)_{1/8}Mg_{2/5}Li_{1/8}(Si_4O_{10})F_2$. Moreover, synthetic smectite is also useful.

In the present invention, among mica compounds, fluorine-based swelling mica is particularly useful. That is, this swelling synthetic mica has a layered structure comprising on the order of 100 to 150 nm (10 to 15 Å) thick unit crystal lattice layers, and metal atom substitution within the lattice is markedly larger than other clay minerals. As a result, the lattice layer is deficient in positive charge, and in order to compensate for this cations such as $Na^+$, $Ca^{2+}$, or $Mg^{2+}$ are adsorbed between layers. These cations present between layers are called exchangeable cations, and are exchanged for various cations. In particular, when the cation between layers is $Li^+$ or $Na^+$, since the ionic radius is small, bonding between lamellar crystal lattices is weak, and it is greatly swollen by water. When shear is applied in this state, it easily cleaves, thus forming a stable sol in water. This tendency is strong for swelling synthetic micas, which are useful in the present invention, and particularly from the viewpoint of the availability of particles having uniform quality a swelling synthetic mica is preferably used.

With regard to the shape of the mica compound used in the present invention, one having a tabular particle shape is preferable; from the viewpoint of adsorption onto organic resin particles, the thinner the better, and with regard to the planar size, the larger the better as long as the smoothness of the coated surface and transmission of actinic radiation are not inhibited. Therefore, the aspect ratio is preferably at least 20, more preferably at least 100, and yet more preferably at least 200. The aspect ratio is the ratio of thickness to major axis of a particle and can be measured, for example, from a projection view of a particle by microphotography. The larger the aspect ratio, the greater the effect obtained.

As for the particle size of the mica compound used in the protective layer in the present invention, the average major axis is preferably 0.3 to 20 $\mu$m, more preferably 0.5 to 10 $\mu$m, and particularly preferably 1 to 5 $\mu$m. The average thickness of the particles is preferably no greater than 0.1 $\mu$m, more preferably no greater than 0.05 $\mu$m, and particularly preferably no greater than 0.01 $\mu$m. Specifically, in the swelling synthetic mica, which is a representative compound, the thickness is on the order of from 1 to 50 nm and the planar size (major axis) is on the order of from 1 to 20 $\mu$m.

The amount of mica compound contained in the protective layer, when the mica compound is added to the same layer as the silica-containing organic resin particles, varies depending on the amount added and type of the silica-containing organic resin particles, but in general the ratio by weight (mica compound:silica-containing organic resin particles) of the mica compound relative to the weight of the silica-containing organic resin particles is preferably in the range of 5:1 to 2:3, and more preferably in the range of 4:1 to 1:1.

When in the above-mentioned range relative to the silica-containing organic resin particles, a balance can be achieved between the effects of improving dispersibility and improving scratch resistance when rubbing against a support reverse face. When a plurality of types of mica compound are used in combination, it is also preferable that the total amount of the mica compounds is in the above-mentioned weight ratio range.

Furthermore, when the protective layer has a layered structure, a mica compound may be used in any one of the plurality of layers, and when this layer is a layer containing no silica-containing organic resin particles, the mica compound is preferably added at a ratio of 5 to 50 parts by weight relative to 100 parts by weight of hydrophilic polymer.

<Backcoat layer>

After applying a surface treatment to the support or forming the intermediate layer above the support, a backcoat layer may as necessary be provided on the reverse face of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as $Si(OCH_3)_4$, $Si(OC_2H_5)_4$, $Si(OC_3H_7)_4$, or $Si(OC_4H_9)_4$ is preferable since starting materials are inexpensive and readily available.

II. Plate making process

The process for making a lithographic printing plate of the present invention, that is, a plate making process, is now explained.

The process for making a lithographic printing plate of the present invention comprises a step of imagewise exposing a lithographic printing plate precursor having an image-forming layer (photosensitive layer) above a hydrophilic support, preferably a lithographic printing plate precursor further having a protective layer above an image-forming layer, and then a processing step of carrying out processing using a processing solution comprising carbonate ion, bicarbonate ion, and a water-soluble polymer compound as defined in claim 1.

By processing using the above-mentioned aqueous solution after imagewise exposing the lithographic printing plate precursor of the present invention, processing and gumming of an image-forming layer can be carried out at the same time by a single bath.

Furthermore, in the case of a lithographic printing plate precursor provided with a protective layer, removal of this protective layer, processing of an image-forming layer, and gumming of an obtained image can be carried out at the same time by a single bath.

The processing of the image-forming layer referred to here means forming an image according to an exposed area by removing a non-exposed area of the image-forming layer using the above-mentioned processing solution.

In the present invention, in a plate making process in which a lithographic printing plate is produced from a lithographic printing plate precursor, the entire surface of the lithographic printing plate precursor may be heated as necessary before exposure, during exposure, or between exposure and development. This heating promotes an image formation reaction in an image formation layer, thus giving advantages such as improvement of sensitivity, improvement of plate life, and stabilization of sensitivity. Furthermore, for the purpose of improving image strength and plate life, post-heating an image obtained by development or exposing the whole surface is also effective. Heating prior to development is usually preferably carried out under mild conditions of no greater than 150°C. Heating after development utilizes more severe conditions. A temperature range of 200°C to 500°C is preferable.

<Imagewise exposure step>

The imagewise exposure step of imagewise exposing a lithographic printing plate precursor can be roughly divided into two. One thereof is imagewise exposure using a transparent original image having a line image, a halftone image, etc., and the other is imagewise exposure by scanning a laser light source based on digital data.

With regard to lithographic printing plate precursor exposure equipment of a scanning exposure method, as an exposure mechanism there are a drum inner face system, a drum outer face system, and a flatbed system, and as a light source among the above-mentioned light sources a continuous-wave type may preferably be used. In practice, in terms of the relationship between the sensitivity of a lithographic printing plate precursor (hereinafter, also called a 'precursor') and plate-making time, the exposure equipment below is particularly preferable.

Single beam to triple beam exposure equipment of a drum inner face system employing one or more gas or

solid-state laser light sources so as to provide a semiconductor laser having a total output of 20 mW or greater.

Multi-beam (1 to 10 beam) exposure equipment of a flat bed system employing one or more semiconductor lasers or gas or solid-state lasers so as to give a total output of 20 mW or greater.

Multi-beam (1 to 9 beam) exposure equipment of a drum outer face system employing one or more semiconductor lasers or gas or solid-state lasers so as to give a total output of 20 mW or greater.

Multi-beam (10 beam or greater) exposure equipment of a drum outer face system employing one or more semiconductor lasers or solid-state lasers so as to give a total output of 20 mW or greater.

In the laser direct writing type lithographic printing plate precursor described above, an equation (eq 1) between precursor sensitivity X (J/cm$^2$), precursor exposure area S (cm$^2$), power q (W) per laser light source, number n of lasers, and total exposure time t (s) generally holds.

$$X \cdot S = n \cdot q \cdot t \text{ (eq 1)}$$

i) In the case of a drum inner face (single beam) system:
An equation (eq 2) between laser rotational speed f (radian/s), precursor subscanning length Lx (cm), resolution Z (dot/cm), and total exposure time t (s) generally holds.

$$f \cdot Z \cdot t = Lx \text{ (eq 2)}$$

ii) In the case of a drum outer face (multi-beam) system:
An equation (eq 3) between drum rotational speed F (radian/s), precursor subscanning length Lx (cm), resolution Z (dot/cm), total exposure time t (s), and number of beams (n) generally holds.

$$F \cdot Z \cdot n \cdot t = Lx \text{ (eq 3)}$$

iii) In the case of a flat head (multi-beam) system:
An equation (eq 4) between polygon mirror rotational speed H (radian/s), precursor subscanning length Lx (cm), resolution Z (dot/cm), total exposure time t (s), and number of beams (n) generally holds.

$$H \cdot Z \cdot n \cdot t = Lx \text{ (eq 4)}$$

By assigning, to the equations above, a resolution (2,560 dpi), plate size (A1/B1, subscanning length 42 inch), and exposure conditions of on the order of 20 sheets/hour required for an actual printing plate precursor, and photosensitive properties (photosensitive wavelength, sensitivity: about 0.1 mJ/cm$^2$) of the lithographic printing plate precursor related to the present invention, it can be understood that in the lithographic printing plate precursor related to the present invention a combination with a multi-beam exposure system employing a laser having a total output of 20 mW or greater is particularly preferable. Furthermore, by taking into consideration as well the operability, cost, etc., a combination with drum outer face system semiconductor laser multi-beam (10 beam or greater) exposure equipment is most preferable.

The infrared laser used in the present invention is not particularly limited, but a solid-state laser and a semiconductor laser that radiate IR rays at a wavelength of 760 to 1,200 nm can be cited suitably. The output of the IR laser is preferably at least 100 mW. Furthermore, in order to reduce exposure time, a multibeam laser device is preferably used. The exposure time per pixel is preferably within 20 μsec. Furthermore, the amount of irradiation energy is preferably 10 to 300 mJ/cm$^2$. As a light source, an AlGaInN semiconductor laser (commercial InGaN-based semiconductor laser, 5 to 30 mW) is suitable in terms of wavelength characteristics and cost.

Furthermore, using, as the photosensitivity layer component of the photosensitive lithographic printing plate precursor used in the present invention, one having high water solubility can make it soluble in neutral water or weakly aqueous alkali, and a photosensitive lithographic printing plate precursor having such a constitution can be used in a system in which, after it is loaded on a printing machine, on-machine exposure - development is carried out.

<Processing solution>

The processing solution used in the process for making a lithographic printing plate used in the present invention is an aqueous solution comprising carbonate ion, bicarbonate ion, and a water-soluble polymer compound as defined

in claim 1. Due to carbonate ion and bicarbonate ion being present, a pH buffer action is exhibited, and even if the processing solution is used for a long period of time, variation in pH can be suppressed, and degradation of developability, formation of development residue, etc. due to variation in pH can be suppressed. With regard to carbonate ion and bicarbonate ion, a carbonate salt and a bicarbonate salt may be added to the developer, or carbonate ion and bicarbonate ion may be formed by adjusting the pH after a carbonate salt or a bicarbonate salt is added. As a carbonate salt and a bicarbonate salt an alkali metal salt is used. As the alkali metal, lithium, sodium, and potassium can be cited, and sodium is particularly preferable. They may be used singly or in a combination of two or more types.

The pH is in the range of 8.5 to 10.8, preferably 9.0 to 10.5, and more preferably 9.5 to 10.3. The pH is in this range since developability of a non-image area does not degrade and the processing capacity is not affected by carbon dioxide in the air.

The processing solution used in the process for making a lithographic printing plate of the present invention is preferably an aqueous solution comprising an alkali metal carbonate, an alkali metal bicarbonate salt, and a water-soluble resin and having a pH of 8.5 to 10.5. As the alkali metal, lithium, sodium, and potassium can be cited, and sodium is particularly preferable. They may be used singly or in a combination of two or more types.

The total amount of the carbonate and bicarbonate salts is 1 to 20 wt % relative to the weight of the processing solution, more preferably 1.2 to 10 wt %, and most preferably 1.4 to 4 wt %. When this concentration is at least 1 wt % the developability and processing capacity do not deteriorate, and when it is no greater than 20 wt % there is hardly any formation of a precipitate or crystals, there is hardly any gelling when carrying out neutralization when discarding solution, and waste solution treatment can be carried out without problems.

Furthermore, for the purpose of finely adjusting the alkali concentration or assisting dissolution of the photosensitivity layer, another alkali agent, for example, an organic alkali agent, may be added supplementarily. Examples of the organic alkali agent include monomethylamine, dimethylamine, trimethylamine, monoethylamine, diethylamine, triethylamine, monoisopropylamine, diisopropylamine, triisopropylamine, *n*-butylamine, monoethanolamine, diethanolamine, triethanolamine, monoisopropanolamine, diisopropanolamine, ethyleneimine, ethylenediamine, pyridine, and tetramethylammonium hydroxide. These alkali agents may be used singly or in a combination of two or more types.

The 'water-soluble polymer compound' means a compound having a weight-average molecular weight of at least 1,000, and preferably at least 10,000, and having a solubility in water of at least 2 g in 100 g of water, and preferably at least 5 g.

The water-soluble polymer compound used in the present invention includes, for example, soybean polysaccharide, modified starch, gum Arabic, dextrin, a cellulose derivative (for example, carboxymethylcellulose, carboxyethylcellulose, or methylcellulose) or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer.

As the soybean polysaccharide, those conventionally known may be used. For example, as a commercial product, the product name Soyafibe (Fuji Oil Co., Ltd.) is available, and various product grades can be used. The soybean polysaccharide preferably used has a viscosity in the range of 10 to 100 mPa·sec in a 10 wt % aqueous solution thereof.

As the modified starch, one represented by Formula (III) below is preferable. As the starch represented by Formula (III), any starch from corn, potato, tapioca, rice, wheat, etc. may be used. Modification of these starches may be carried out by, for example, a method in which they are decomposed with, for example, an acid or an enzyme to the extent that the number of glucose residues per molecule is from 5 to 30 and then oxypropylene is added thereto in an alkali.

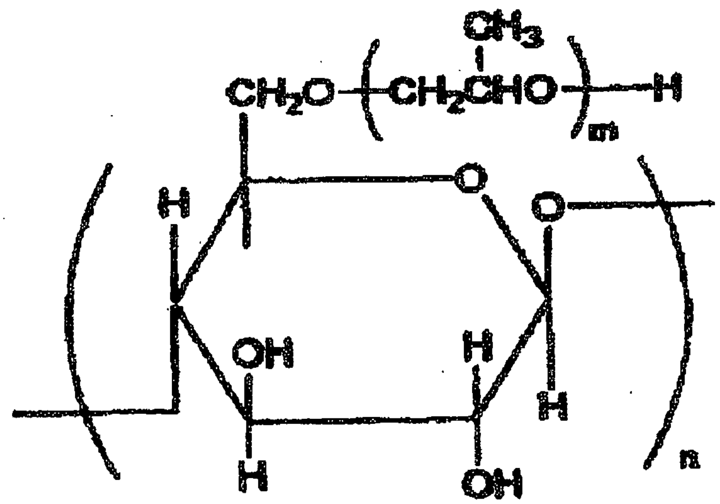

(III)

(In the formula, the degree of etherification (degree of substitution) is in the range of 0.05 to 1.2 per glucose unit, n denotes an integer of 3 to 30, and m denotes an integer of 1 to 3.)

Among the water-soluble polymer compounds, soybean polysaccharide, modified starch, gum Arabic, dextrin, carboxymethylcellulose, polyvinyl alcohol, etc. are particularly preferable.

The water-soluble polymer compound may be used in a combination of two or more types. The content of the water-soluble polymer compound in the processing solution is preferably 0.1 to 20 wt %, and more preferably 0.5 to 10 wt %.

The processing solution that can be used in the present invention may comprise a surfactant (anionic, nonionic, cationic, etc.).

Examples of the anionic surfactant used in the present invention include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkylphenoxypolyoxyethylene propylsulfonic acid salt, a polyoxyethylene alkylsulfophenyl ether salt, sodium N-methyl-*N*-oleyltaurine, a disodium *N*-alkylsulfosuccinic acid monoamide, a petroleum sulfonic acid salt, sulfated castor oil, sulfated tallow oil, a sulfate ester of a fatty acid alkyl ester, an alkylsulfate ester, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkyl phosphate ester, a polyoxyethylene alkyl ether phosphate ester, a polyoxyethylene alkyl phenyl ether phosphate ester, a partially saponified styrene-maleic anhydride copolymer, a partially saponified olefin-maleic anhydride copolymer, and a naphthalenesulfonic acid salt formalin condensate. Among them, a dialkylsulfosuccinic acid salt, an alkylsulfate ester, and an alkylnaphthalenesulfonic acid salt are particularly preferably used.

The cationic surfactant used in the present invention is not particularly limited, and a conventionally known cationic surfactant may be used. Examples thereof include an alkylamine salt, a quaternary ammonium salt, a polyoxyethylene alkylamine salt, and a polyethylene polyamine derivative.

Examples of the nonionic surfactant used in the present invention include a polyethylene glycol type higher alcohol ethylene oxide adduct, an alkylphenol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide.

These nonionic surfactants may be used singly or as a mixture of two or more types. In the present invention, a sorbitol and/or sorbitan fatty acid ester ethylene oxide adduct, a polypropylene glycol ethylene oxide adduct, a dimethylsiloxane-ethylene oxide block copolymer, a dimethylsiloxane-(propylene oxide-ethylene oxide) block copolymer, and a polyhydric alcohol fatty acid ester are preferable.

Furthermore, from the viewpoint of stable solubility in water and turbidity, for the nonionic surfactant used in the processing solution that can be used in the present invention, the HLB (Hydrophile-Lipophile Balance) value is preferably at least 6, and more preferably at least 8. Furthermore, the proportion of the nonionic surfactant contained in the processing solution is preferably 0.01 to 10 wt %, and more preferably 0.01 to 5 wt %. It is also possible to similarly use acetylene glycol-based and acetylene alcohol-based oxyethylene adducts, fluorine-based, silicone-based etc. surfactants.

These surfactants may be used singly or in combination. The content of the surfactant in the developer is desirably in the range of 0.1 to 20 wt % expressed as effective component.

The processing solution that can be used in the present invention may contain, in addition to the above-mentioned components, a wetting agent, a preservative, a chelating compound, an antifoaming agent, an organic acid, an organic solvent, an inorganic acid, an inorganic salt, etc.

As the wetting agent, ethylene glycol, propylene glycol, triethylene glycol, butylene glycol, hexylene glycol, diethylene glycol, dipropylene glycol, glycerol, trimethylolpropane, diglycerol, etc. are suitably used. These wetting agents may be used singly or in a combination of two or more types. The wetting agent is preferably used in an amount of 0.1 to 5 wt % based on the total weight of the processing solution.

As the preservative, for example, phenol or a derivative thereof, formalin, an imidazole derivative, sodium dehydroacetate, a 4-isothiazolin-3-one derivative, benzisothiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative, or a nitrobromoalcohol such as 2-bromo-2-nitropropane-1,3-diol, 1,1-dibromo-1-nitro-2-ethanol, or 1,1-dibromo-1-nitro-2-propanol is preferably used.

The amount of preservative added is an amount that exhibits stable efficacy toward bacteria, molds, yeasts, etc., and depends on the type of bacterium, mold, or yeast, but is preferably in the range of 0.01 to 4 wt % relative to the processing solution when used; it is preferable to use in combination at least two types of preservatives so as to exhibit efficacy toward various types of molds and bacteria.

As the chelating compound, for example, ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid, for example, 1-hydroxyethane-1,1-diphosphonic acid, the potassium salt thereof, or the sodium salt thereof; or aminotri(methylenephosphonic acid), the potassium salt thereof, or the sodium salt thereof; or a phosphonoalkanetricarboxylic acid can be cited. An organic amine salt is also effective instead of the sodium salt or potassium salt of the chelating compounds.

As these chelating agents, those that are present stably in the processing solution composition and do not inhibit printing properties are selected. The amount thereof added is suitably 0.001 to 1.0 wt % relative to the processing solution when used.

As the antifoaming agent, a normal silicone-based self emulsifying type, emulsifying type, nonionic, etc. compound having an HLB of no greater than 5 may be used. Silicone antifoaming agents are preferable. Among them, any of an emulsifying dispersion type and a solubilizing type may be used.

The content of the antifoaming agent is suitably in the range of 0.001 to 1.0 wt % relative to the processing solution when used.

As the organic acid, for example, citric acid, acetic acid, oxalic acid, malonic acid, salicylic acid, caprylic acid, tartaric acid, malic acid, lactic acid, levulinic acid, *p*-toluenesulfonic acid, xylenesulfonic acid, phytic acid, and an organic phosphonic acid can be cited. The organic acid may also be used in the form of an alkali metal salt or an ammonium salt. The content of the organic acid is preferably 0.01 to 0.5 wt % based on the total weight of the processing solution.

Examples of the organic solvent that can be contained include an aliphatic hydrocarbon (e.g. hexane, heptane, Isopar E, H, G (Esso Chemical Co., Ltd.), gasoline, or kerosene), an aromatic hydrocarbon (e.g. toluene or xylene), a halogenated hydrocarbon (e.g. methylene dichloride, ethylene dichloride, triclene, or monochlorobenzene), and a polar solvent.

Examples of the polar solvent include an alcohol (e.g. methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenylcarbinol, *n*-amyl alcohol, or methylamyl alcohol), a ketone (e.g. acetone, methyl ethyl ketone, ethyl butyl ketone, methyl isobutyl ketone, or cyclohexanone), an ester (e.g. ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, or butyl levulinate), and others (e.g. triethyl phosphate, tricresyl phosphate, *N*-phenylethanolamine, or *N*-phenyldiethanolamine).

Furthermore, when the organic solvent is insoluble in water, it may be employed by being solubilized in water using a surfactant, etc., and in the case where the developer contains an organic solvent, the concentration of the solvent is preferably less than 40 wt % from the viewpoint of safety and flammability.

As the inorganic acid and inorganic salt, for example, phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate can be cited. The content of the inorganic salt is preferably 0.01 to 0.5 wt % based on to the total weight of the processing solution.

A development step in the process for making a lithographic printing plate of the present invention is explained in detail.

In the usual development process, the protective layer is removed by a water washing pre-step, development is then carried out using an alkaline developer, the alkali is removed by a water washing post-step, a gumming treatment is carried out by a gumming step, and drying is carried out by a drying step.

In the present invention, since a water-soluble polymer compound is contained in the processing solution, development and gumming can be carried out at the same time using a single solution. Therefore, a water washing post-step is not particularly required, and it is preferable that, after development and gumming are carried out using a single solution, a drying step is carried out.

Furthermore, it is preferable that a water washing pre-step is not carried out, and removal of the protective layer is carried out at the same time as development and gumming using a single solution. Moreover, it is preferable that, subsequent to development and gumming, surplus developer is removed using a squeegee roller, and drying is then carried out.

Development processing of a lithographic printing plate precursor in the present invention may be carried out in accordance with a standard method, preferably at 0°C to 60°C, and more preferably at 15°C to 40°C, such as, for

example, a method in which an exposed lithographic printing plate precursor is immersed in a developer and rubbed by a brush. Furthermore, when processing is carried out using an automatic processor, since due to the increase in the amount processed the developer becomes exhausted, it is preferable to recover the processing capacity by use of a replenisher or fresh developer.

A hydrophilic support in the present invention can, as explained in Example 1 below, be subjected to a mechanical surface roughening treatment. This mechanical surface roughening treatment may employ equipment as shown in FIG. 1.

As shown in FIG. 1, roller-shaped brushes 2 and 4 and two each of support rollers 5, 6 and 7, 8 supporting them respectively are disposed so that an aluminum plate 1 is interposed therebetween, and the two support rollers 5, 6 and 7, 8 are arranged so that the shortest distance between the external faces is smaller than the outer diameter of the roller-shaped brushes 2 and 4. The aluminum plate 1 is fed at a constant speed in a state in which the aluminum plate is pressurized by the roller-shaped brushes 2 and 4 and pushed between the two support rollers 5, 6 and 7, 8, and by rotating the roller-shaped brushes while supplying an abrasive slurry liquid 3 onto the aluminum plate the surface of the aluminum plate 1 is brush-abraded. The gap (pitch) between the two support rollers 5, 6 or 7, 8 is preferably 350 mm to 550 mm, and particularly preferably 400 mm to 500 mm.

A more detailed explanation is given in paragraphs 0078 to 0097 of JP-A-2008-201038.

A lithographic printing plate precursor may be subjected to development processing using a processor as illustrated in FIG. 2.

Here, 'development processing' means combined processing which includes, in addition to development of an image-forming layer, one or more processes selected from the group consisting of removal of a protective layer, gumming, and drying.

The processing solution used is illustrated in Examples. The processor is an automatic processor having two rotating brush rollers 11. As the rotating brush roller 11, for the first rotating brush roller 11 a brush roller having an outer diameter of 90 mm and having implanted therein fibers of polybutylene terephthalate (bristle diameter: 200 μm, bristle length: 17 mm) is used, and rotated at 200 rotations per minute in the same direction as the transport direction (peripheral speed at brush tip: 0.94 m/sec). Furthermore, for the second rotating brush roller 11, a brush roller having an outer diameter of 60 mm and having implanted therein fibers of polybutylene terephthalate (bristle diameter: 200 μm, bristle length: 17 mm) is used, and rotated at 200 rotations per minute in the direction opposite to the transport direction (peripheral speed at brush tip: 0.63 m/sec). With regard to transport of exposed lithographic printing plate precursor 30, the lithographic printing plate precursor 30 is transported on transport guide plates 14 provided en route from a plate supply table 18 to a plate discharge table 19 between three pairs of transport rollers 13 in the transport direction shown in the figure so as to pass between the rotating brush rollers 11 and opposing backing rollers 12.

A processing solution stored in a processing solution tank 20 is supplied by means of a circulation pump 21 to four spray pipes 15 via a pipeline 16 through a filter 17, and is supplied to the plate face by showering from the spray pipes 15. The processing solution can be recycled.

A lithographic printing plate discharged from the processor is dried by a dryer 22 without being washed with water.

The direction of rotation of the rotating brush roller used in the present invention may be the same direction or the opposite direction with respect to the transport direction of the lithographic printing plate precursor, but when two or more rotating brush rollers are used in a processor as shown in FIG. 1, it is preferable that they rotate in the opposite direction. The image-forming layer in the non-image area can be more reliably removed by such an arrangement. Furthermore, swinging the rotating brush roller in the rotational axis direction of the brush roller is also effective for development.

## Examples

The present invention is explained below by way of Examples, but the present invention should not be construed as being limited thereto. In the Examples 'parts' means 'parts by weight' unless otherwise specified.

Furthermore, the figures on the bottom right of the parentheses showing the monomer units in the polymers shown in the Examples denote molar ratio unless otherwise specified.

(Preparation of aqueous dispersion of silica-containing organic resin particles)

(Preparation of Art Pearl J-7P aqueous dispersion)

In order to improve dispersion stability, 3.0 parts by weight of a nonionic surfactant (Emalex 710, Nihon Emulsion Co., Ltd.) and 77.0 parts by weight of a mica dispersion (MEB-3L, Co-op Chemical Co., Ltd., solids content 3.4%) were added and mixed. 20 parts by weight of silica composite crosslinked acrylic resin particles (Art Pearl J-7P, Negami Chemical Industrial Co., Ltd., average particle size 6.6 μm) was added to this aqueous solution, and dispersion was carried out using a Ace homogenizer manufactured by Nissei Corporation at 10,000 rpm for 15 minutes, thus giving Art

Pearl J-7P aqueous dispersion 1.

Art Pearl J-7P was subjected to TEM examination and X ray fluorescence analysis, and it was confirmed that silica was present on the surface. This aqueous dispersion was used as a coating solution for a protective layer that is described later.

<Preparation of lithographic printing plate precursor A>

(Preparation of support 1)

The surface treatment described below was carried out using a JIS A 1050 aluminum plate having a thickness of 0.30 mm and a width of 1030 mm.

(Surface treatment)

As the surface treatment, the various treatments (a) to (f) below were carried out successively. After each treatment and after washing with water liquid was removed by means of a nip roller.

(a) The aluminum plate was subjected to an etching treatment with a sodium hydroxide concentration of 26 wt % and an aluminum ion concentration of 6.5 wt % at 70°C so as to dissolve 5 g/$m^2$ of the aluminum plate. Subsequently, washing with water was carried out.
(b) A desmutting treatment was carried out by means of a spray using an aqueous solution having a nitric acid concentration of 1 wt % and a temperature of 30°C (containing 0.5 wt % of aluminum ion), and following this washing with water was carried out.
(c) An electrochemical surface roughening treatment was carried out consecutively using a 60 Hz AC voltage. An electrolytic liquid used here was a 1 wt % aqueous solution of nitric acid (containing 0.5 wt % of aluminum ion and 0.007 wt % of ammonium ion) at a temperature of 30°C. The electrochemical surface roughening treatment was carried out using as an alternating current source a trapezoidal rectangular wave alternating current having a duty ratio of 1:1 and a time TP from zero to peak current value of 2 msec, with a carbon electrode as the counter electrode. Ferrite was used as an auxiliary anode. The current density was 25 A/$dm^2$ as a peak current value, and the quantity of electricity as the total quantity of electricity when the aluminum plate was the anode was 250 C/$cm^2$. 5% of the current flowing from the power source was diverted to the auxiliary anode. Subsequently, washing with water was carried out.
(d) The aluminum plate was subjected to an etching treatment at 35°C by means of a spray at a sodium hydroxide concentration of 26 wt % and an aluminum ion concentration of 6.5 wt % so as to dissolve 0.2 g/$m^2$ of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out.
(e) A desmutting treatment was carried out by means of a spray using an aqueous solution having a sulfuric acid concentration of 25 wt % and a temperature of 60°C (containing 0.5 wt % of aluminum ion), and following this washing with water was carried out by means of a spray.
(f) An anodizing treatment was carried out at a sulfuric acid concentration of 170 g/L (containing 0.5 wt % of aluminum ion), a temperature of 33°C, and an electric current density of 5 (A/$dm^2$) for 50 sec. Following this, washing with water was carried out. The weight of the anodized coating at this time was 2.7 g/$m^2$.

The surface roughness Ra (center line average roughness) of the aluminum support thus obtained was 0.27 μm (measurement equipment; Surfcom, manufactured by Tokyo Seimitsu Co., Ltd., probe tip diameter 2 micro meter).

Subsequently, intermediate layer coating solution (1) below was applied at a dry coat weight of 10 mg/$m^2$ onto the aluminum support that had been subjected to the above-mentioned surface treatment, and dried.

<u>Intermediate laver coating solution (1)</u>

| | |
|---|---|
| Compound (1) below (weight-average molecular weight: 50,000) | 0.017 parts by weight |
| Methanol | 9.00 parts by weight |
| Water | 1.00 parts by weight |

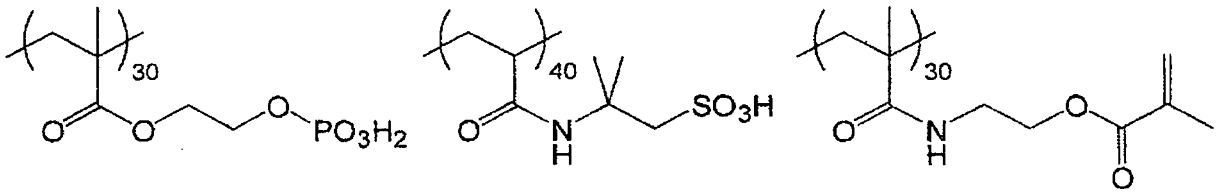

Compound (1)

(Preparation of lithographic printing plate precursor)

After an image-forming layer (photosensitive layer) coating solution was applied by bar coating onto the support provided with the above intermediate layer it was dried at 100°C for 75 sec in an oven, thus forming an image-forming layer (photosensitive layer) at a dry coat weight of 1.0 g/$m^2$. The image-forming layer was coated using a bar with protective layer coating solution (1) having the composition below at a dry coat weight of 0.5 g/$m^2$, and then dried in an oven at 100°C for 90 sec, thus giving lithographic printing plate precursor A.

Image-forming layer (photosensitive layer) coating solution (1) was obtained by mixing and stirring the whole amounts of photosensitive solution (1) and microcapsule liquid (1) below immediately before coating.

(Photosensitive solution (1))

| | |
|---|---|
| Binder polymer (1) below (weight-average molecular weight: 80,000) | 0.162 parts by weight |
| Polymerization initiator (1) below | 0.100 parts by weight |
| Infrared-absorbing agent (1) below | 0.020 parts by weight |
| Ethylenically unsaturated compound Aronix M315 (Toagosei Co., Ltd.) (triacrylate of adduct of isocyanuric acid with 3 moles of ethylene oxide) | 0.385 parts by weight |
| Fluorine-based surfactant (1) below (weight-average molecular weight: 11,000) | 0.044 parts by weight |
| Crystal Violet (Hodogaya Chemical Co., Ltd.) | 0.050 parts by weight |
| Methyl ethyl ketone | 1.091 parts by weight |
| 1-Methoxy-2-propanol | 8.609 parts by weight |

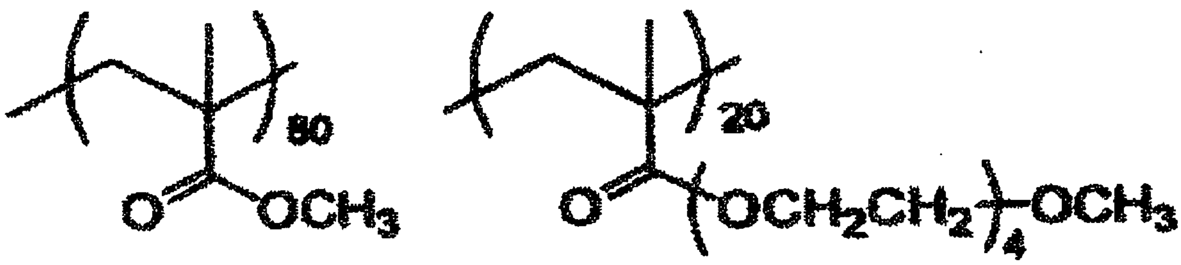

Binder Polymer (1)

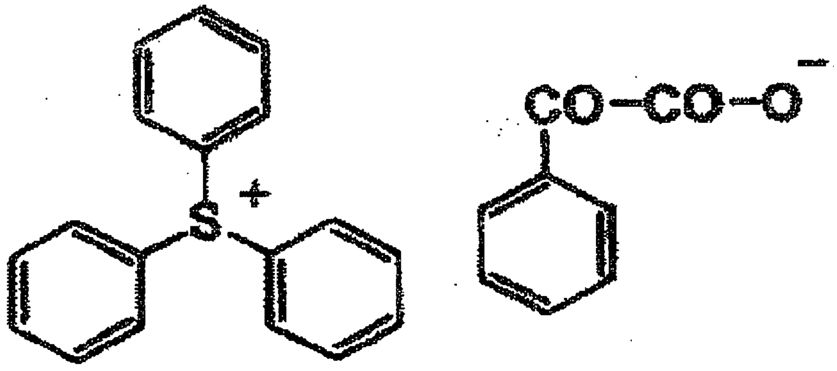

Polymerization initiator (1)

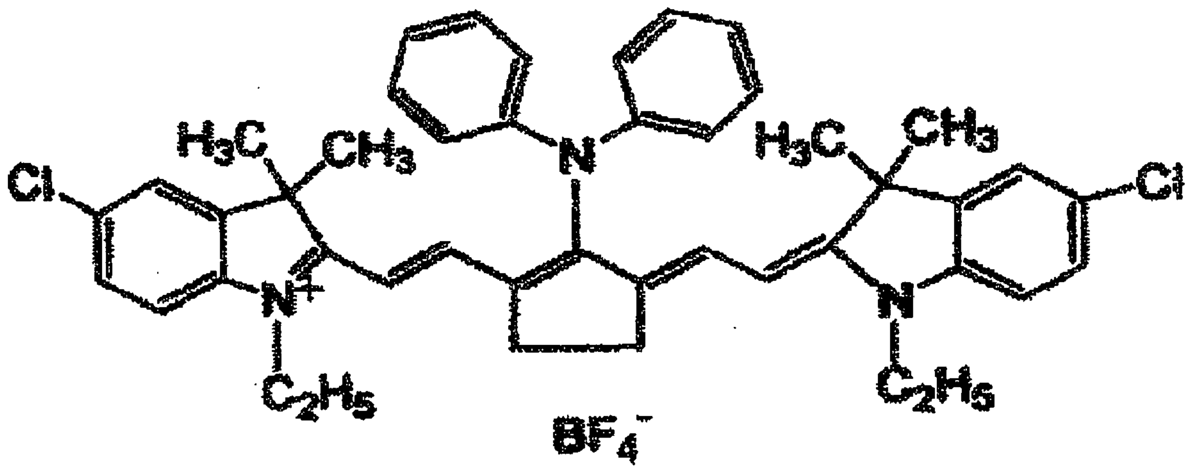

Infrared-absorbing agent (1)

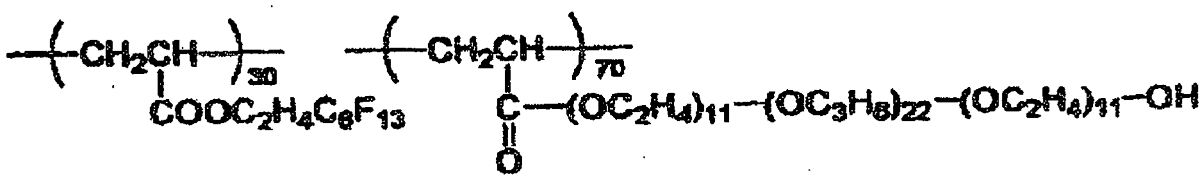

Fluorine-based surfactant (1)

(Microcapsule Liquid (1))

| | |
|---|---|
| Microcapsules (1) synthesized as below | 2.640 parts by weight |
| Water | 2.425 parts by weight |

(Synthesis of Microcapsules (1))

As an oil phase component, 10 parts by weight of an adduct of trimethylolpropane and xylene diisocyanate (Takenate D-110N, 75% ethyl acetate solution, Mitsui Takeda Chemicals, Inc.), 6.00 parts by weight of Aronix M-215 (Toagosei Co., Ltd.; bis(acryloyloxyethyl) isocyanurate toluene mixture), and 0.12 parts by weight of Pionin A-41C (Takemoto Oil & Fat Co., Ltd.) were dissolved in 16.67 parts by weight of ethyl acetate. As an aqueous phase component,

37.5 parts by weight of a 4 wt % aqueous solution of PVA-205 was prepared. The oil phase component and the aqueous phase component were mixed and emulsified using a homogenizer at 12,000 rpm for 10 min. The resulting emulsion was added to 25 parts by weight of distilled water and the mixture was stirred at room temperature for 30 min and then stirred at 40°C for 2 hours. The microcapsule liquid thus obtained was diluted with distilled water so as to have a solids content concentration of 15 wt %. The average particle diameter was 0.2 μm.

(Protective layer coating solution (1))

| | |
|---|---|
| Polyvinyl alcohol (6% aqueous solution) | 2.24 parts by weight |
| (CKS50, The Nippon Synthetic Chemical Industry Co., Ltd., degree of saponification 98.5%, degree of polymerization 300) | |
| Surfactant | 2.15 parts by weight |
| (Emalex 710, Nihon Emulsion Co., Ltd., 1% aqueous solution) | |
| Mica dispersion (3.4% aqueous dispersion) | 3.75 parts by weight |
| (Scale-like synthetic mica, Co-op Chemical Co., Ltd. (Somasif MEB3L)) | |
| Art Pearl J-7P aqueous dispersion 1 above | 0.20 parts by weight |
| Distilled water | 10.60 parts by weight |

<Preparation of lithographic printing plate precursor B>

(Preparation of support 2)

(Surface treatment)

With regard to the surface treatment, treatments (a) to (k) below were carried out successively. After each treatment and after washing with water liquid was removed by means of a nip roller.

(a) Mechanical roughening treatment

Using the equipment shown in FIG. 1, the surface of an aluminum plate was subjected to a mechanical roughening treatment by means of a rotating roller-shaped nylon brush while supplying a suspension of an abrasive (pumice) having a specific gravity of 1.12 in water as an abrasive slurry to the surface of the aluminum plate. In FIG. 1, 1 denotes an aluminum plate, 2 and 4 denote roller-shaped brushes, 3 denotes an abrasive slurry, and 5, 6, 7, and 8 denote support rollers. The abrasive had an average particle size of 30 μm and a maximum particle size of 100 μm. The material of the nylon brush was nylon 6,10, the bristle length was 45 mm, and the diameter of the bristles was 0.3 mm. The nylon brush was formed by making holes in a stainless steel tube having a diameter of 300 mm and densely implanting the bristles. Three rotating brushes were used. The distance of two support rollers (ϕ 200 mm) below the brush was 300 mm. The brush rollers were pressed against the aluminum plate so that the load on a drive motor for rotating the brushes increased by 7 kW from the load before pressing the brush rollers. The direction of rotation of the brushes was the same as the direction in which the aluminum plate moved. The rotational speed of the brushes was 200 rpm.

(b) Alkali etching treatment

The aluminum plate obtained above was subjected to an etching treatment by spraying an aqueous solution with a sodium hydroxide concentration of 2.6 wt % and an aluminum ion concentration of 6.5 wt % at 70°C so as to dissolve 10 $g/m^2$ of the aluminum plate. Subsequently, washing with water was carried out by means of a spray.

(c) Desmutting treatment

A desmutting treatment was carried out by means of a spray using an aqueous solution having a nitric acid concentration of 1 wt % and a temperature of 30°C (containing 0.5 wt % of aluminum ion), and following this washing with water was carried out by means of a spray. The aqueous solution of nitric acid used in the desmutting treatment employed liquid waste from the step involving carrying out the electrochemical roughening treatment using alternating current in an aqueous solution of nitric acid.

(d) Electrochemical surface roughening treatment

An electrochemical surface roughening treatment was carried out consecutively using a 60 Hz AC voltage. An electrolytic liquid used here was a 10.5 g/L aqueous solution of nitric acid (containing 5 g/L of aluminum ion and 0.007 wt % of ammonium ion) at a liquid temperature of 50°C. The electrochemical surface roughening treatment was carried out using a trapezoidal rectangular wave alternating current having an alternating current waveform shown in FIG. 2 with a duty ratio of 1:1 and a time TP from zero to peak current value of 0.8 msec, with a carbon electrode as the counter electrode. Ferrite was used as an auxiliary anode.

The current density was 30 A/$dm^2$ as a peak current value, and the quantity of electricity as the total quantity of electricity when the aluminum plate was the anode was 220 C/$dm^2$. 5% of the current flowing from the power source was diverted to the auxiliary anode. Following this, washing with water was carried out by means of a spray.

(e) Alkali etching treatment

The aluminum plate was subjected to an etching treatment at 32°C by means of a spray with an aqueous solution having a sodium hydroxide concentration of 26 wt % and an aluminum ion concentration of 6.5 wt % so as to dissolve 0.50 g/$m^2$ of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray.

(f) Desmutting treatment

A desmutting treatment was carried out by means of a spray using an aqueous solution having a nitric acid concentration of 15 wt % and a temperature of 30°C (containing 4.5 wt % of aluminum ion), and following this washing with water was carried out by means of a spray. The aqueous solution of nitric acid used in the desmutting treatment employed liquid waste from the step involving carrying out the electrochemical roughening treatment using alternating current in an aqueous solution of nitric acid.

(g) Electrochemical surface roughening treatment

An electrochemical surface roughening treatment was carried out consecutively using a 60 Hz AC voltage. An electrolytic liquid used here was a 5.0 g/L aqueous solution of hydrochloric acid (containing 5 g/L of aluminum ion) at a liquid temperature of 35°C. The electrochemical surface roughening treatment was carried out using a trapezoidal rectangular wave alternating current having an alternating current waveform with a duty ratio of 1:1 and a time TP from zero to peak current value of 0.8 msec, with a carbon electrode as the counter electrode. Ferrite was used as an auxiliary anode.

The current density was 25 A/$dm^2$ as a peak current value, and the quantity of electricity as the total quantity of electricity when the aluminum plate was the anode was 50 C/$dm^2$. Following this, washing with water was carried out by means of a spray.

(h) Alkali etching treatment

The aluminum plate was subjected to an etching treatment at 32°C by means of a spray with an aqueous solution having a sodium hydroxide concentration of 26 wt % and an aluminum ion concentration of 6.5 wt % so as to dissolve 0.10 g/$m^2$ of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray.

(i) Desmutting treatment

A desmutting treatment was carried out by means of a spray using an aqueous solution having a sulfuric acid concentration of 25 wt % and a temperature of 60°C (containing 0.5 wt % of aluminum ion), and following this washing with water was carried out by means of a spray.

(j) Anodizing treatment

An anodizing treatment was carried out using an anodizing system (first and second electrolysis section lengths 6 m each, first and second power supply section lengths 3 m each, first and second power supply electrode section lengths 2.4 m each). As electrolytic liquids supplied to the first and second electrolysis sections, sulfuric acid was used. The electrolytic liquids both had a sulfuric acid concentration of 50 g/L (containing 0.5 wt % aluminum ion) and a temperature of 20°C. Subsequently, washing with water was carried out by means of a spray.

(k) Alkali metal silicate treatment

The aluminum support obtained by the anodizing treatment was immersed in a treatment vessel with a 1 wt % aqueous solution of No. 3 sodium silicate at a temperature of 30°C for 10 sec, thus carrying out an alkali metal silicate treatment (silicate treatment). Subsequently, washing with water was carried out by means of a spray using well water, thus preparing a support that had been subjected to a surface silicate hydrophilization treatment.

(Formation of intermediate layer)

The support used in Examples below was prepared by coating with the intermediate layer coating solution (1) above at a dry coat weight of 10 $mg/m^2$ and drying.

(Formation of photosensitive layer)

Photosensitive layer coating solution A was prepared as follows and applied onto the intermediate layer formed as above by means of a wire-wound bar. Drying was carried out using a hot air dryer at 125°C for 34 sec. The coverage after drying was 1.4 $g/m^2$.

(Photosensitive layer coating solution A)

| | |
|---|---|
| IR absorber (IR-1) | 0.038 parts by weight |
| Polymerization initiator A (S-1) | 0.061 parts by weight |
| Polymerization initiator B (I-1) | 0.094 parts by weight |
| Mercapto compound (E-1) | 0.015 parts by weight |
| Ethylenically unsaturated compound (M-1) | 0.425 parts by weight |
| (A-BPE-4, Shin-Nakamura Chemical Co., Ltd.) | |
| Binder polymer A (B-1) (weight-average molecular weight = 110,000) | 0.311 parts by weight |
| Binder polymer B (B-2) (weight-average molecular weight = 100,000) | 0.250 parts by weight |
| Binder polymer C (B-3) (weight-average molecular weight = 120,000) | 0.062 parts by weight |
| Additive (T-1) | 0.079 parts by weight |
| Polymerization inhibitor (Q-1) | 0.0012 parts by weight |
| Ethyl Violet (EV-1) | 0.021 parts by weight |
| Fluorine-based surfactant | 0.0081 parts by weight |
| (Megafac F-780-F, Dai-Nippon Ink & Chemicals, Inc., methyl isobutyl ketone (MIBK) 30 wt % solution) | |
| Methyl ethyl ketone | 5.886 parts by weight |
| Methanol | 2.733 parts by weight |
| 1-Methoxy-2-propanol | 5.886 parts by weight |

The structures of the IR absorber (IR-1), polymerization initiator A (S-1), polymerization initiator B (I-1), the mercapto compound (E-1), the polymerizable compound (M-1), binder polymer A (B-1), binder polymer B (B-2), binder polymer C (B-3), the additive (T-1), the polymerization inhibitor (Q-1), and Ethyl Violet (EV-1) used in photosensitive layer coating solution A are shown below.

(IR-1)

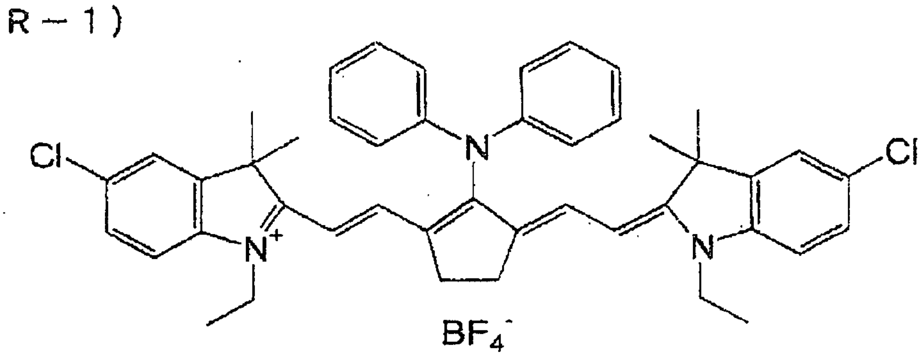

(S-1)

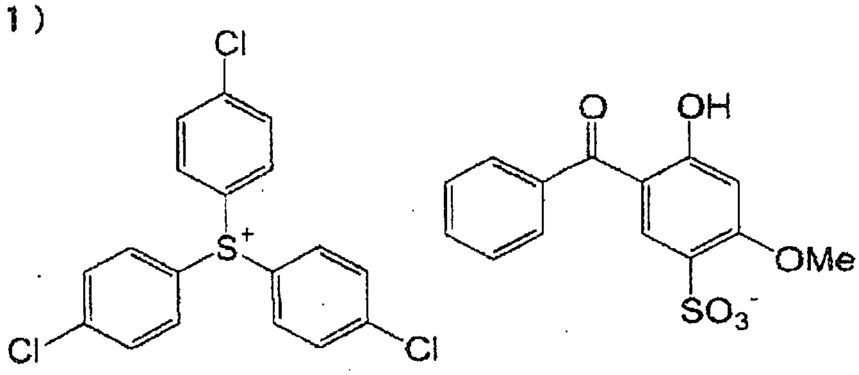

(I-1)

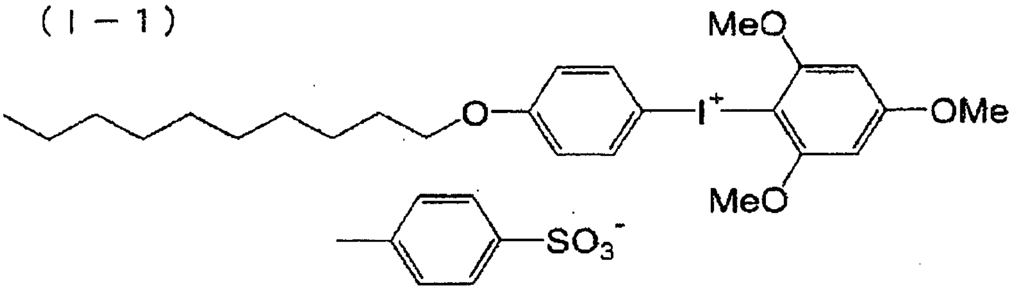

(E-1)

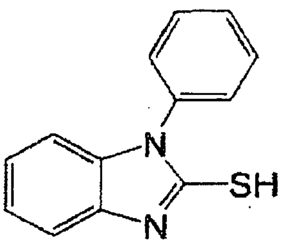

(M-1)

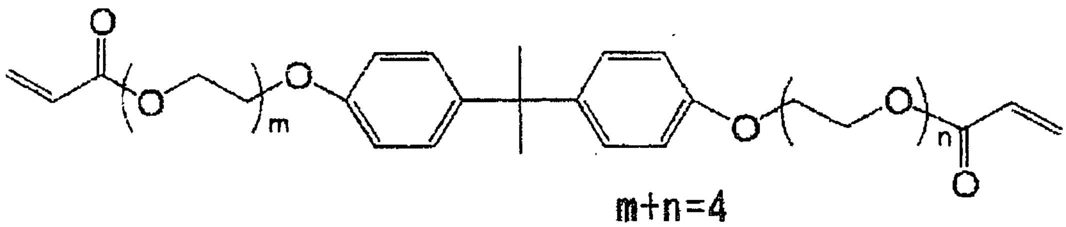

m+n=4

(B－1)

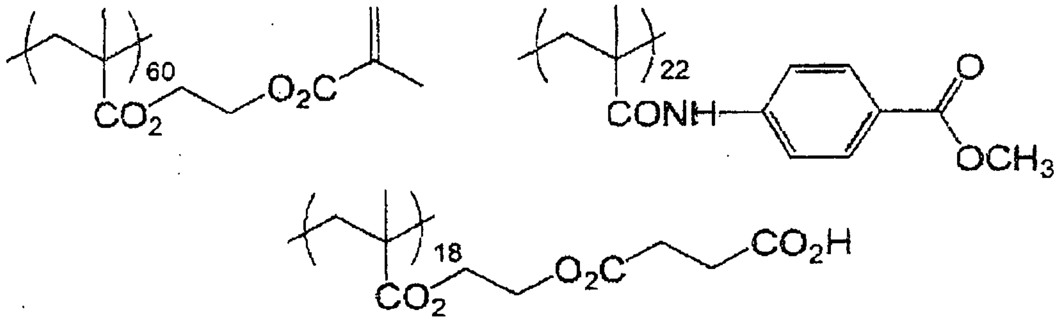

(B－2)

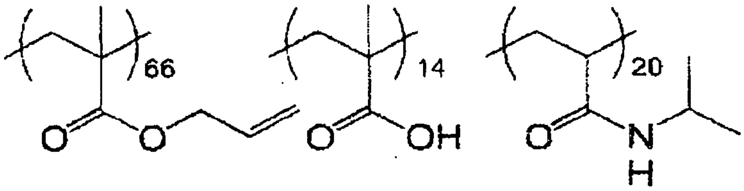

(B-3)

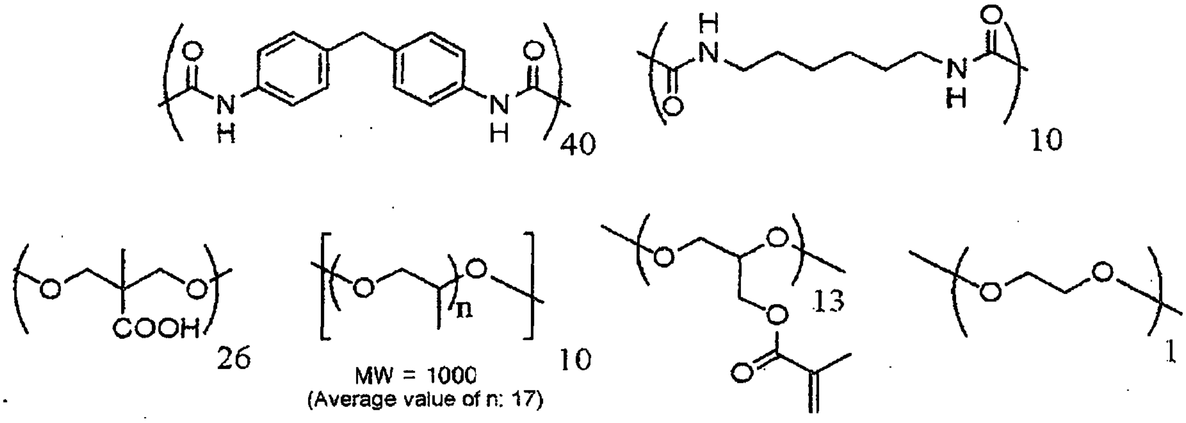

MW = 1000
(Average value of n: 17)

(T－1)

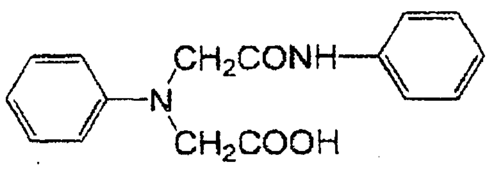

(Q－1)

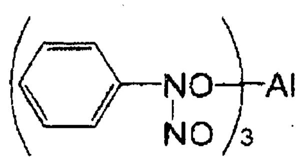

(EV-1)

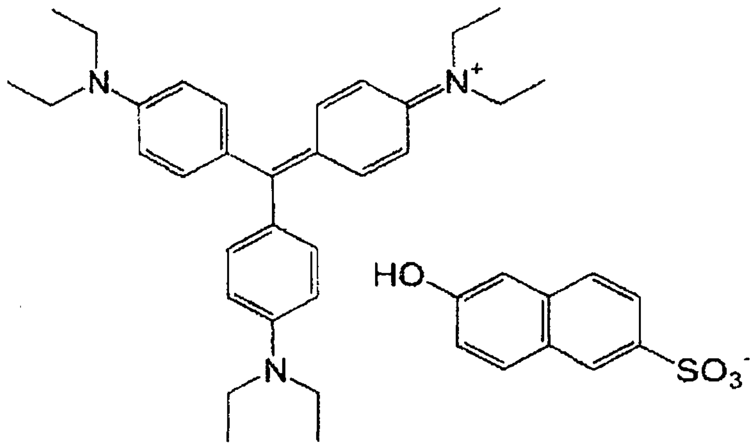

(Formation of lower protective layer)

The photosensitive layer thus formed was coated with a mixed aqueous solution (lower protective layer-forming coating solution) of synthetic mica (Somasif MEB-3L, 3.2% aqueous dispersion, Co-op Chemical Co., Ltd.), polyvinyl alcohol (Gohseran CKS-50, degree of saponification 99 mole %, degree of polymerization 300, sulfonic acid-modified polyvinyl alcohol, The Nippon Synthetic Chemical Industry Co., Ltd.), surfactant A (Emalex 710, Nihon-Emulsion Co., Ltd.), and surfactant B (Adeka Pluronic P-84: ADEKA Corp.) using a wire-wound bar, and dried at 125°C for 30 sec using a hot air dryer.

The synthetic mica (solids content)/polyvinyl alcohol/surfactant Alsurfactant B content ratio in this mixed aqueous solution (lower protective layer-forming coating solution) was 7.5/89/2/1.5 (wt %), and the amount coated (coverage after drying) was 0.5 g/$m^2$.

(Formation of upper protective layer)

A mixed aqueous solution (upper protective layer-forming coating solution) of organic filler (Art Pearl J-7P, Negami Chemical Industrial Co., Ltd.), synthetic mica (Somasif MEB-3L, 3.2% aqueous dispersion, Co-op Chemical Co., Ltd.), polyvinyl alcohol (L-3266: degree of saponification 87 mole %, degree of polymerization 300, sulfonic acid-modified polyvinyl alcohol, The Nippon Synthetic Chemical Industry Co., Ltd.), thickener (Cellogen FS-B, Dai-ichi Kogyo Seiyaku Co., Ltd.), and surfactant (Emalex 710, Nihon-Emulsion Co., Ltd.), was applied onto the lower protective layer using a wire-wound bar and dried at 125°C for 30 sec using a hot air dryer.

The organic filler/synthetic mica (solids content)/polyvinyl alcohol/thickener/surfactant content ratio in this mixed aqueous solution (upper protective layer-forming coating solution) was 3.2/2.0/80.5/11.5/2.8 (wt %), and the amount coated (coverage after drying) was 1.76 g/$m^2$.

<Preparation of lithographic printing plate precursor C>

The intermediate layer below was provided on support 1 as in lithographic printing plate precursor A.

(Formation of intermediate layer)

An aluminum plate subjected to the above-mentioned electric field surface roughening treatment was coated using a bar coater with the intermediate layer solution below and dried at 80°C for 20 sec. The dry coat weight of the intermediate layer was 25 mg/$m^2$.

(Intermediate layer coating solution)

| | |
|---|---|
| Sol liquid below | 100 parts by weight |

(continued)

| | |
|---|---|
| Methanol | 900 parts by weight |
| (Sol liquid) | |
| Phosmer PE (Uni-Chemical Co., Ltd.) | 5 parts by weight |
| Methanol | 45 parts by weight |
| Water | 10 parts by weight |
| 85 wt % phosphoric acid | 5 parts by weight |
| Tetraethoxysilane | 20 parts by weight |
| 3-Methacryloxypropyltrimethoxysilane | 15 parts by weight |

(Formation of image-forming layer)

The intermediate layer formed on the support was coated with Composition P-1 below at a dry coat weight of 1.4 g/m$^2$ and dried at 100°C for 1 min, thus forming an image-forming layer.

(Composition P-1)

| | |
|---|---|
| (C) Polymerizable compound having urethane bond and a plurality of ethylenically unsaturated bonds (AM-1) | 4.2 parts by weight |
| (D) Polyurethane binder (BT-1) (weight-average molecular weight: 120,000) | 3.6 parts by weight |
| (A) Infrared-absorbing agent (IR-1) | 0.31 parts by weight |
| (B) Onium salt (OS-12) | 1.2 parts by weight |
| ε-Phthalocyanine dispersion | 0.92 parts by weight |
| Fluorine-based nonionic surfactant Megafac F780 (Dainippon Ink and Chemicals, Incorporated) | 0.05 parts by weight |
| Methyl ethyl ketone | 62 parts by weight |
| Propylene glycol monomethyl ether acetate | 57 parts by weight |

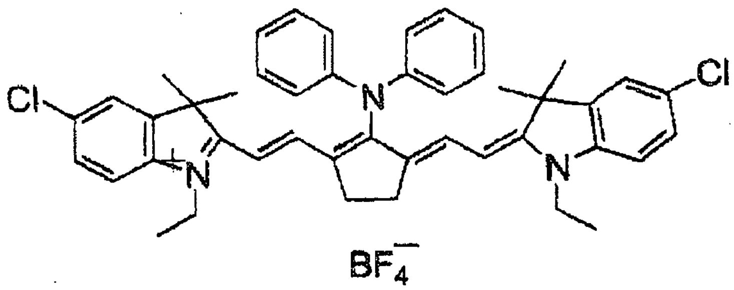

(IR-1)

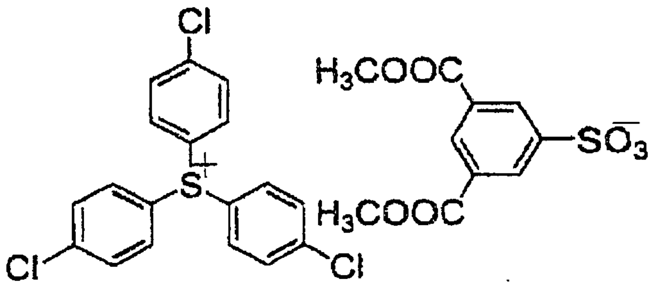

(OS-12)

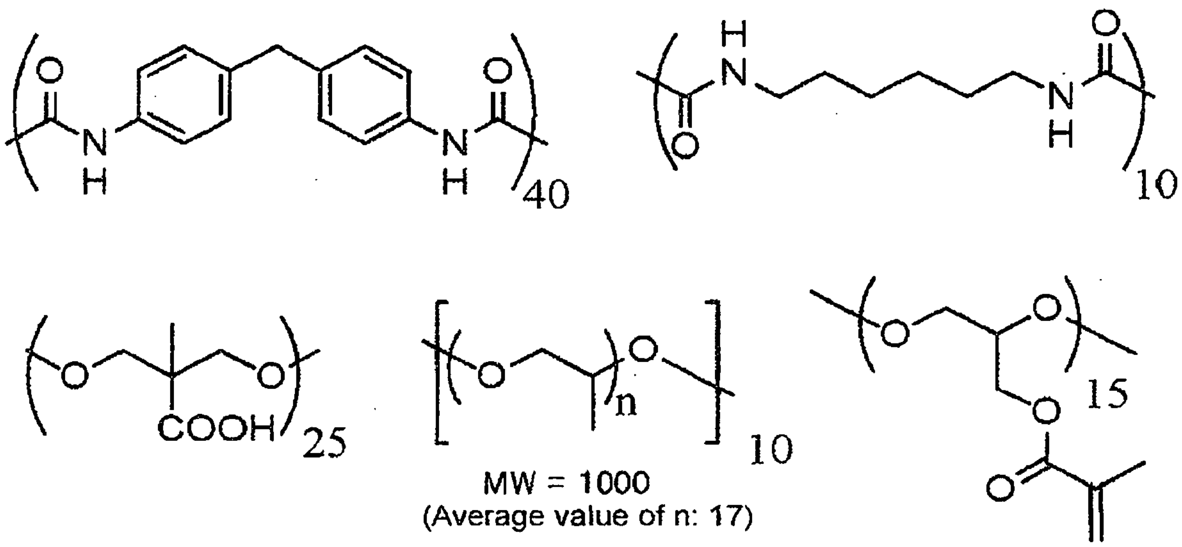

MW = 1000
(Average value of n: 17)

(BT-1)

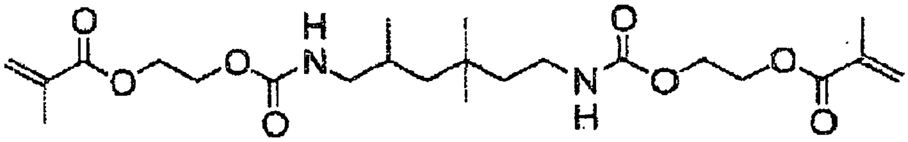

(AM-1)

(Formation of protective layer)

The image-forming layer surface was coated using a wire-wound bar with a mixed aqueous solution of polyvinyl alcohol (degree of saponification 98 mole %, degree of polymerization 500) and polyvinyl pyrrolidone (Luviskol K-30, BASF) and dried using a hot air dryer at 125°C for 75 sec to form a protective layer, thus preparing a lithographic printing plate precursor (negative-working lithographic printing plate precursor). The polyvinyl alcohol/polyvinyl pyrrolidone content ratio was 4/1 (ratio by weight), and the coat weight (coverage after drying) was 2.45 g/$m^2$.

(Formation of backcoat layer)

A backcoat layer was provided on the side of the lithographic printing plate precursor A or B opposite to the side provided with the photosensitive layer and protective layer in the same manner as in Example 1 of JP-A-6-35174.

(Evaluation methods)

(1) Plate making evaluation

<Plate making-1: lithographic printing plate precursor A, B >

The lithographic printing plate precursors A and B thus obtained were subjected to exposure, development processing, and drying steps in sequence.

Imagewise exposure was carried out using as an exposure light source (setter) an IR semiconductor laser (Creo Trendsetter 3244VX: equipped with a water-cooled 40 W IR semiconductor laser) under conditions of an output of 9 W, a drum outer face rotational speed of 210 rpm, and a resolution of 2,400 dpi.

After the exposure, and without carrying out a thermal treatment or a water washing treatment, development processing was carried out within 30 sec in an automatic processor having the structure shown in FIG. 2 using each of the developers having the compositions below. The automatic processor had two rotating brush rollers, the first brush roller was a brush roller having an outer diameter of 50 mm and having implanted therein fibers of polybutylene terephthalate (bristle diameter: 200 μm, bristle length: 17 mm), and the brush roller was rotated at 200 rpm in the same direction as the transport direction (peripheral speed at brush tip: 0.52 m/sec). The second brush roller was a brush roller having an outer diameter of 50 mm and having implanted therein fibers of polybutylene terephthalate (bristle diameter: 200 μm, bristle length: 17 mm), and the brush roller was rotated at 200 rpm in the opposite direction to the transport direction (peripheral speed at brush tip: 0.52 m/sec). Transport of the lithographic printing plate precursor was carried out at a transport speed of 100 cm/min.

The developer was supplied onto the plate surface by showering from a spray pipe using a circulation pump. The tank volume for the developer was 10 liters.

<Plate making-2: lithographic printing plate precursor C>

The lithographic printing plate precursor C obtained was subjected to exposure, preheating, processing, and drying in sequence. Exposure was carried out by the same method as in Plate making-1.

Subsequently, within 30 sec, pre-heating was carried out at 100°C for 30 sec, and processing was then carried out in an automatic processor having the structure shown in FIG. 2 using each of the developers having the compositions below. Following this, processing was carried out within 30 sec in an automatic processor using each of the developers having the compositions below. The automatic processor was used by the same method as in Plate making-1.

In Plate making-1 and -2, 'development processing' means combined processing which includes, in addition to development of an image-forming layer, carrying out each of removal of a protective layer and gumming. A water-washing step was not carried out either before or after processing.

The compositions of the processing solutions used are shown below. Processing solution No. 1 (pH 9.7)

| | |
|---|---|
| Water | 8329.8 parts by weight |
| Sodium carbonate | 130 parts by weight |
| Sodium bicarbonate | 70 parts by weight |
| Newcol B13 (Nippon Nyukazai Co., Ltd.) | 500 parts by weight |
| Gum Arabic (weight-average molecular weight 200,000) | 250 parts by weight |
| Hydroxyalkylated starch (Penon JE66, Nippon Starch Chemical Co.) | 700 parts by weight |
| Monoammonium phosphate | 20 parts by weight |
| 2-Bromo-2-nitropropane-1,3-diol | 0.1 parts by weight |
| 2-Methyl-4-isothiazolin-3-one | 0.1 parts by weight |
| Processing solution No. 2 (pH 9.7) | |
| Water | 8619.8 parts by weight |
| Sodium carbonate | 200 parts by weight |
| Sodium bicarbonate | 100 parts by weight |
| Newcol B4SN (Nippon Nyukazai Co., Ltd.) | 400 parts by weight |
| Gum Arabic (weight-average molecular weight 200,000) | 400 parts by weight |
| Phosphoric acid-modified starch (Petrocoat HN25, Nippon Starch Chemical Co.) | 200 parts by weight |
| Ethylenediaminetetraacetic acid tetrasodium salt | 80 parts by weight |
| 2-Bromo-2-nitropropane-1,3-diol | 0.1 parts by weight |
| 2-Methyl-4-isothiazolin-3-one | 0.1 parts by weight |

(continued)

| | |
|---|---|
| Processing solution No. 3 (pH 9.7) | |
| Water | 8260 parts by weight |
| Potassium carbonate | 150 parts by weight |
| Potassium bicarbonate | 80 parts by weight |
| Eleminol MON (100% conversion, Sanyo Chemical Industries, Ltd.) | 350 parts by weight |
| Yellow dextrin (Red Ball Dextrin 102, Nippon Starch Chemical Co.) | 800 parts by weight |
| Monoammonium phosphate | 180 parts by weight |
| Sodium hexametaphosphate | 180 parts by weight |
| Processing solution No. 4 (pH 9.5) | |
| Water | 8460 parts by weight |
| Sodium carbonate | 200 parts by weight |
| Sodium bicarbonate | 140 parts by weight |
| Pionin D310 (Takemoto Oil & Fat Co., Ltd.) | 450 parts by weight |
| Methylcellulose (Shin-Etsu Chemical Co., Ltd.) | 150 parts by weight |
| Enzyme-decomposed dextrin (Amycol, Nippon Starch Chemical Co.) | 600 parts by weight |
| Processing solution No. 5 (pH 9.8) | |
| Water | 8179.8 parts by weight |
| Sodium carbonate | 200 parts by weight |
| Sodium bicarbonate | 80 parts by weight |
| Pelex NBL (100% conversion, Kao Corporation) | 500 parts by weight |
| Octenylsuccinic acid-esterified starch (Natural Nisk, Nippon Starch Chemical Co.) | 900 parts by weight |
| Citric acid | 40 parts by weight |
| Monoammonium phosphate | 20 parts by weight |
| Propylene glycol | 80 parts by weight |
| 2-Bromo-2-nitropropane-1,3-diol | 0.1 parts by weight |
| 2-Methyl-4-isothiazolin-3-one | 0.1 parts by weight |
| Processing solution No. 6 (pH 9.5) | |
| Water | 8150 parts by weight |
| Sodium carbonate | 160 parts by weight |
| Sodium bicarbonate | 160 parts by weight |
| Pionin C157K (100% conversion, Takemoto Oil & Fat Co., Ltd.) | 500 parts by weight |
| Polyvinylpyrrolidone (Nippon Shokubai Co., Ltd.) | 850 parts by weight |
| Sodium hexametaphosphate | 180 parts by weight |
| Processing solution No. 7 (pH 9.4) | |
| Water | 8349.8 parts by weight |
| Sodium carbonate | 60 parts by weight |
| Sodium bicarbonate | 240 parts by weight |
| Pionin B111 (Takemoto Oil & Fat Co., Ltd.) | 400 parts by weight |
| Methylcellulose (Shin-Etsu Chemical Co., Ltd.) | 950 parts by weight |
| 2-Bromo-2-nitropropane-1,3-diol | 0.1 parts by weight |
| 2-Methyl-4-isothiazolin-3-one | 0.1 parts by weight |
| Processing solution No. 8 (pH 10.7) | |
| Water | 8359.8 parts by weight |
| Potassium carbonate | 150 parts by weight |
| Potassium bicarbonate | 20 parts by weight |
| Newcof B13 (Nippon Nyukazai Co., Ltd.) | 500 parts by weight |
| Gum Arabic (weight-average molecular weight 200,000) | 250 parts by weight |
| Hydroxyalkylated starch (Penon JE66, Nippon Starch Chemical Co.) | 700 parts by weight |
| Monoammonium phosphate | 20 parts by weight |
| 2-Bromo-2-nitropropane-1,3-diol | 0.1 parts by weight |
| 2-Methyl-4-isothiazolin-3-one | 0.1 parts by weight |

(continued)

| | |
|---|---|
| Processing solution No. 9 (pH 8.7) | |
| Water | 8350 parts by weight |
| Potassium carbonate | 10 parts by weight |
| Potassium bicarbonate | 130 parts by weight |
| Eleminol MON (100% conversion, Sanyo Chemical Industries, Ltd.) | 350 parts by weight |
| Yellow dextrin (Red Ball Dextrin 102, Nippon Starch Chemical Co.) | 800 parts by weight |
| Monoammonium phosphate | 180 parts by weight |
| Sodium hexametaphosphate | 180 parts by weight |
| Processing solution No. 1 (pH 9.9) for Comparative Example | |
| Water | 9279.8 parts by weight |
| Sodium carbonate | 130 parts by weight |
| Sodium bicarbonate | 70 parts by weight |
| Newcol B13 (Nippon Nyukazai Co., Ltd.) | 500 parts by weight |
| Monoammonium phosphate | 20 parts by weight |
| 2-Bromo-2-nitropropane-1,3-diol | 0.1 parts by weight |
| 2-Methyl-4-isothiazolin-3-one | 0.1 parts by weight |
| Processing solution No. 2 (pH 11.9) for Comparative Example | |
| Water | 8519 parts by weight |
| Potassium carbonate | 17 parts by weight |
| Potassium hydroxide (48%) | 14 parts by weight |
| Newcol B13 (Nippon Nyukazai Co., Ltd.) | 500 parts by weight |
| Gum Arabic (weight-average molecular weight 200,000) | 250 parts by weight |
| Hydroxyalkylated starch (Penon JE66, Nippon Starch Chemical Co.) | 700 parts by weight |
| Monoammonium phosphate | 20 parts by weight |
| 2-Bromo-2-nitropropane-1,3-diol | 0.1 parts by weight |
| 2-Methyl-4-isoth iazolin-3-one | 0.1 parts by weight |

The lithographic printing plates thus obtained were mounted on a SOR-M printing machine (Heidelberg), and printing was carried out at a printing speed of 6,000 sheets per hour using dampening water (EU-3 (etching liquid, Fuji Photo Film Co., Ltd.))/water/isopropyl alcohol = 1/89/10 (ratio by volume)) and TRANS-G(N) black ink (Dai-Nippon Ink & Chemicals, Inc.).

Evaluation

Developability, processability, and plate life were evaluated as follows using the lithographic printing plate precursors so obtained.

<Developability>

Printing was carried out as described above using each lithographic printing plate, and unevenness of a screen tint image (unevenness of ink density) due to staining in a non-image area of the 1,000$^{th}$ printed material was evaluated. When there was ink density unevenness in a screen tint image: Poor, when there was slight ink density unevenness in a screen tint image but at an allowable level: Fair, and when there was no ink density unevenness in a screen tint image and a good image was obtained: Good.

<Processability>

When 500 $m^2$ was processed as described above over 1 week using each lithographic printing plate precursor, the incidence of residue attached to a vessel wall of an automatic processor was visually examined. The residue thus generated was mainly due to the binder of the protective layer. Where there was no residue: Good, when there was residue but at an allowable level: Fair, and when the occurrence of residue was marked: Poor.

<Stain prevention properties>

Printing was carried out as described above using each lithographic printing plate, and non-image area blanket staining after 10,000 sheets were printed was visually evaluated. The stain prevention properties were evaluated using three criteria of Good, Fair, and Poor in order from those with little blanket staining. When there was no staining: Good, when there was hardly any staining: Fair, and when there was staining: Poor.

<Plate life>

Since as the number of prints increases the photosensitive layer image formed on the lithographic printing plate is gradually abraded and the ink receiving properties are degraded, the ink density of the image on the printed paper decreases. The plate life was evaluated using the number of sheets printed before the ink density (reflection density) decreased by 0.1 from that when printing started.

Evaluation of the plate life was carried out after exposure and development. Furthermore, after a lithographic printing plate was made, it was allowed to stand at room temperature for 1 week, printing was carried out under the above-mentioned conditions, and the plate life (after 1 week) was evaluated in the same manner.

The results are summarized in Table 1.

(Table 1)

| Experiment No. | Lithographic printing plate precursor | Processing solution | Develop ability | Process ability | Stain prevention properties | Plate life (x1000) | |
|---|---|---|---|---|---|---|---|
| | | | | | | Immed. after plate made | After 1 week |
| Example 1 | A | 1 | Good | Good | Good | 50 | 50 |
| Example 2 | A | 2 | Good | Good | Good | 50 | 45 |
| Example 3 | A | 3 | Good | Good | Good | 50 | 50 |
| Example 4 | A | 4 | Good | Good | Good | 50 | 45 |
| Example 5 | A | 5 | Good | Good | Good | 50 | 50 |
| Example 6 | A | 6 | Good | Good | Good | 50 | 50 |
| Example 7 | A | 7 | Good | Good | Good | 50 | 50 |
| Example 8 | B | 1 | Good | Good | Good | 70 | 60 |
| Example 9 | B | 2 | Good | Good | Good | 80 | 70 |
| Example 10 | B | 3 | Good | Good | Good | 65 | 60 |
| Example 11 | B | 4 | Good | Good | Good | 60 | 55 |
| Example 12 | B | 5 | Good | Good | Good | 70 | 60 |
| Example 13 | B | 6 | Good | Good | Good | 65 | 65 |
| Example 14 | B | 7 | Good | Good | Good | 60 | 60 |
| Example 15 | C | 1 | Fair | Good | Good | 60 | 80 |
| Example 16 | C | 2 | Fair | Good | Good | 80 | 80 |
| Example 17 | C | 3 | Fair | Good | Good | 55 | 90 |
| Example 18 | C | 4 | Fair | Good | Good | 50 | 80 |
| Example 19 | C | 5 | Fair | Good | Good | 50 | 70 |
| Example 20 | C | 6 | Fair | Good | Good | 55 | 75 |
| Example 21 | c | 7 | .Fair | Good | Good | 50 | 70 |
| Example 22 | A | 8 | Good | Good | Good | 50 | 45 |
| Example 23 | A | 9 | Good | Good | Good | 60 | 60 |

(continued)

| Experiment No. | Lithographic printing plate precursor | Processing solution | Develop ability | Process ability | Stain prevention properties | Plate life (x1000) | |
|---|---|---|---|---|---|---|---|
| | | | | | | Immed. after plate made | After 1 week |
| Comp. Ex. 1 | A | Comp. Ex. 1 | Fair | Good | Poor | 50 | 50 |
| Comp. Ex. 2 | A | Comp. | Fair | Poor | Fair | 60 | 15 |
| Comp. Ex. 3 | B | Comp. Ex. 1 | Fair | Good | Poor | 70 | 60 |
| Comp. Ex. 4 | B | Comp. Ex. 2 | Poor | Poor | Fair | 80 | 20 |
| Comp. Ex. 5 | C | Comp. Ex. 1 | Fair | Good | Poor | 60 | 70 |
| Comp. Ex. 6 | C | Comp. Ex. 2 | Poor | Poor | Fair | 80 | 40 |

**Claims**

**1.** A process for making a lithographic printing plate, comprising the steps of

(1) preparing a lithographic printing plate precursor having above a hydrophilic support an image-forming layer comprising

(i) an infrared-absorbing agent,
(ii) a polymerization initiator,
(iii) an ethylenically unsaturated compound, and
(iv) a carboxylic acid-containing aqueous alkalisoluble or -swelling organic polymer as a binder polymer;

(2) image-wise exposing the lithographic printing plate precursor; and
(3) processing the image-wise exposed lithographic printing plate precursor using a processing solution which has a pH in the range of 8.5-10.8 and comprises
an alkali metal carbonate salt and an alkali metal bicarbonate salt; and

- a water-soluble polymer compound wherein the total amount of the carbonate and bicarbonate salts is 1-20 wt.-% based on the weight of the processing solution.

**2.** The process of claim 1, wherein step (2) is carried out by means of a near-infrared or infrared laser emitting light at 760-1,200 nm.

**3.** The process of claim 1 or 2, wherein the water-soluble polymer compound is selected from soybean polysaccharide, modified starch, gum Arabic, dextrin, a cellulose derivative or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer.

**4.** The process of any of claims 1-3, wherein the binder polymer (iv) has an acid group in a side chain.

**5.** The process of claim 4, wherein the acid group is a carboxylic acid group.

**6.** The process of any of claims 1-5, wherein the lithographic printing plate precursor has a protective layer above the image-forming layer.

**7.** The process of claim 6, wherein the protective layer comprises an acid-modified polyvinyl alcohol.

**8.** The process of any of claims 1-7, wherein step (3) is a step of carrying out development processing and gumming processing at the same time using a single solution.

**9.** The process of claim 6 or 7, wherein step (3) is a step of carrying out removal of the protective layer, development

processing, and gumming processing at the same time using a single solution.

**10.** The process of any of claims 1-9, wherein a water-washing step is not carried out either before or after step (3).

**11.** The process of any of claims 1-10, wherein the water-soluble polymer compound is selected from soybean polysaccharide, modified starch, gum Arabic, dextrin, carboxymethyl cellulose, and polyvinyl alcohol.

**12.** The process of any of claims 1-11, wherein the binder polymer (iv) is a polyurethane polymer having a carboxylic acid group and an ethylenically unsaturated group in a side chain.

**Patentansprüche**

**1.** Verfahren zur Herstellung einer lithografischen Druckplatte, umfassend die folgenden Schritte:

(1) Herstellung eines lithografischen Druckplattenvorläufers, der über einem hydrophilen Träger eine Bilderzeugungsschicht aufweist, umfassend

(i) einen Infrarotabsorber,
(ii) einen Polymerisationsinitiator,
(iii) eine ethylenisch ungesättigte Verbindung, und
(iv) ein im wässrigen alkalischen Milieu lösliches oder quellendes organisches Polymer, das eine Carbonsäure umfasst, als ein Bindemittelpolymer;

(2) bildweise Belichtung des lithografischen Druckplattenvorläufers; und
(3) Behandlung des bildweise belichteten lithographischen Druckplattenvorläufers unter Verwendung einer Behandlungslösung, die einen pH Wert im Bereich von 8,5 bis 10,8 hat, und ein Alkalimetallcarbonat-Salz und ein Alkalimetallbicarbonat-Salz; und eine wasserlösliche Polymerverbindung umfasst, wobei die Gesamtmenge der Carbonat- und Bicarbonat-Salze 1-20 Gew.-% ist, bezogen auf das Gewicht der Behandlungslösung.

**2.** Verfahren nach Anspruch 1, bei dem der Schritt (2) mittels eines Nahinfrarot- oder Infrarotlasers durchgeführt wird, der Licht mit 760-1,200 nm emittiert.

**3.** Verfahren nach Anspruch 1 oder 2, bei dem die wasserlösliche Polymerverbindung ausgewählt ist aus Sojabohnen-Polysaccharid, modifizierter Stärke, Gummiarabikum, Dextrin, einem Cellulosederivat oder einem modifizierten Produkt davon, Pullulan, Polyvinylalkohol oder einem Derivat davon, Polyvinylpyrrolidon, Polyacrylamid, einem Acrylamid-Copolymer, einem Vinylmethylether/Maleinsäureanhydrid-Copolymer, einem Vinylacetat/Maleinsäureanhydrid-Copolymer und einem Styrol/Maleinsäureanhydrid-Copolymer.

**4.** Verfahren nach mindestens einem der Ansprüche 1 bis 3, bei dem das Bindemittelpolymer (iv) eine Säuregruppe in einer Seitenkette hat.

**5.** Verfahren nach Anspruch 4, bei dem die Säuregruppe eine Carbonsäuregruppe ist.

**6.** Verfahren nach mindestens einem der Ansprüche 1 bis 5, bei dem der lithographische Druckplattenvorläufer eine Schutzschicht über der Bilderzeugungsschicht hat.

**7.** Verfahren nach Anspruch 6, bei dem die Schutzschicht einen Säure-modifizierten Polyvinylalkohol umfasst.

**8.** Verfahren nach mindestens einem der Ansprüche 1 bis 7, bei dem der Schritt (3) ein Schritt ist, in dem Entwicklungsbehandlung und Gummierungsbehandlung gleichzeitig unter Verwendung einer einzigen Lösung durchgeführt werden.

**9.** Verfahren nach Anspruch 6 oder 7, bei dem der Schritt (3) ein Schritt ist, in dem Entfernung der Schutzschicht, Entwicklungsbehandlung und Gummierungsbehandlung gleichzeitig unter Verwendung einer einzigen Lösung durchgeführt werden.

**10.** Verfahren nach mindestens einem der Ansprüche 1 bis 9, bei dem ein Waschschritt mit Wasser entweder vor oder

nach dem Schritt (3) nicht durchgeführt wird.

**11.** Verfahren nach mindestens einem der Ansprüche 1 bis 10, bei dem die wasserlösliche Polymerverbindung aus Sojabohnen-Polysaccharid, modifizierter Stärke, Gummiarabikum, Dextrin, Carboxymethylcellulose und Polyvinylalkohol ausgewählt ist.

**12.** Verfahren nach mindestens einem der Ansprüche 1 bis 11, bei dem das Bindemittelpolymer (iv) ein Polyurethanpolymer mit einer Carbonsäuregruppe und einer ethylenisch ungesättigten Gruppe in einer Seitenkette ist.

**Revendications**

**1.** Processus de fabrication d'une plaque d'impression lithographique, comprenant les étapes qui consistent

(1) à préparer un précurseur de plaque d'impression lithographique ayant au-dessus d'un support hydrophile une couche de formation d'image comprenant

(i) un agent absorbant l'infrarouge,
(ii) un initiateur de polymérisation,
(iii) un composé éthyléniquement insaturé, et
(iv) un polymère organique gonflant ou soluble dans les alcalis aqueux contenant un acide carboxylique en tant que polymère liant ;

(2) à exposer sous forme d'image le précurseur de plaque d'impression lithographique ; et
(3) à traiter le précurseur de plaque d'impression lithographique exposé sous forme d'image en utilisant une solution de traitement qui présente un pH dans la plage allant de 8,5 à 10,8 et comprend :

- un sel de carbonate de métal alcalin et un sel de bicarbonate de métal alcalin ; et
- un composé polymère hydrosoluble où la quantité totale des sels de carbonate et de bicarbonate est de 1 à 20% en poids sur la base du poids de la solution de traitement.

**2.** Processus de la revendication 1, dans lequel l'étape (2) est effectuée au moyen d'un laser infrarouge ou en proche infrarouge émettant de la lumière à 760-1200 nm.

**3.** Processus de la revendication 1 ou 2, dans lequel le composé polymère hydrosoluble est choisi parmi le polysaccharide de soja, un amidon modifié, la gomme Arabique, la dextrine, un dérivé de cellulose ou un produit modifié de celui-ci, le pullulane, un alcool polyvinylique ou un dérivé de celui-ci, la polyvinylpyrrolidone, le polyacrylamide, un copolymère d'acrylamide, un copolymère d'éther méthylvinylique/anhydride maléique, un copolymère d'acétate vinylique/anhydride maléique et un copolymère de styrène/anhydride maléique.

**4.** Processus de l'une des revendications 1 à 3, dans lequel le polymère liant (iv) a un groupe acide dans une chaîne latérale.

**5.** Processus de la revendication 4, dans lequel le groupe acide est un groupe acide carboxylique.

**6.** Processus de l'une des revendications 1 à 5, dans lequel le précurseur de plaque d'impression lithographique a une couche protectrice au-dessus de la couche de formation d'image.

**7.** Processus de la revendication 6, dans lequel la couche protectrice comprend un alcool polyvinylique modifié par un acide.

**8.** Processus de l'une des revendications 1 à 7, dans lequel l'étape (3) est une étape qui consiste à effectuer un traitement de développement et un traitement de gommage en même temps en utilisant une seule solution.

**9.** Processus de la revendication 6 ou 7, dans lequel l'étape (3) est une étape qui consiste à effectuer le retrait de la couche protectrice, un traitement de développement et un traitement de gommage en même temps en utilisant une seule solution.

**10.** Processus de l’une des revendications 1 à 9, dans lequel une étape de lavage à l’eau n’est pas effectuée avant ou après l’étape(3).

**11.** Processus de l’une des revendications 1 à 10, dans lequel le composé polymère hydrosoluble est choisi parmi le polysaccharide de soja, un amidon modifié, la gomme Arabique, la dextrine, la carboxyméthylcellulose et un alcool polyvinylique.

**12.** Processus de l’une des revendications 1 à 11, dans lequel le polymère liant (iv) est un polymère de polyuréthanne ayant un groupe acide carboxylique et un groupe éthyléniquement insaturé dans une chaîne latérale.

FIG.1

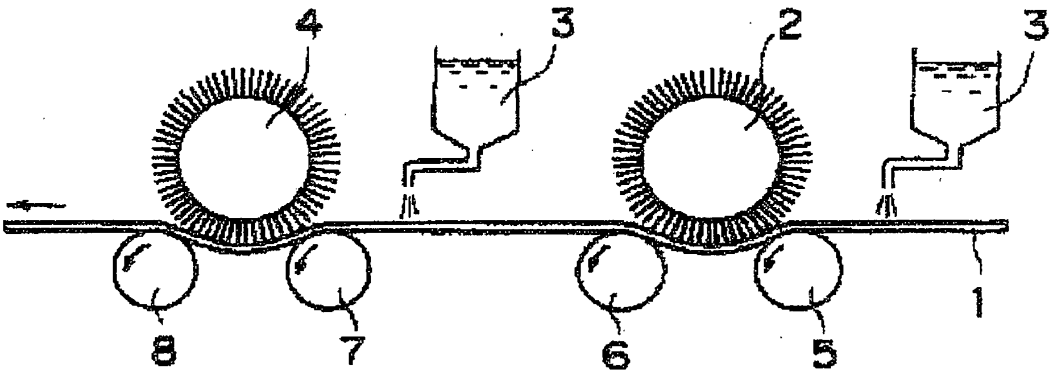

*FIG.2*

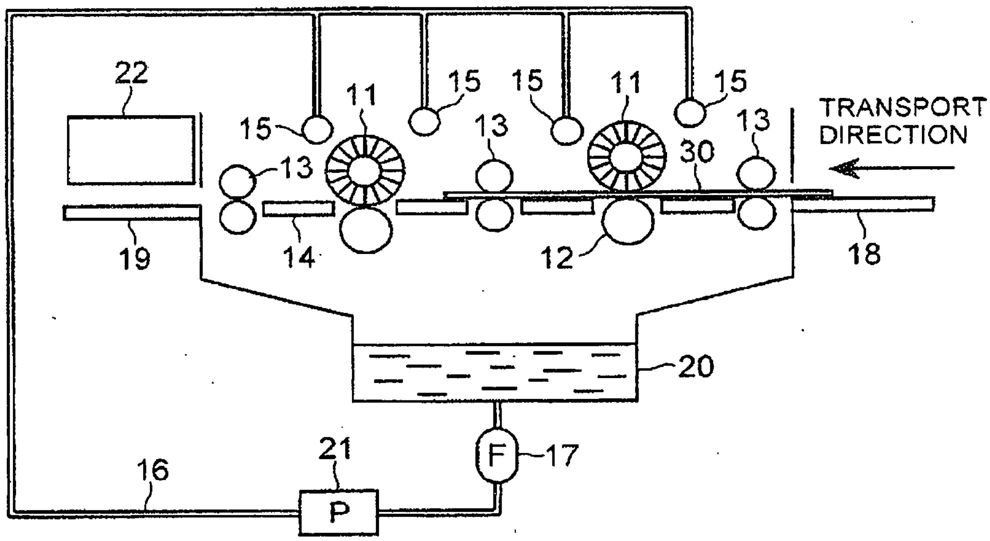
22
15
11
15
15
11
15
TRANSPORT
DIRECTION
13
13
30
13
19
14
12
18
20
21
16
P
F
17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11065126 A
- EP 1868036 A
- EP 1334823 A
- JP 2007047742 A
- JP 2002079772 A
- JP 10282679 A
- JP 2304441 A
- JP 2005125749 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2002278057 A
- JP 2001133969 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 449047 B
- JP 4431837 B
- JP 459613 B
- JP 4524915 B
- JP 4525713 B
- JP 50005102 A
- JP 50084302 A
- JP 50084303 A
- JP 53012984 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2003328465 A
- JP 2000066385 A
- JP 2000080068 A
- US 4069055 A

- JP 4365049 A
- US 4069056 A
- EP 104143 A
- US 339049 A
- US 410201580 B
- US 3604581 A
- JP 2001343742 A
- JP 2002148790 A
- JP 51037193 A
- JP 48064183 A
- JP 49043191 B
- JP 52030490 B
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 11352691 A
- JP 2007272134 A
- JP 2007017948 A
- JP 2003270775 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 2004307837 A
- JP 2002327036 A
- JP 2002173410 A
- JP 2004 A
- JP 307837 A
- JP 5045885 A
- JP 6035174 A
- JP 2008201038 A

**Non-patent literature cited in the description**


- Senryo Binran. 1970
- Saishin Ganryo Binran. Karaa Indekkusu. 1977
- Saishin Ganryo Ouyo Gijutsu. CMC Publishing, 1986
- Insatsu Inki Gijutsu. CMC Publishing, 1984
- Insatsu Inki Gijutsu. Kinzoku Sekken no Seishitsu to Ouyo. CMC Publishing, 1984
- **WAKABAYASHI et al.** *Bull. Chem. Soc. Japan,* 1969, vol. 42, 2924
- **M. P. HUTT.** *Journal of Heterocyclic Chemistry,* 1970, vol. 1 (3
- *J. C. S. Perkin II.,* 1979, 1653-1660
- *J. C. S. Perkin II,* 1979, 156-162
- *Journal of Photopolymer Science and Technology,* 1995, 202-232
- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *The Proc. Conf. Rad. Curing ASIA,* October 1988, 478
- *Nippon Secchaku Kyokaishi,* 1984, vol. 20 (7), 300-308
- Ultrafine Particles and Materials. Shokabo Publishing Co., Ltd, 1993
- Manufacturing & Application of Microspheres & Powders. CMC Publishing Co., Ltd, 2005